# EUROPEAN PATENT APPLICATION

(11) **EP 4 276 534 A1**
(43) Date of publication of application: **15.11.2023**
(21) Application number: 23172015.2
(22) Date of filing: 08.05.2023
(51) Int. Cl.: G03F 7/039, G03F 7/20

(54) **MASK BLANK, RESIST PATTERN FORMING PROCESS AND CHEMICALLY AMPLIFIED POSITIVE RESIST COMPOSITION**

(30) Priority: 10.05.2022 JP 2022077283
(71) Applicant: Shin-Etsu Chemical Co., Ltd., Tokyo (JP)
(72) Inventor: MASUNAGA, Keiichi, Joetsu-shi (JP); HATAKEYAMA, Jun, Joetsu-shi (JP); WATANABE, Satoshi, Joetsu-shi (JP); FUNATSU, Kenji, Joetsu-shi (JP); FUKUSHIMA, Masahiro, Joetsu-shi (JP); KOTAKE, Masaaki, Joetsu-shi (JP)
(74) Representative: Ter Meer Steinmeister & Partner

(57) **Abstract**

A photomask blank has a resist film which is obtained by coating a chemically amplified positive resist composition comprising a polymer comprising phenolic hydroxy-containing repeat units and repeat units having a carboxy group which is protected with an acid labile group in the form of a tertiary hydrocarbyl group having an electron attractive moiety and/or hydroxy-substituted phenyl moiety bonded to the tertiary carbon, and an organic solvent. The resist film is processed to form a pattern with a high resolution, reduced LER, improved rectangularity, and pattern fidelity.

## Description

### TECHNICAL FIELD

This invention relates to a mask blank, a resist pattern forming process, and a chemically amplified positive resist composition.

### BACKGROUND ART

To meet the recent demand for higher integration in integrated circuits, pattern formation to a smaller feature size is required. Acid-catalyzed chemically amplified resist compositions are most often used in forming resist patterns with a feature size of 0.2 µm or less. High-energy radiation such as UV, deep-UV, EUV or EB is used as the energy source for exposure of these resist compositions. In particular, the EB lithography is utilized as the ultra-fine microfabrication technique, and is also indispensable in processing a photomask blank into a transfer mask (photomask) for use in the fabrication of semiconductor devices.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB having a minute area. The operation of successively scanning all finely divided regions on the work surface takes a long time as compared with one-shot exposure through a photomask. To avoid any throughput decline, a resist film having a high sensitivity is required. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. A small line edge roughness (LER) is another important performance factor. In recent years, the multibeam mask writing (MBMW) process is used in the processing of mask blanks to achieve further miniaturization. The resist used in the MBMW process is a low-sensitivity resist (or high-dose region) which is advantageous in roughness while a spotlight is brought to the optimization of the resist composition in the high-dose region

The control of resist sensitivity and pattern profile has been improved by a proper selection and combination of resist material components and processing conditions. One improvement pertains to the diffusion of acid that largely affects the resolution of a resist film. In the processing of photomasks, it is required that the profile of a resist pattern formed do not change with a lapse of time from the end of exposure to PEB. The major cause of such a profile change with time is diffusion of an acid generated upon exposure. The problem of acid diffusion has been widely studied not only in terms of photomask processing, but also in terms of general resist compositions because the acid diffusion has a significant impact on sensitivity and resolution.

Patent Documents 1 and 2 describe acid generators capable of generating bulky acids for controlling acid diffusion and reducing LER. Since these acid generators are still insufficient to control acid diffusion, it is desired to have an acid generator with more controlled acid diffusion.

Patent Document 3 discloses a resist composition comprising a base polymer having introduced therein repeat units having a sulfonium structure capable of generating a sulfonic acid upon light exposure. This approach of controlling acid diffusion by introducing repeat units capable of generating acid upon exposure into a base polymer is effective in forming a pattern with reduced LER. However, the base polymer having introduced therein repeat units capable of generating acid upon exposure encounters a problem with respect to its solubility in organic solvent, depending on the structure and proportion of the repeat units.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography since they exhibit strong absorption to radiation of wavelength around 200 nm. These polymers, however, are expected to form useful resist materials for the EB and EUV lithography of forming patterns with smaller size than the processing limit of ArF excimer laser because they offer high etching resistance.

Often used as the base polymer in positive resist compositions for EB and EUV lithography is a polymer having an acidic functional group on phenol side chain masked with an acid labile group. Upon exposure to high-energy radiation, a photoacid generator generates an acid and the acid labile group is deprotected by the catalysis of the generated acid, whereby the polymer turns soluble in alkaline developer. Typical of the acid labile group are tertiary alkyl, tert-butoxycarbonyl, and acetal groups. The use of acid labile groups (e.g., acetal groups) requiring a relatively low level of activation energy for deprotection offers the advantage that a resist film having a high sensitivity is obtainable. However, if the diffusion of generated acid is not fully controlled, deprotection reaction can occur even in the unexposed region of the resist film, giving rise to the problems of degraded resolution and LER.

Patent Documents 4 and 5 describe chemically amplified positive resist compositions comprising a base polymer containing a tertiary ester group having a fluorinated aromatic ring structure as the acid labile group. These resist compositions aim to acquire transmission to exposure light of wavelength below 300 nm, especially F₂ (157 nm), Kr₂ (146 nm), KrAr (134 nm) or Ar₂ (121 nm) excimer laser or to achieve an effect of enhancing the sensitivity in the EUV exposure process. No precise studies have been made on the mask fabrication process by EB writing which needs neither transmission nor sensitization.

The transfer mask is used in the photolithography of forming small-size patterns for the fabrication of semiconductor devices. The mask generally consists of a glass substrate and a metal thin film thereon which is provided with a small-size pattern. Not only binary masks consisting of a light-transmissive substrate and a patterned light-shielding film of chromium-based material, but also halftone phase shift masks are known in the art. In the recent trend toward higher integration of semiconductor devices, it is required to form patterns of smaller size than the transfer limit of the photolithography technology. To meet the demand, the EUV lithography which is an exposure technology using EUV radiation of shorter wavelength is now used. The EUV radiation is light of wavelength about 0.2 nm to about 100 nm, specifically light near 13.5 nm. Since the EUV radiation has a very low transmittance relative to materials, conventional projection optical systems or masks of transmission type cannot be used, and instead, optical parts of reflection type are used. Accordingly, masks of reflection type are proposed as the pattern transfer mask.

The mask of reflection type includes a substrate, a multilayer reflective film thereon for reflecting EUV radiation, and a patterned absorber film thereon for absorbing EUV radiation. Such a structure prior to patterning of the absorber film (including the structure having a resist film formed thereon) is referred to as a mask blank of reflection type. The blank is used as a start material toward the mask of reflection type. The mask blank for reflecting EUV radiation is referred to as EUV mask blank, hereinafter. The EUV mask blank has a basic structure which includes a glass substrate, a multilayer reflective film formed thereon for reflecting EUV radiation, and an absorber film formed thereon for absorbing EUV radiation. The multilayer reflective film is typically a Mo/Si multilayer reflective film consisting of alternately deposited molybdenum (Mo) layers and silicon (Si) layers until a reflectivity to EUV radiation is acquired. For the absorber film, a material based on tantalum (Ta) having a relatively high extinction coefficient relative to EUV radiation is often used. See Patent Document 6.

In general, the transfer mask is manufactured using an EB writer system. In the process, some of EB entering the resist film are scattered forward as a result of impingement with atoms of which the resist film is composed, whereas some of EB transmitted by the resist film are scattered backward as a result of impingement with atoms of which the substrate is composed and enter the resist film again. The backward scattered electrons shoot up through the resist film, are reflected within the system, and enter the resist film again. Under the influences of forward and backward scattering or the like, a line width variation due to the percent opening of the pattern occurs. In particular, the influence of backward scattering is significant because tantalum (Ta) having a high atomic weight is used to form the absorber film in the mask of reflection type. To solve the problem, a method of performing proximity effect correction (PEC) in accordance with the pattern layout (density and arrangement of exposure pattern) and a method of improving the dose margin of resist have been developed. In the microfabrication technology of the advanced generation wherein the resist sensitivity falls in the low-sensitivity region (high-dose region) and the influence of backward scattering becomes further stronger, the above methods are still insufficient to form small-size patterns. As described in Patent Documents 7 and 8, it is desired to improve the resist composition used in the processing of mask blanks by EB writing.

### Citation List

Patent Document 1: JP-A 2009-053518
Patent Document 2: JP-A 2010-100604
Patent Document 3: JP-A 2011-022564
Patent Document 4: JP-A 2002-249520
Patent Document 5: JP-A 2013-080031
Patent Document 6: JP-A 2002-122981
Patent Document 7: JP-A 2012-033715
Patent Document 8: JP-A 2013-084883

### SUMMARY OF INVENTION

An object of the invention is to provide a mask blank comprising a resist film capable of forming a pattern having a very high resolution, reduced LER, improved rectangularity, and pattern fidelity, a pattern forming process, and a chemically amplified positive resist composition.

The inventors have found that when a resist film is formed on a mask blank from a chemically amplified positive resist composition comprising a base polymer containing a polymer comprising phenolic hydroxy group-containing repeat units and repeat units having a carboxy group which is protected with an acid labile group in the form of a tertiary hydrocarbyl group having an electron attractive moiety and/or hydroxy moiety-substituted phenyl group bonded to the tertiary carbon, and an organic solvent, the resist film is capable of forming a pattern with a very high resolution, reduced LER, improved profile, and fidelity. Due to the minimized influence of backward scattering, the pattern is useful in the processing of mask blanks.

Accordingly, the invention provides a mask blank, resist pattern forming process and chemically amplified positive resist composition, as defined below.
1. A mask blank comprising a resist film which is obtained by coating a chemically amplified positive resist composition, the resist composition comprising a base polymer containing a polymer comprising phenolic hydroxy group-containing repeat units having the formula (A1) and repeat units containing a carboxy group protected with an acid labile group, having the formula (A2), and an organic solvent, 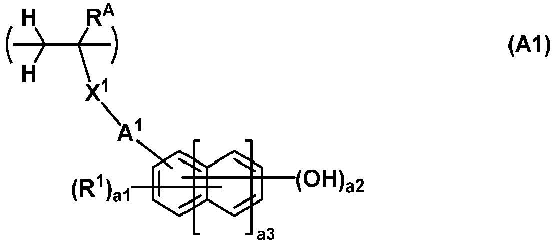 wherein R^{A} is hydrogen, fluorine, methyl or trifluoromethyl,
   X¹ is a single bond, *-C(=O)-O- or *-C(=O)-NH-, * designates a point of attachment to the carbon atom in the backbone,
   A¹ is a single bond or a C₁-C₁₀ saturated hydrocarbylene group in which some constituent -CH₂- may be replaced by -O-,
   R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
   a1 is an integer satisfying 0 ≤ a1 ≤ 5+2a3-a2, a2 is an integer of 1 to 3, and a3 is an integer of 0 to 2, 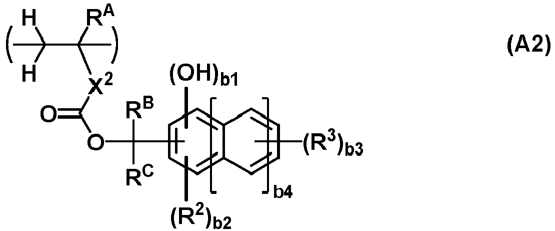 wherein R^{A} is hydrogen, fluorine, methyl or trifluoromethyl,
      X² is a single bond, ^{∗}-C(=O)-O-X²¹-, phenylene group, or naphthylene group, the phenylene group and naphthylene group may be substituted with an optionally fluorinated C₁-C₁₀ alkoxy moiety or halogen, X²¹ is a C₁-C₂₀ aliphatic hydrocarbylene group, phenylene group or naphthylene group, the aliphatic hydrocarbylene group may contain at least one moiety selected from an optionally fluorinated C₁-C₁₀ alkoxy moiety, hydroxy, ether bond, ester bond and lactone ring, * designates a point of attachment to the carbon atom in the backbone,
      R^{B} and R^{C} are each independently a C₁-C₁₀ hydrocarbyl group which may contain a heteroatom, R^{B} and R^{C} may bond together to form a ring with the carbon atom to which they are attached,
      R² is each independently halogen, cyano group, C₁-C₅ acyl group, C₁-C₅ alkoxy group, C₁-C₅ fluorinated alkyl group, or C₁-C₅ fluorinated alkoxy group,
      R³ is each independently a C₁-C₁₀ hydrocarbyl group which may contain a heteroatom,
      b1 is an integer of 0 to 2, b2 is an integer of 0 to 2, b3 is an integer of 0 to 5, and b4 is an integer of 0 to 2, with the proviso that b1 and b2 are not equal to 0 at the same time.
2. The mask blank of 1 wherein the phenolic hydroxy group-containing unit is a repeat unit having the following formula (A1-1), and the unit containing a carboxy group protected with an acid labile group is a repeat unit having the following formula (A2-1): 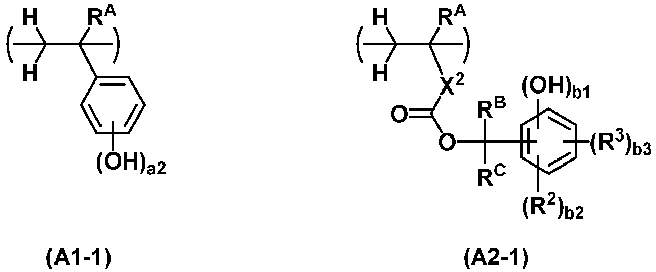 wherein R^{A}, R^{B}, R^{C}, X², R², R³, a2, b1, b2 and b3 are as defined above, with the proviso that b1 and b2 are not equal to 0 at the same time.
3. The mask blank of 1or 2 wherein b2 is 1 or 2, and R² is fluorine, trifluoromethyl or trifluoromethoxy.
4. The mask blank of any one of 1 to 3 wherein the polymer further comprises repeat units having any one of the formulae (B 1) to (B3): 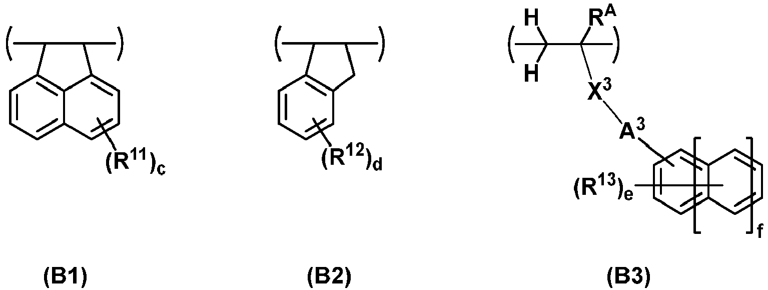 wherein R^{A} is as defined above,
   c and d are each independently an integer of 0 to 4, e is an integer of 0 to 5, f is an integer of 0 to 2,
   X³ is a single bond, *-C(=O)-O- or *-C(=O)-NH-, * designates a point of attachment to the carbon atom in the backbone,
   A³ is a single bond or a C₁-C₁₀ saturated hydrocarbylene group in which some constituent -CH₂- may be replaced by -O-,
   R¹¹ and R¹² are each independently hydroxy, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group,
   R¹³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group or cyano group, R¹³ may also be hydroxy when f is 1 or 2.
5. The mask blank of any one of 1 to 4 wherein the polymer further comprises repeat units having any one of the formulae (C1) to (C8): 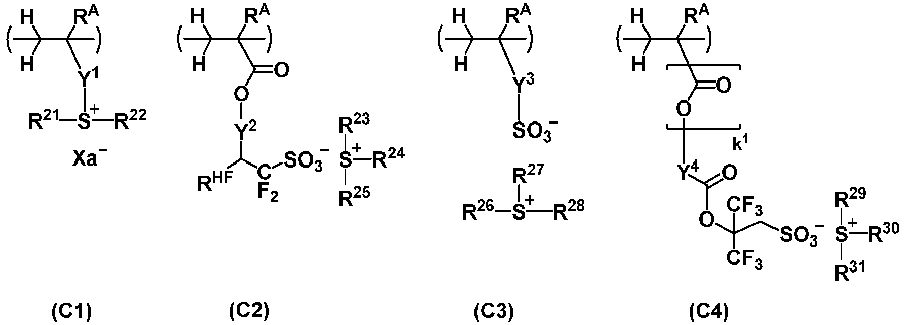 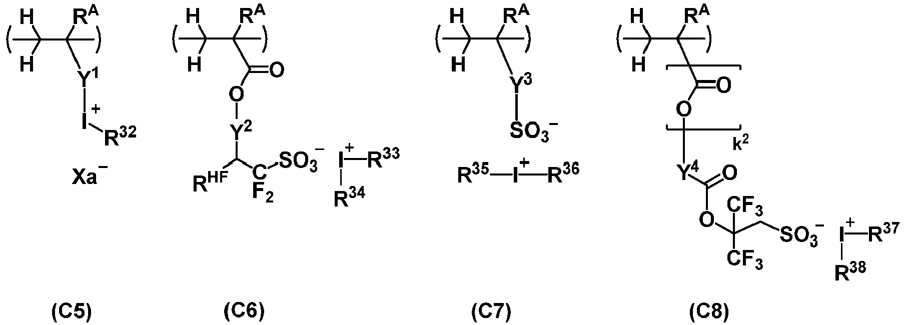 wherein R^{A} is as defined above,
   Y¹ is a single bond, a C₁-C₆ aliphatic hydrocarbylene group, phenylene group, naphthylene group or C₇-C₁₈ group obtained by combining the foregoing, ^{∗}-O-Y¹¹-, ^{∗}-C(=O)-O-Y¹¹-, or ^{∗}-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
   Y² is a single bond or ^{∗∗}-Y²¹-C(=O)-O-, Y²¹ is a C₁-C₂₀ hydrocarbylene group which may contain a heteroatom,
   Y³ is a single bond, methylene, ethylene, phenylene, fluorinated phenylene, trifluoromethyl-substituted phenylene, ^{∗}-O-Y³¹-, ^{∗}-C(=O)-O-Y³¹-, or ^{∗}-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
   * designates a point of attachment to the carbon atom in the backbone, ** designates a point of attachment to the oxygen atom in the formula,
   Y⁴ is a single bond or C₁-C₃₀ hydrocarbylene group which may contain a heteroatom, k¹ and k² are each independently 0 or 1, k¹ and k² are 0 when Y⁴ is a single bond,
   R²¹ to R³⁸ are each independently halogen or a C₁-C₂₀ hydrocarbyl group which may contain a heteroatom, R²¹ and R²² may bond together to form a ring with the sulfur atom to which they are attached, R²³ and R²⁴, R²⁶ and R²⁷, or R²⁹ and R³⁰ may bond together to form a ring with the sulfur atom to which they are attached,
   R^{HF} is hydrogen or trifluoromethyl, and
   Xa⁻ is a non-nucleophilic counter ion.
6. The mask blank of any one of 1 to 5 wherein the resist composition further comprises a fluorinated polymer comprising repeat units of at least one type selected from repeat units having the following formula (D1), repeat units having the following formula (D2), repeat units having the following formula (D3), and repeat units having the following formula (D4) and optionally repeat units of at least one type selected from repeat units having the following formula (D5) and repeat units having the following formula (D6): 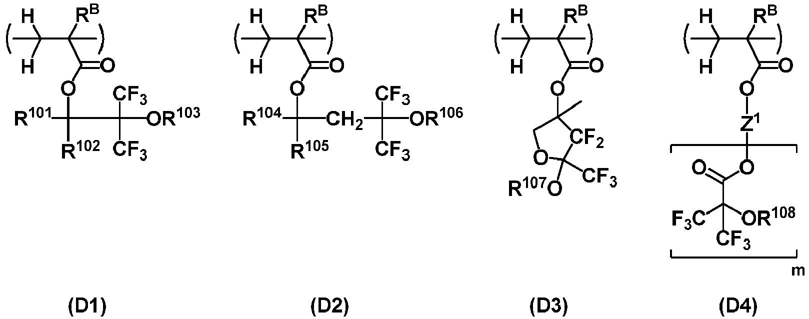 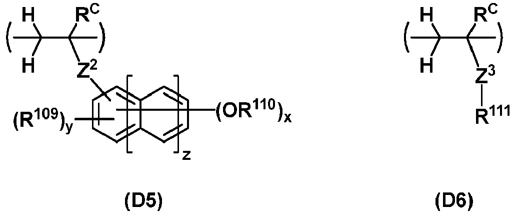 wherein R^{B} is each independently hydrogen, fluorine, methyl or trifluoromethyl,
   R^{C} is each independently hydrogen or methyl,
   R¹⁰¹, R¹⁰², R¹⁰⁴ and R¹⁰⁵ are each independently hydrogen or a C₁-C₁₀ saturated hydrocarbyl group,
   R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
   R¹⁰⁹ is hydrogen or a C₁-C₅ straight or branched hydrocarbyl group in which a heteroatom-containing moiety may intervene in a carbon-carbon bond,
   R¹¹⁰ is hydrogen or a C₁-C₅ straight or branched hydrocarbyl group in which a heteroatom-containing moiety may intervene in a carbon-carbon bond,
   R¹¹¹ is a C₁-C₂₀ saturated hydrocarbyl group in which at least one hydrogen atom is substituted by fluorine and in which some constituent -CH₂- may be replaced by an ester bond or ether bond,
   x is an integer of 1 to 3, y is an integer satisfying 0 ≤ y ≤ 5+2z-x, z is 0 or 1, m is an integer of 1 to 3,
   Z¹ is a C₁-C₂₀ (m+1)-valent hydrocarbon group or C₁-C₂₀ (m+1)-valent fluorinated hydrocarbon group,
   Z² is a single bond, *-C(=O)-O- or *-C(=O)-NH-, * designates a point of attachment to the carbon atom in the backbone, and
   Z³ is a single bond, -O-, ^{∗}-C(=O)-O-Z³¹-Z³²- or ^{∗}-C(=O)-NH-Z³¹-Z³²-, Z³¹ is a single bond or a C₁-C₁₀ saturated hydrocarbylene group, Z³² is a single bond, ester bond, ether bond or sulfonamide bond, * designates a point of attachment to the carbon atom in the backbone.
7. The mask blank of any one of 1 to 6 wherein the resist composition further comprises a photoacid generator.
8. The mask blank of 7 wherein the photoacid generator has an anion having an acid strength (pKa) of -2.0 or larger.
9. The mask blank of any one of 1 to 8 wherein the resist composition further comprises a quencher.
10. The mask blank of any one of 1 to 9 wherein the resist film has a dissolution rate in overexposed region of at least 100 nm/sec.
11. The mask blank of any one of 1 to 10 wherein the mask blank has an outermost surface prior to coating of the resist composition, the outermost surface being composed of a material containing at least one element selected from chromium, silicon, tantalum, molybdenum, cobalt, nickel, tungsten and tin.
12. The mask blank of 11 which is of reflection type.
13. A resist pattern forming process comprising the steps of:
   exposing the resist film of the mask blank of any one of 1 to 12 patternwise to high-energy radiation, and
   developing the exposed resist film in an alkaline developer.
14. The process of 13 wherein the high-energy radiation is EB.
15. A chemically amplified positive resist composition comprising a base polymer containing a polymer comprising phenolic hydroxy group-containing repeat units having the formula (A1) and repeat units containing a carboxy group protected with an acid labile group, having the formula (A2), an organic solvent, a photoacid generator, and a quencher, wherein a weight ratio of the photoacid generator to the quencher is less than 6/1, 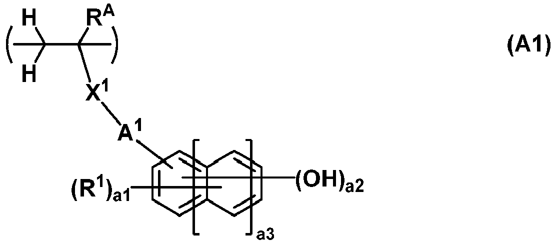 wherein R^{A} is hydrogen, fluorine, methyl or trifluoromethyl,
   X¹ is a single bond, *-C(=O)-O- or *-C(=O)-NH-, * designates a point of attachment to the carbon atom in the backbone,
   A¹ is a single bond or a C₁-C₁₀ saturated hydrocarbylene group in which some constituent -CH₂- may be replaced by -O-,
   R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
   a1 is an integer satisfying 0 ≤ a1 ≤ 5+2a3-a2, a2 is an integer of 1 to 3, and a3 is an integer of 0 to 2, 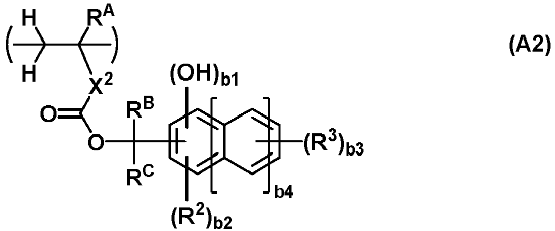
   wherein R^{A} is hydrogen, fluorine, methyl or trifluoromethyl,
   X² is a single bond, ^{∗}-C(=O)-O-X²¹-, phenylene group, or naphthylene group, the phenylene group and naphthylene group may be substituted with an optionally fluorinated C₁-C₁₀ alkoxy moiety or halogen, X²¹ is a C₁-C₂₀ aliphatic hydrocarbylene group, phenylene group or naphthylene group, the aliphatic hydrocarbylene group may contain at least one moiety selected from an optionally fluorinated C₁-C₁₀ alkoxy moiety, hydroxy, ether bond, ester bond and lactone ring, * designates a point of attachment to the carbon atom in the backbone,
   R^{B} and R^{C} are each independently a C₁-C₁₀ hydrocarbyl group which may contain a heteroatom, R^{B} and R^{C} may bond together to form a ring with the carbon atom to which they are attached,
   R² is each independently halogen, cyano group, C₁-C₅ acyl group, C₁-C₅ alkoxy group, C₁-C₅ fluorinated alkyl group, or C₁-C₅ fluorinated alkoxy group,
   R³ is each independently a C₁-C₁₀ hydrocarbyl group which may contain a heteroatom,
   b 1 is an integer of 0 to 2, b2 is an integer of 0 to 2, b3 is an integer of 0 to 5, b4 is an integer of 0 to 2, b1 and b2 are not equal to 0 at the same time.

### ADVANTAGEOUS EFFECTS OF INVENTION

Since the chemically amplified positive resist composition is formulated so as to restrain the influence of backward scattering inherent to mask blanks, the composition forms a pattern with a very high resolution, reduced LER, and improved rectangularity of a profile after exposure, while controlling the influence of develop loading. It is thus suited as a resist composition for forming a resist film which is sensitive to high-energy radiation such as UV, deep UV, EB, EUV, X-ray, γ-ray or synchrotron radiation and useful in the processing of semiconductor substrates and photomask blanks. The pattern forming process using the positive resist composition can form a resist pattern with a high resolution, etch resistance, reduced LER and controlled influence of develop loading. The process is best suited in the micropatterning technology, typically EB lithography.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. The terms "group" and "moiety" are interchangeable. In chemical formulae, the broken line designates a valence bond.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Mask blank

One embodiment of the invention is a mask blank comprising a resist film which is obtained by coating a chemically amplified positive resist composition. The resist composition is defined as comprising a base polymer containing a polymer comprising phenolic hydroxy group-containing repeat units (also referred to as repeat units A1, hereinafter) and repeat units having a carboxy group which is protected with an acid labile group in the form of a tertiary hydrocarbyl group having an electron attractive moiety and/or hydroxy moiety-substituted phenyl group bonded to the tertiary carbon (also referred to as repeat units A2, hereinafter), and an organic solvent. The polymer turns alkali soluble as a result of the acid labile group being eliminated under the action of acid.

The repeat unit A1 has the formula (A1).

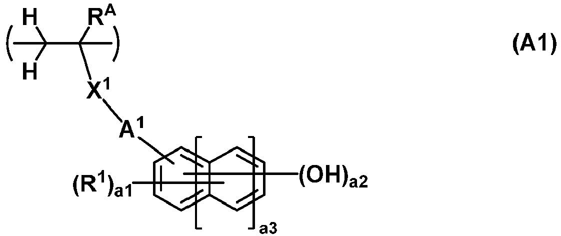

In formula (A1), a1 is an integer satisfying 0 ≤ a1 ≤ 5+2a3-a2, a2 is an integer of 1 to 3, and a3 is an integer of 0 to 2.

In formula (A1), R^{A} is hydrogen, fluorine, methyl or trifluoromethyl.

In formula (A1), X¹ is a single bond, *-C(=O)-O- or *-C(=O)-NH-. The asterisk (*) designates a point of attachment to the carbon atom in the backbone.

In formula (A1), A¹ is a single bond or a C₁-C₁₀ saturated hydrocarbylene group in which some constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof.

In formula (A1), R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof include alkyl groups such as methyl, ethyl, n-propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. Groups R¹ may be identical or different when a1 is 2 or more.

Preferred examples of the repeat unit A1 wherein both X¹ and A¹ are a single bond include units derived from 3-hydroxystyrene, 4-hydroxystyrene, 5-hydroxy-2-vinylnaphthalene, and 6-hydroxy-2-vinylnaphthalene. Of these, repeat units having the formula (A1-1) are more preferred. 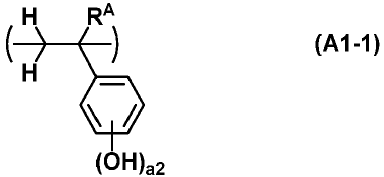 Herein R^{A} and a2 are as defined above.

Preferred examples of the repeat unit A1 wherein X¹ is other than a single bond are shown below, but not limited thereto. Herein R^{A} is as defined above.

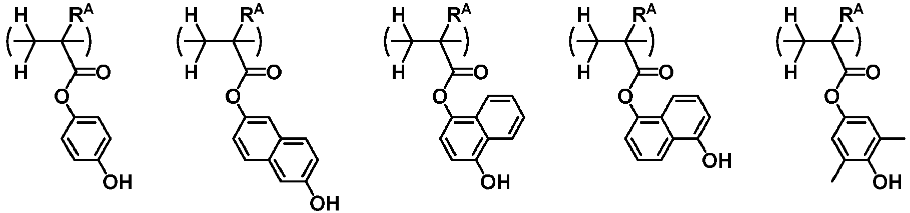

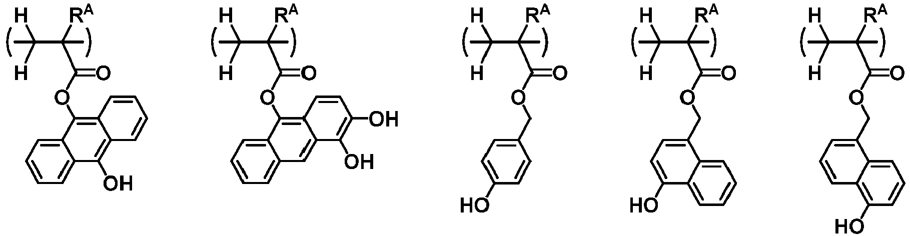

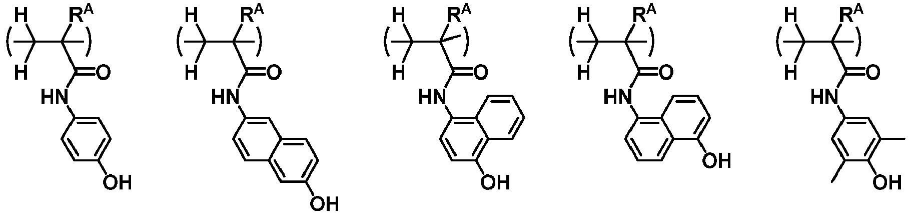

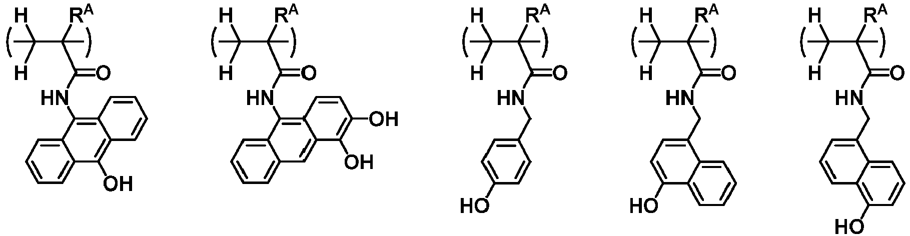

The repeat units A1 are preferably incorporated in a range of 10 to 95 mol%, more preferably 30 to 85 mol% based on the overall repeat units of the polymer in the base polymer. It is noted that when the polymer contains additional repeat units of at least one type selected from repeat units having formulae (B 1) and (B2) contributing to high etching resistance, the additional repeat units having a phenolic hydroxy group as a substituent group, the sum of repeat units A1 and additional repeat units preferably falls in the above range. The repeat units A1 used herein may be of one type or a mixture of two or more types.

The repeat unit A2 has the following formula (A2).

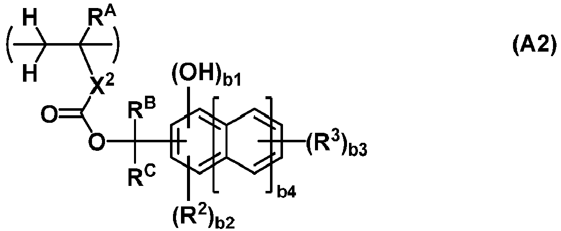

In formula (A2), R^{A} is as defined above. X² is a single bond, ^{∗}-C(=O)-O-X²¹-, phenylene group, or naphthylene group. The phenylene group and naphthylene group may be substituted with an optionally fluorinated C₁-C₁₀ alkoxy group or halogen. X²¹ is a C₁-C₂₀ aliphatic hydrocarbylene group, phenylene group or naphthylene group, the aliphatic hydrocarbylene group may contain at least one moiety selected from an optionally fluorinated C₁-C₁₀ alkoxy moiety, hydroxy, ether bond, ester bond and lactone ring. The asterisk (*) designates a point of attachment to the carbon atom in the backbone.

The aliphatic hydrocarbylene group may be saturated or unsaturated and straight, branched or cyclic. Examples thereof include alkanediyl groups such as methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, 1,1-dimethylethane-1,2-diyl, pentane-1,5-diyl, 2-methylbutane-1,2-diyl, hexane-1,6-diyl, heptane-1,7-diyl, octane-1,8-diyl, nonane-1,9-diyl, and decane-1,10-diyl; cycloalkanediyl groups such as cyclopropanediyl, cyclobutanediyl, cyclopentanediyl, and cyclohexanediyl; divalent polycyclic saturated hydrocarbylene groups such as adamantanediyl and norbornanediyl; and divalent groups obtained by combining the foregoing.

Examples of the unit having formula (A2) wherein X² is a variant are illustrated below, but not limited thereto. Herein R^{A} is as defined above, and the broken line designates a point of attachment to the carbon atom to which R^{B} and R^{C} are attached in formula (A2).

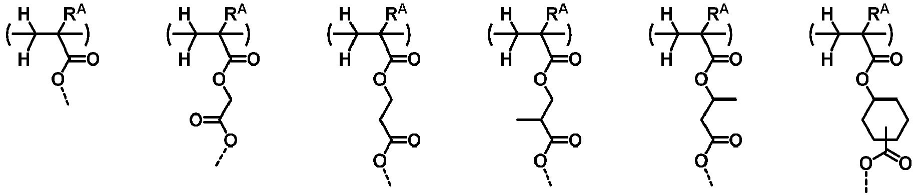

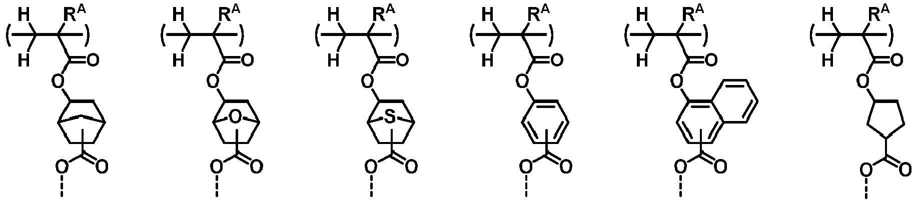

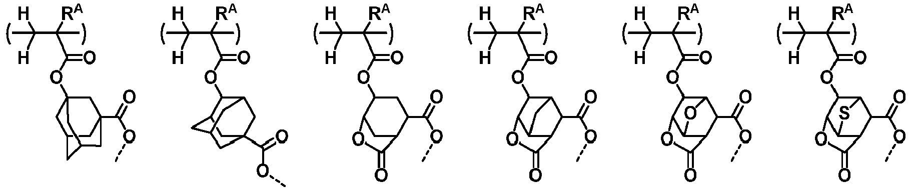

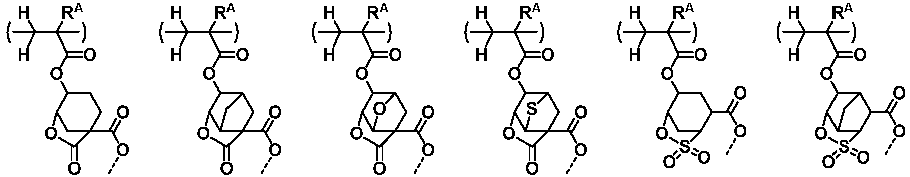

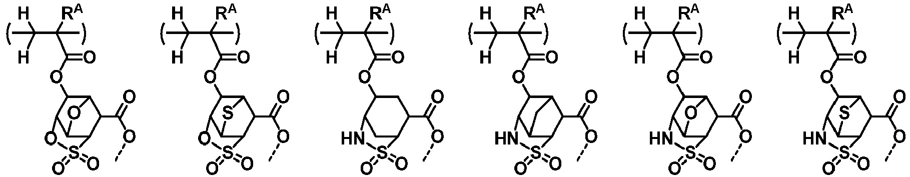

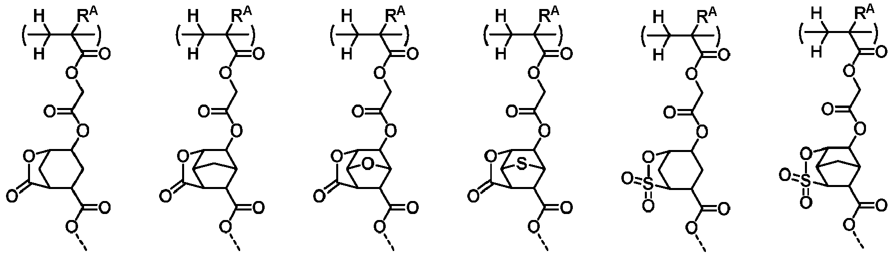

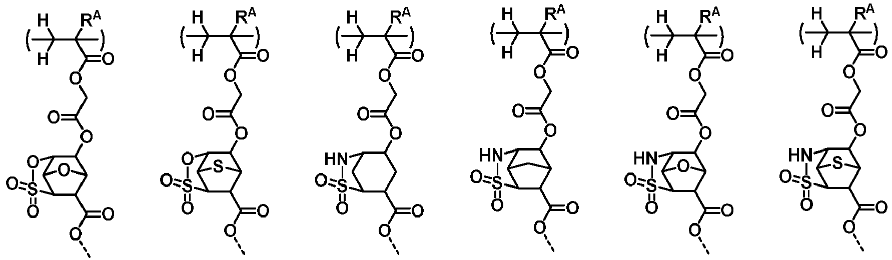

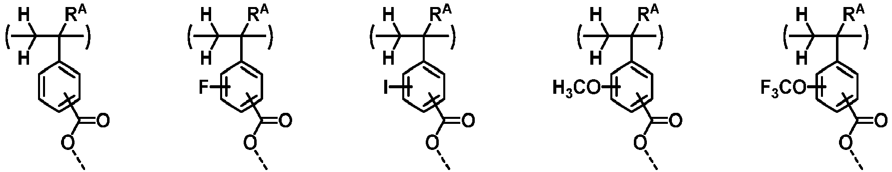

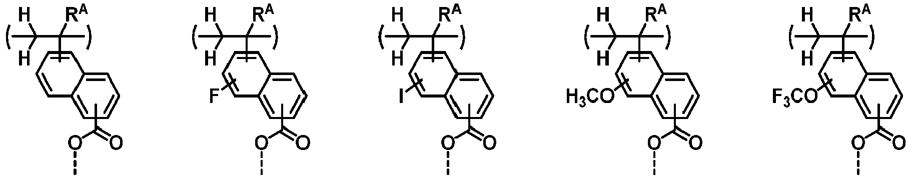

In formula (A2), R^{B} and R^{C} are each independently a C₁-C₁₀ hydrocarbyl group which may contain a heteroatom. The hydrocarbyl group may be saturated or unsaturated and straight, branched or cyclic. Examples thereof include C₁-C₁₀ alkyl groups such as methyl, ethyl, n-propyl, isopropyl, n-butyl, sec-butyl, tert-butyl, cyclopentyl, cyclohexyl, 2-ethylhexyl and n-octyl; and C₃-C₁₀ cyclic saturated hydrocarbyl groups such as cyclopentyl, cyclohexyl, norbornyl, tricyclodecanyl and adamantyl.

Also, R^{B} and R^{C} may bond together to form a ring with the carbon atom to which they are attached. Suitable rings include cyclopropane, cyclobutane, cyclopentane and cyclohexane rings, with cyclopentane and cyclohexane rings being preferred.

In formula (A2), R² is each independently halogen, cyano group, C₁-C₅ acyl group, C₁-C₅ alkoxy group, C₁-C₅ fluorinated alkyl group, or C₁-C₅ fluorinated alkoxy group. Examples of the fluorinated alkyl group include fluoromethyl, difluoromethyl, trifluoromethyl, 2,2,2-trifluoroethyl, pentafluoroethyl, pentafluoropropyl, 1,1,1,3,3,3-hexafluoro-2-propyl, and nonafluorobutyl. Examples of the fluorinated alkoxy group include fluoromethoxy, difluoromethoxy, trifluoromethoxy, 2,2,2-trifluoroethoxy, pentafluoroethoxy, pentafluoropropoxy, 1,1, 1,3,3,3-hexafluoro-2-propoxy and nonafluorobutoxy. Inter alia, R² is preferably fluorine, C₁-C₅ fluorinated alkyl group, or C₁-C₅ fluorinated alkoxy group, more preferably fluorine, trifluoromethyl or trifluoromethoxy.

In formula (A2), R³ is each independently a C₁-C₁₀ hydrocarbyl group which may contain a heteroatom. The hydrocarbyl group may be saturated or unsaturated and straight, branched or cyclic. Examples thereof are as exemplified above for the hydrocarbyl groups R^{B} and R^{C}.

In formula (A2), b1 is an integer of 0 to 2, b2 is an integer of 0 to 2, b1 and b2 are not equal to 0 at the same time.

In formula (A2), b3 is an integer of 0 to 5, preferably 0 or 1.

In formula (A2), b4 is an integer of 0 to 2. The structure represents a benzene ring when b4=0, a naphthalene ring when b4=1, and an anthracene ring when b4=2. Inter alia, the benzene ring corresponding to b4=0 is preferred from the aspect of solvent solubility.

The preferred repeat unit A2 has the formula (A2-1).

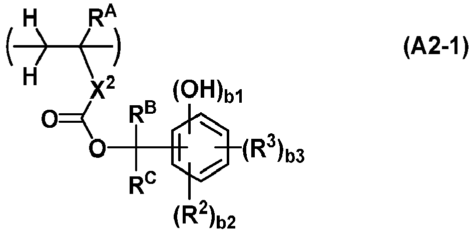

Herein R^{A}, R^{B}, R^{C}, X², R², R³, b 1, b2 and b3 are as defined above, with the proviso that b1 and b2 are not equal to 0 at the same time.

Examples of the repeat unit A2 are shown below, but not limited thereto. Herein, R^{A} is as defined above.

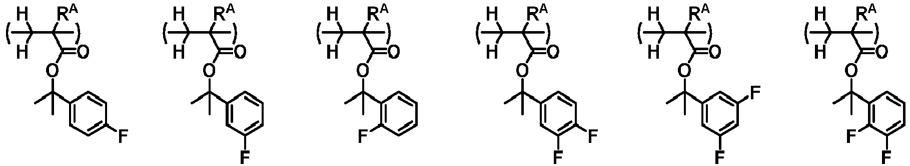

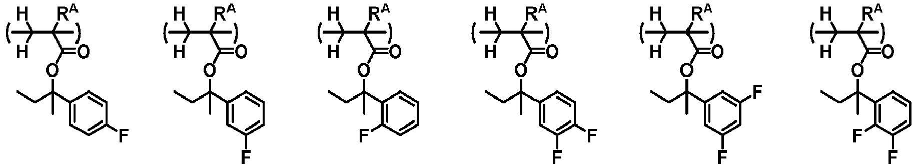

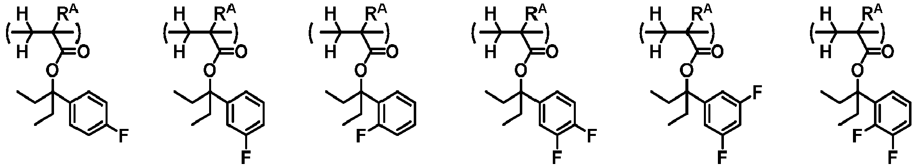

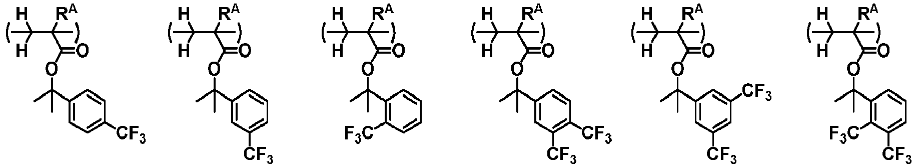

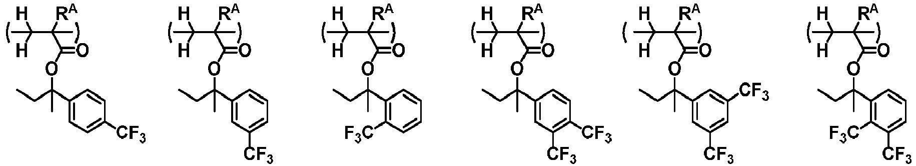

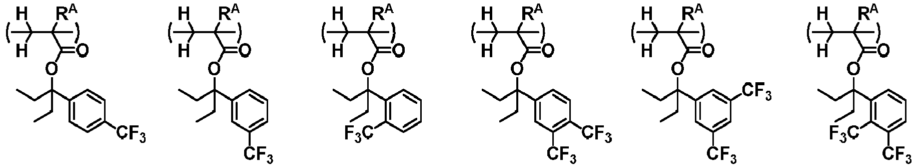

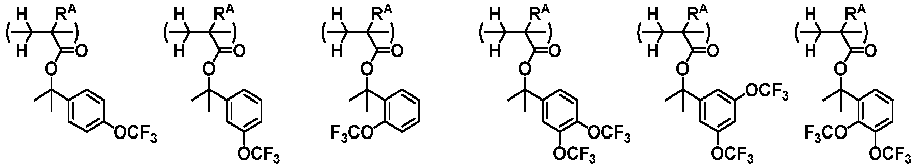

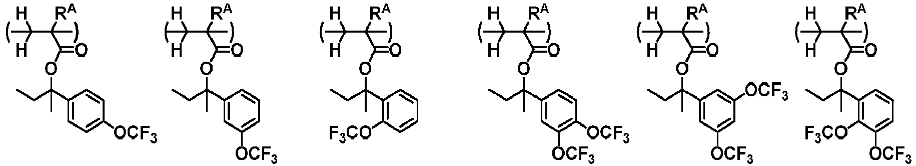

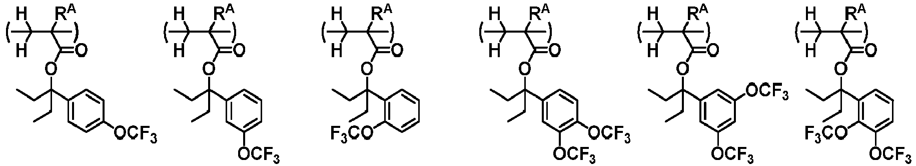

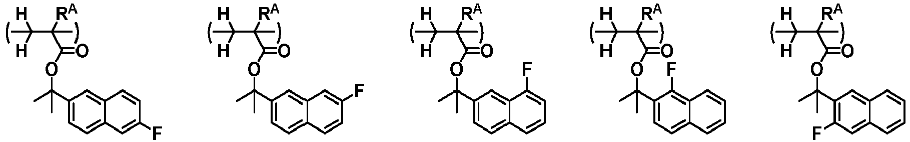

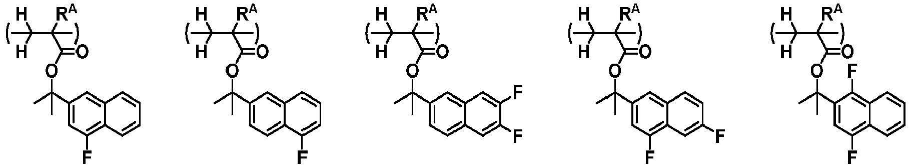

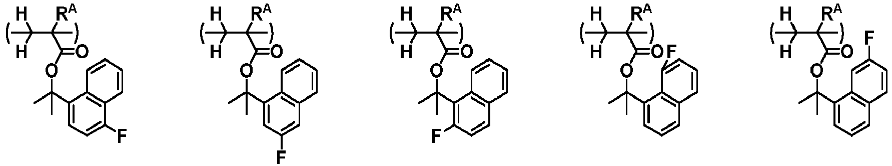

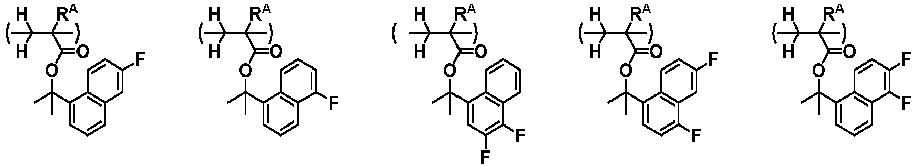

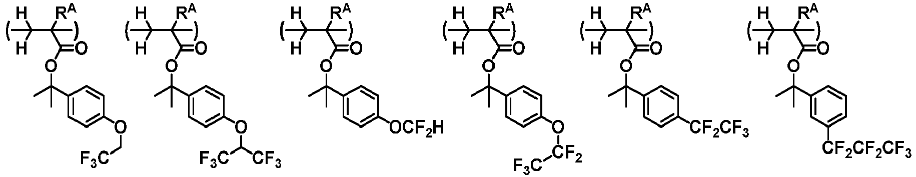

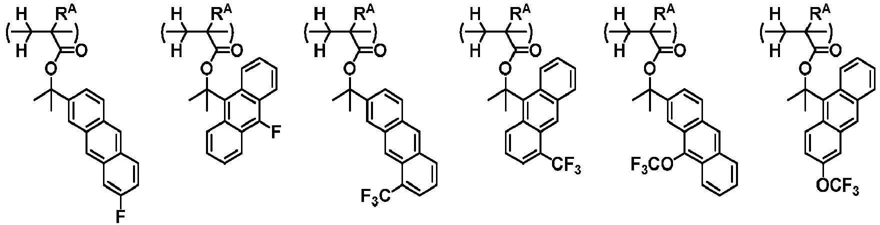

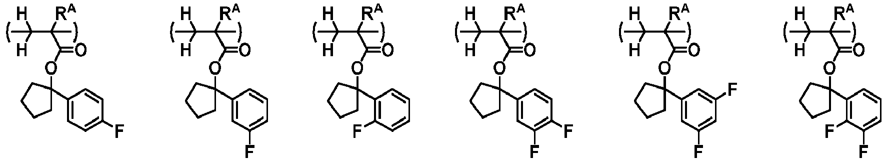

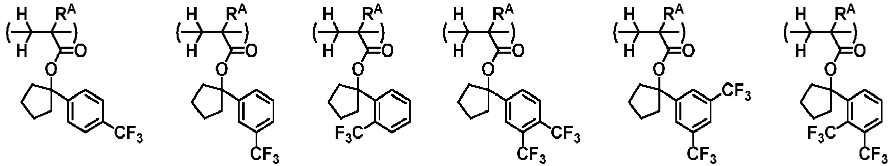

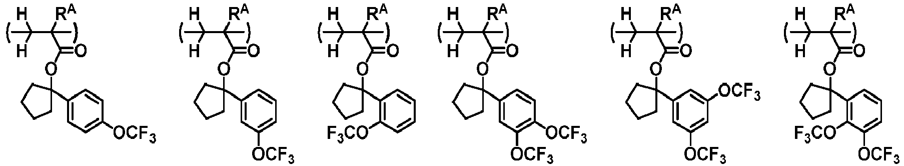

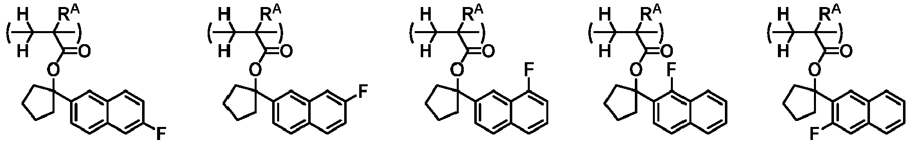

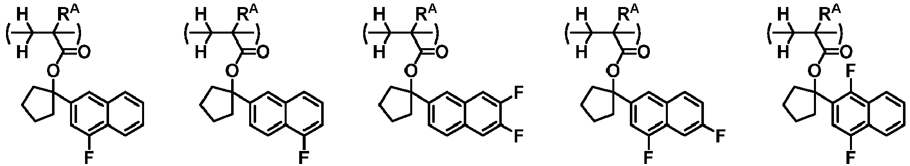

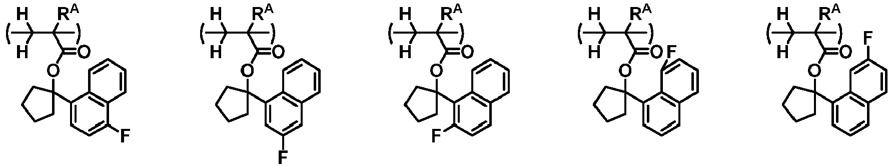

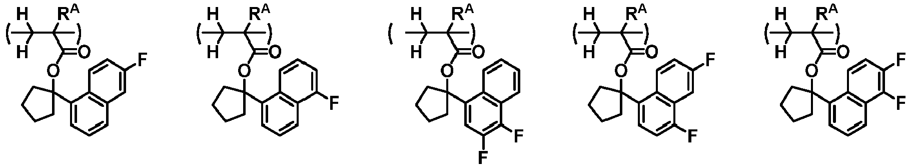

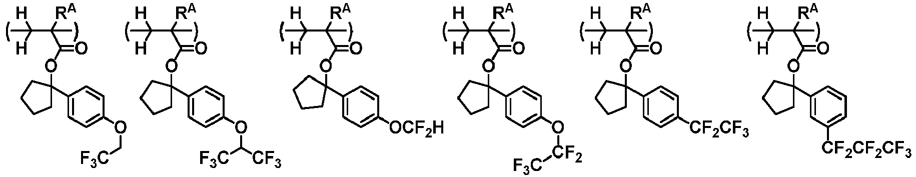

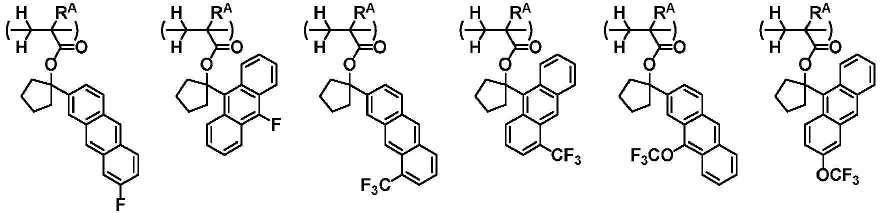

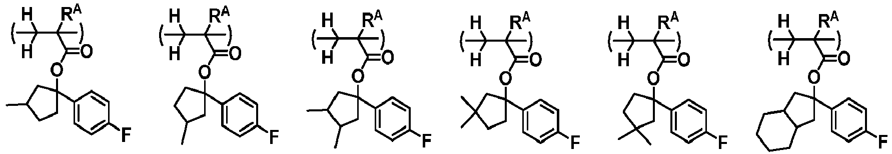

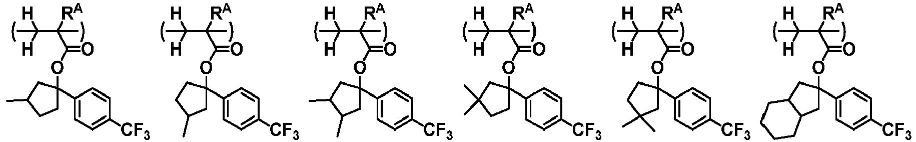

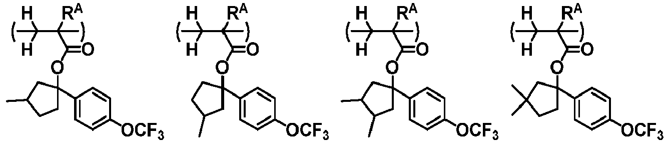

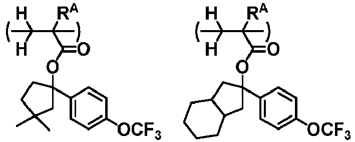

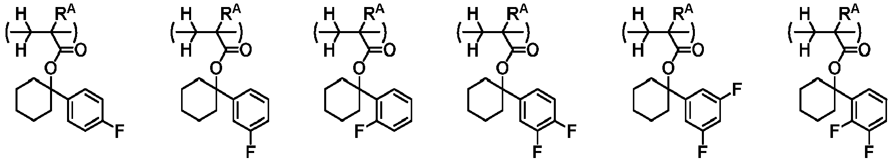

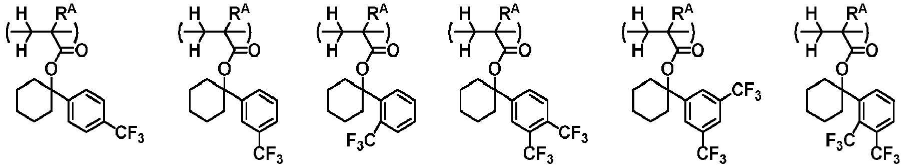

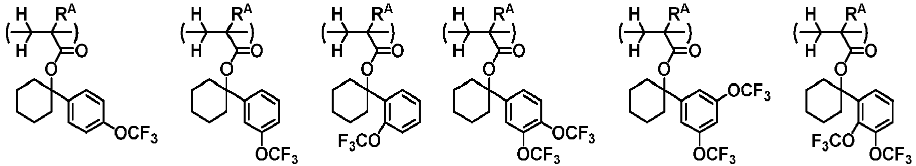

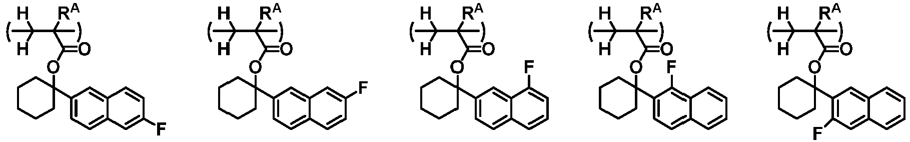

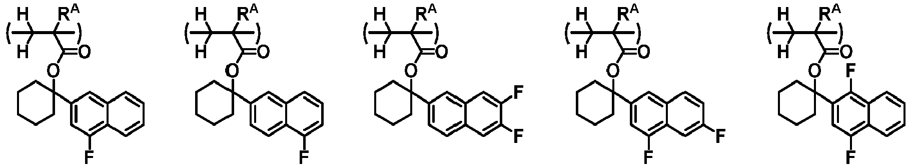

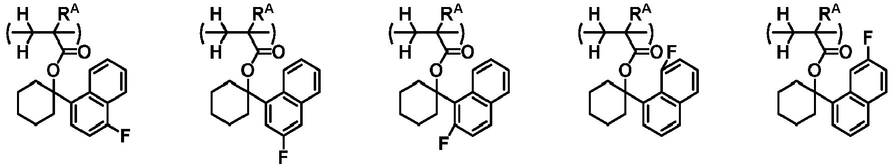

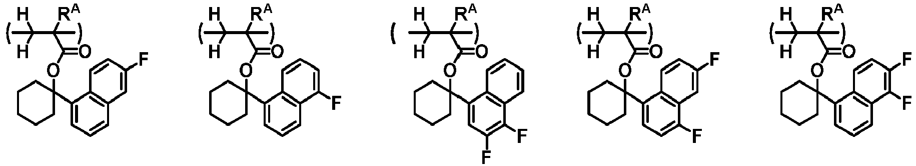

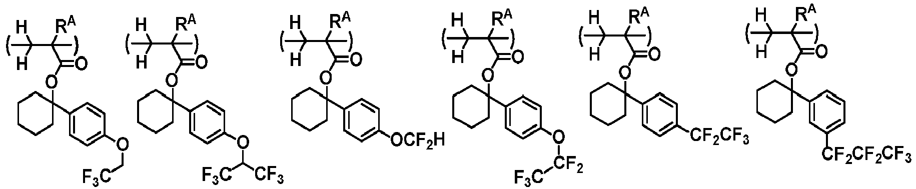

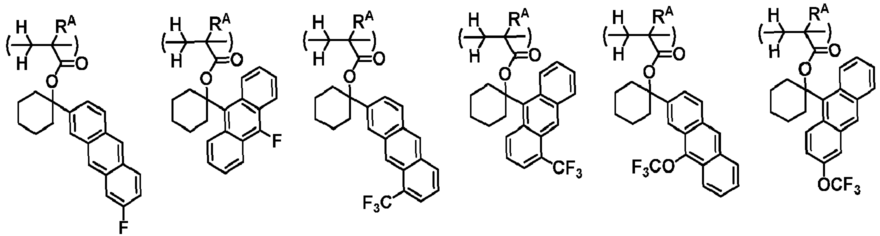

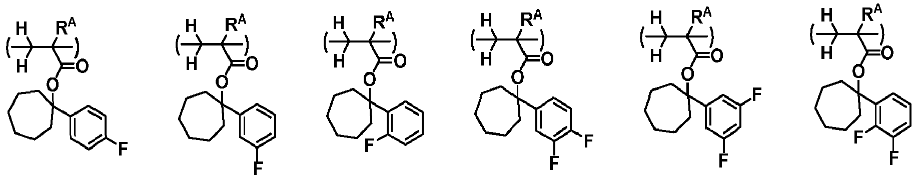

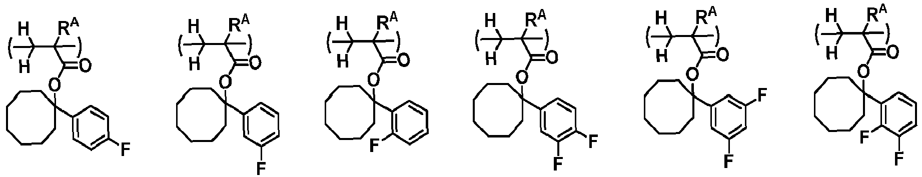

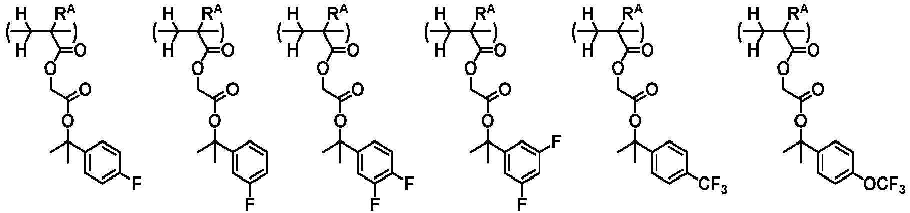

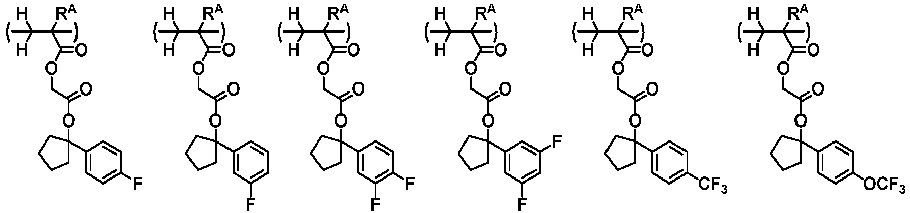

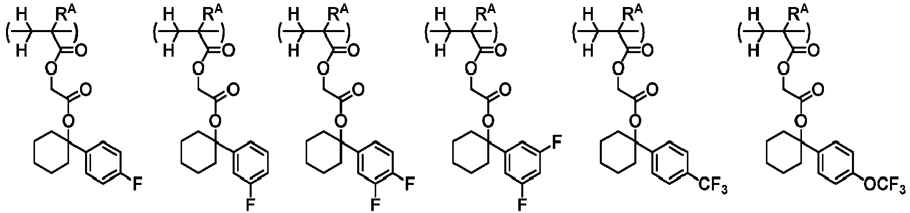

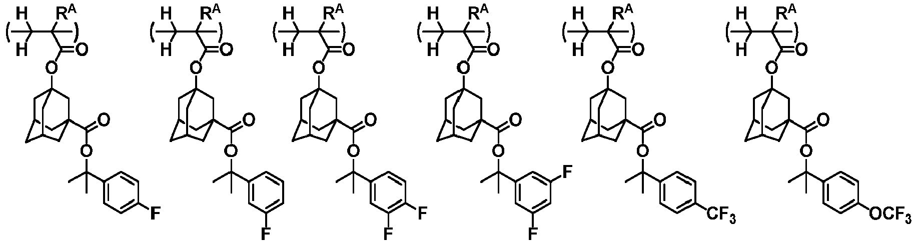

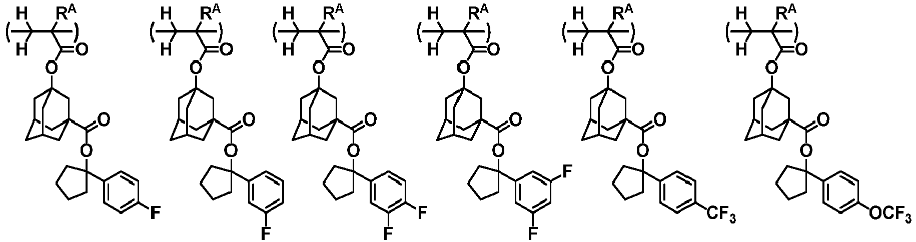

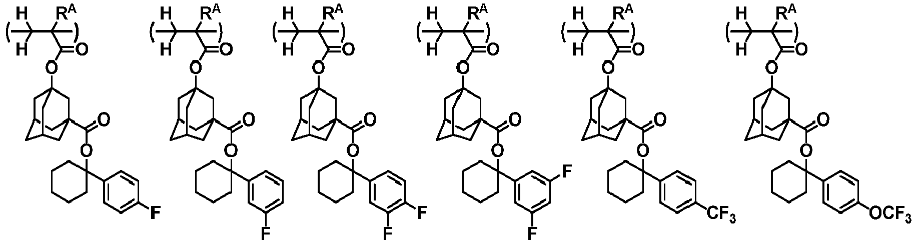

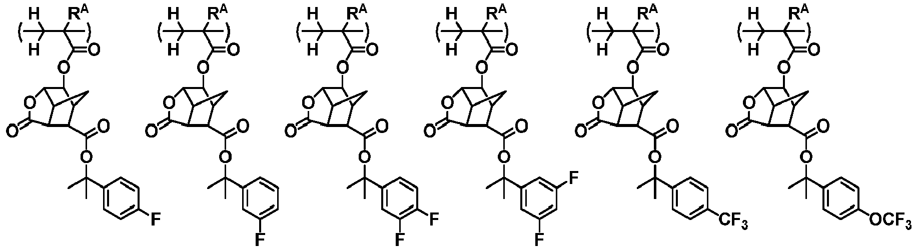

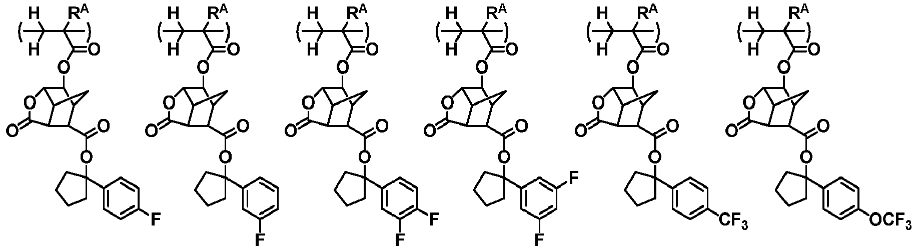

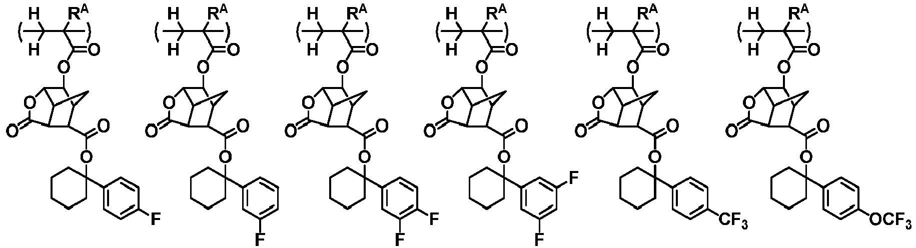

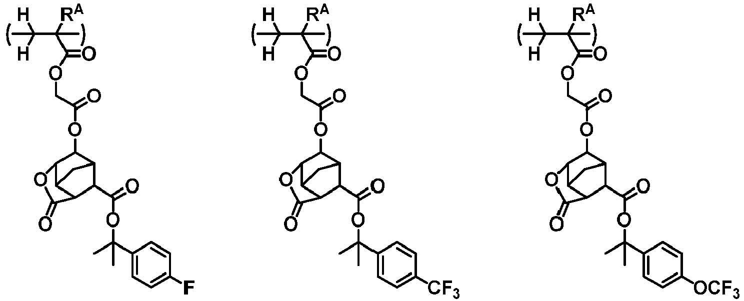

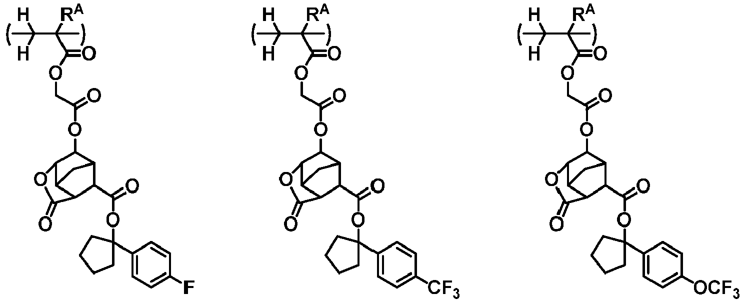

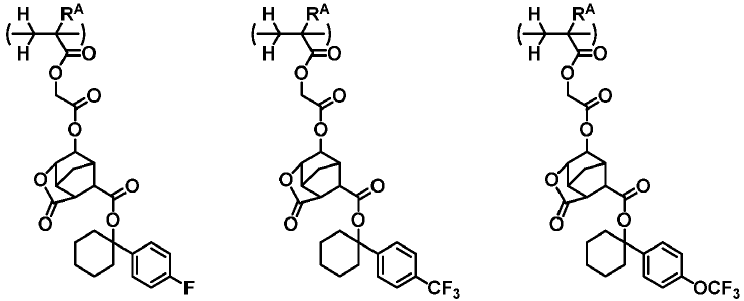

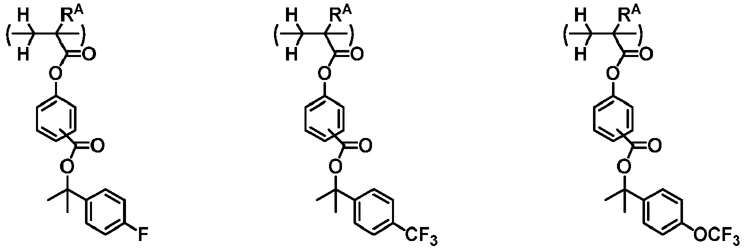

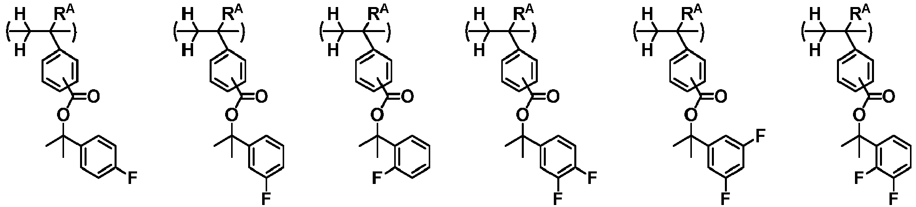

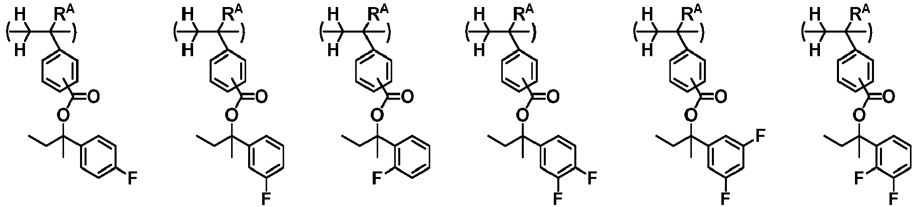

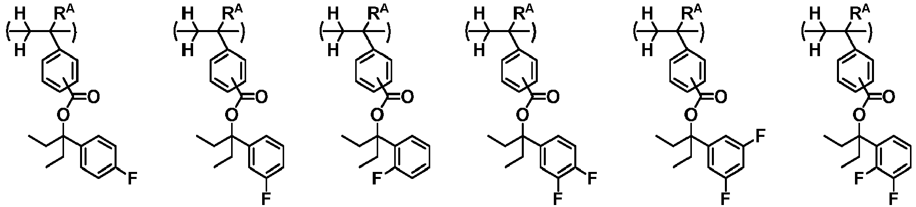

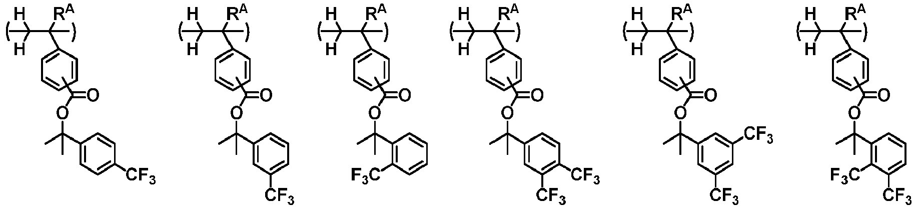

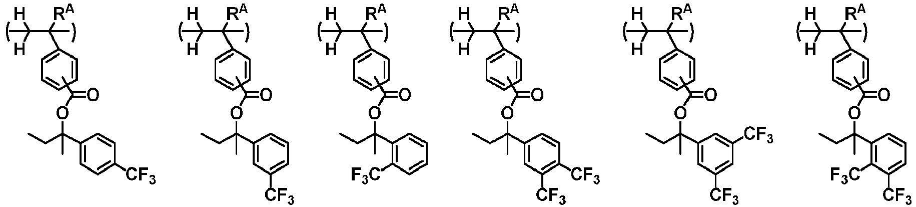

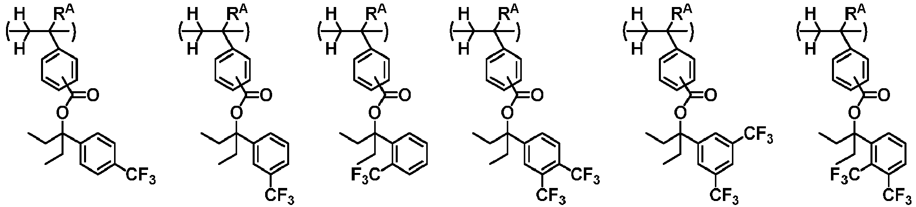

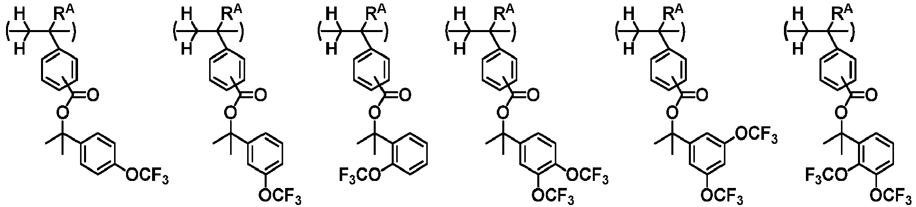

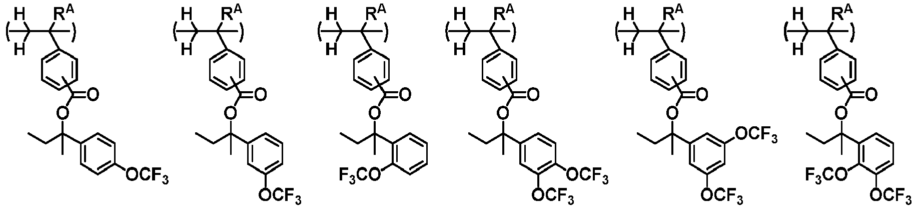

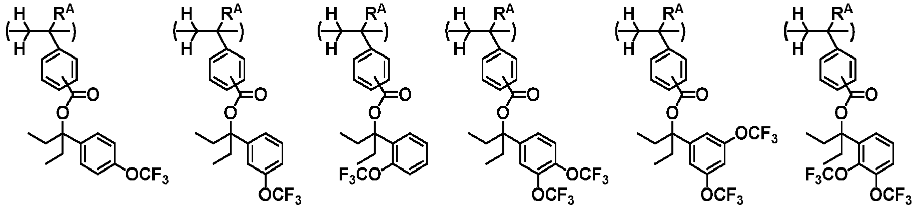

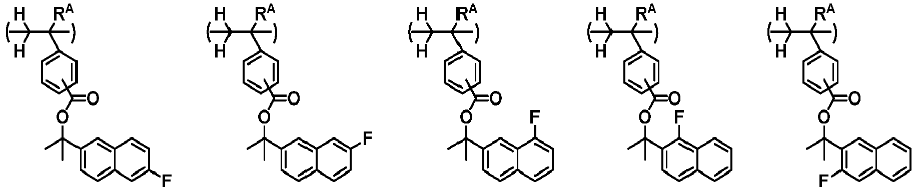

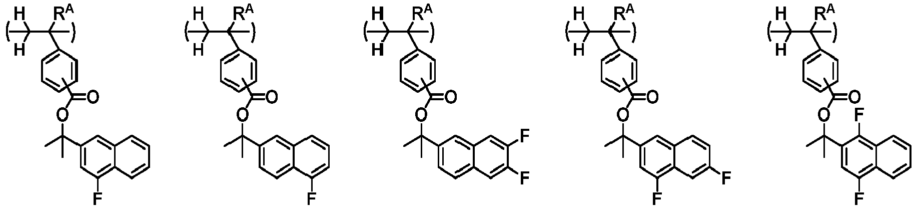

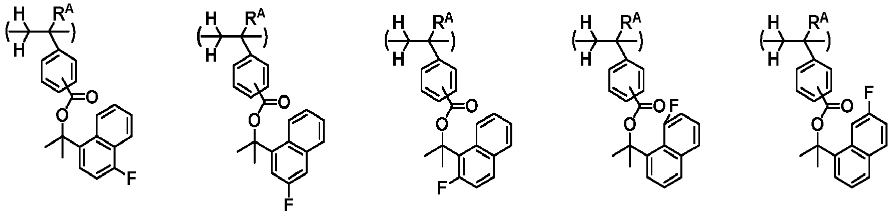

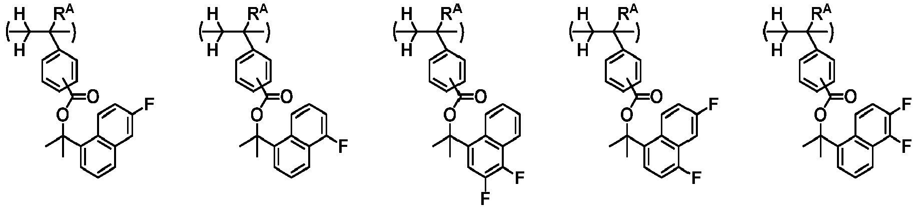

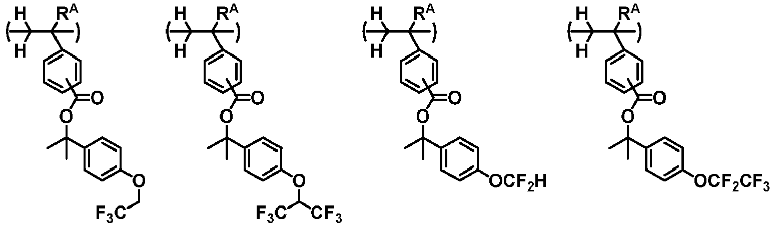

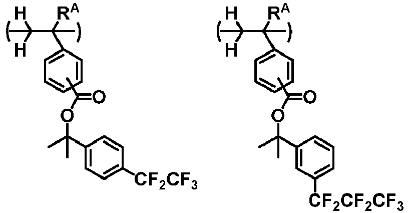

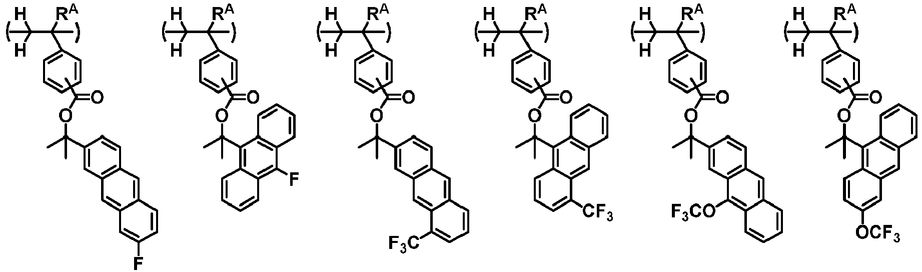

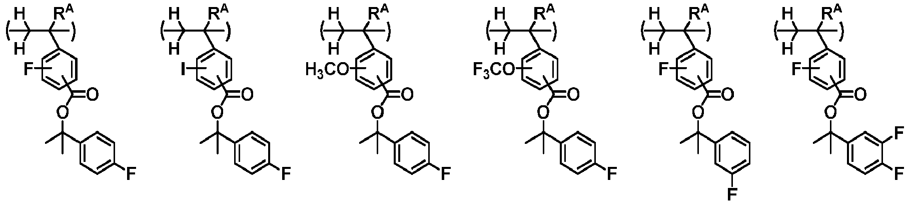

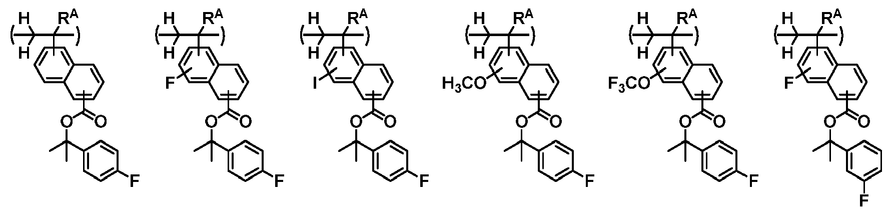

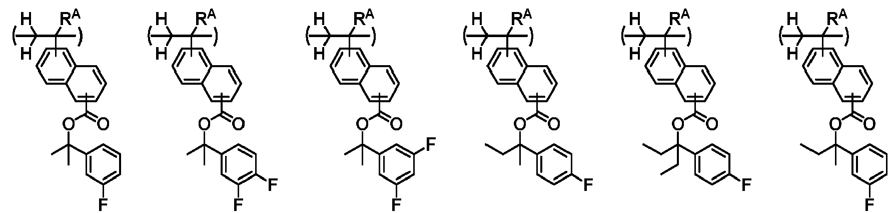

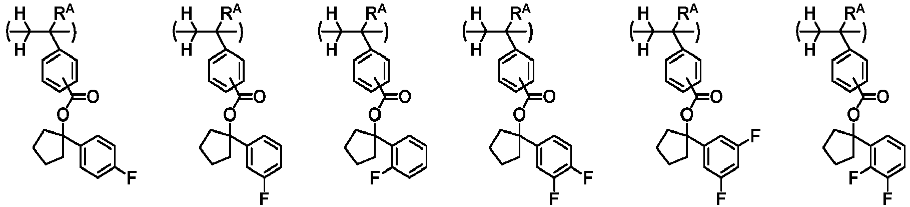

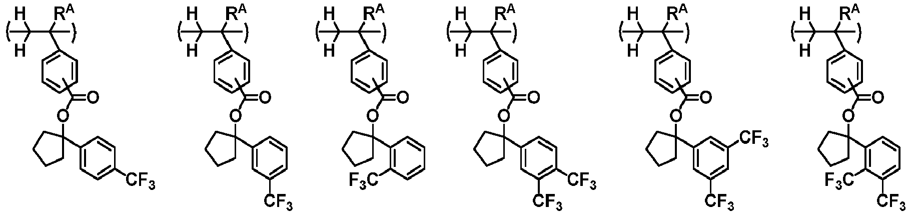

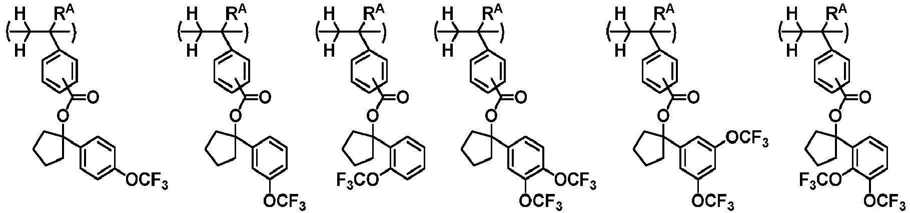

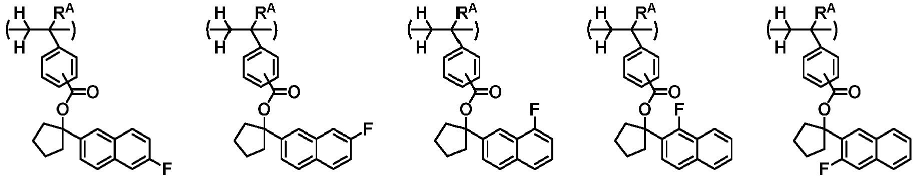

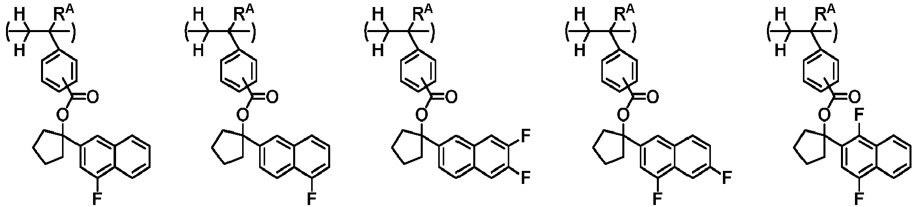

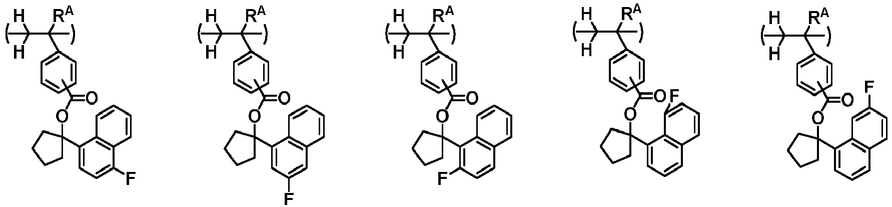

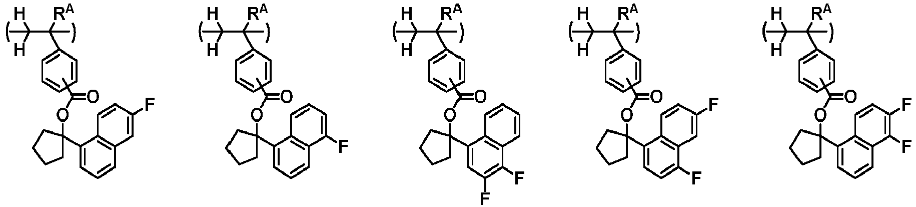

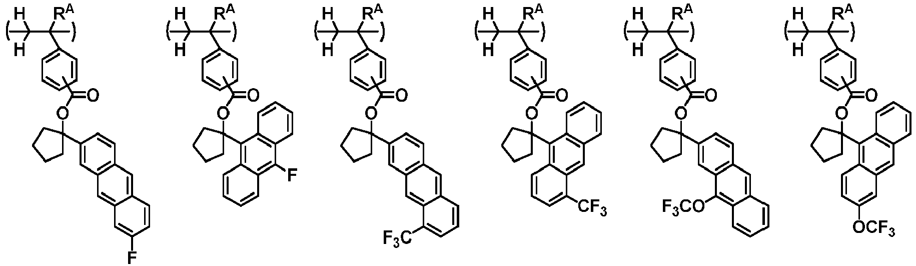

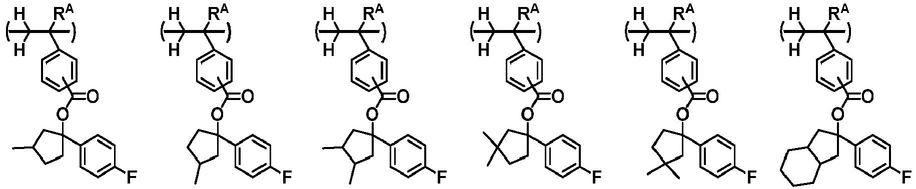

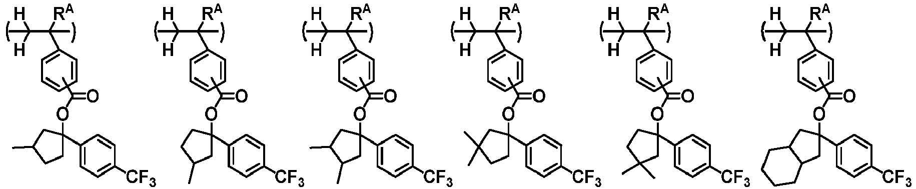

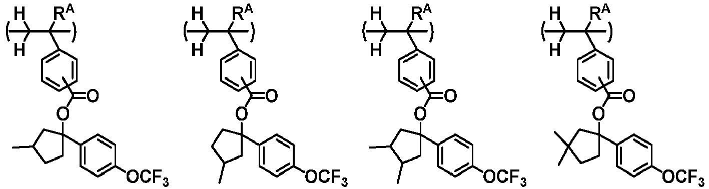

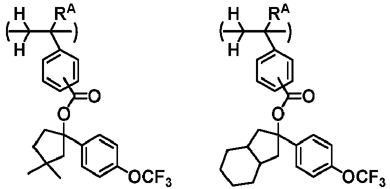

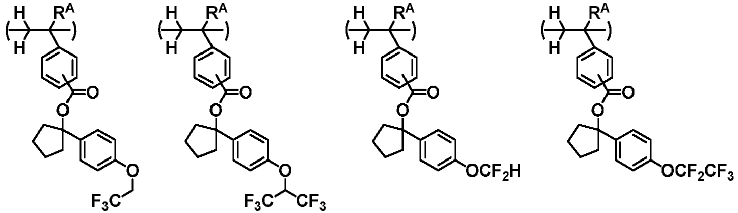

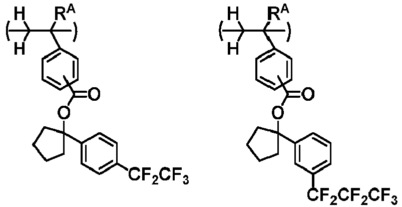

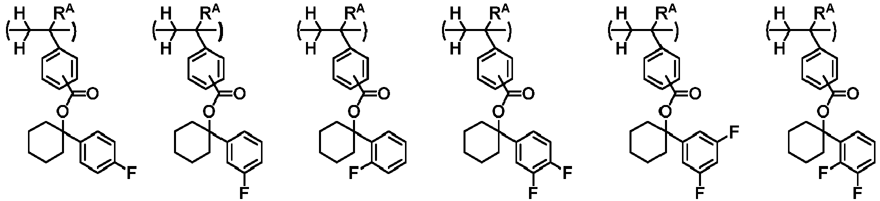

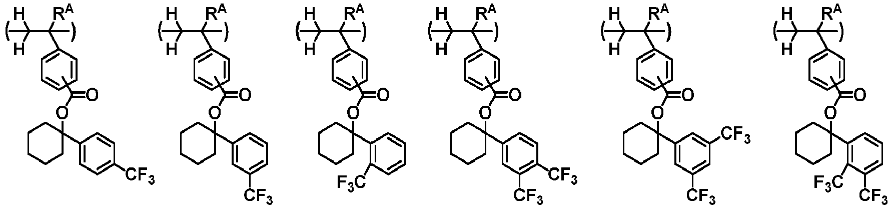

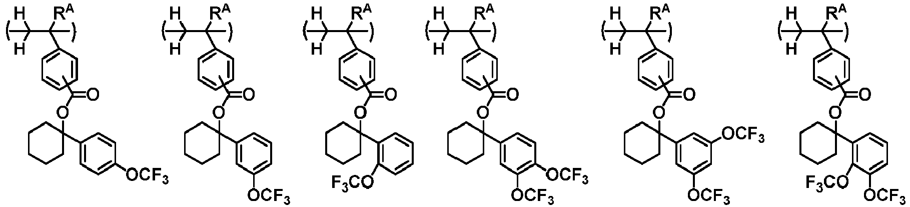

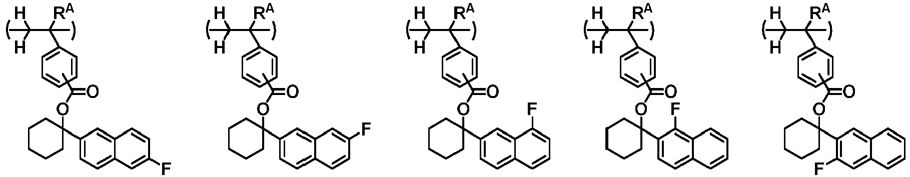

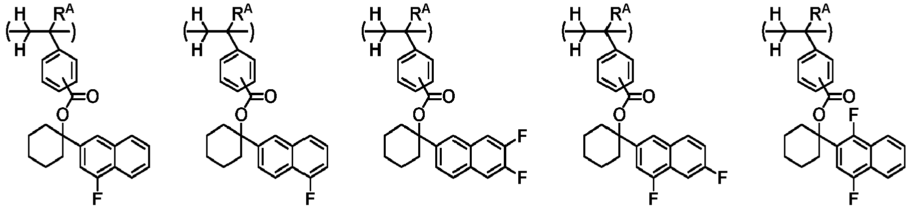

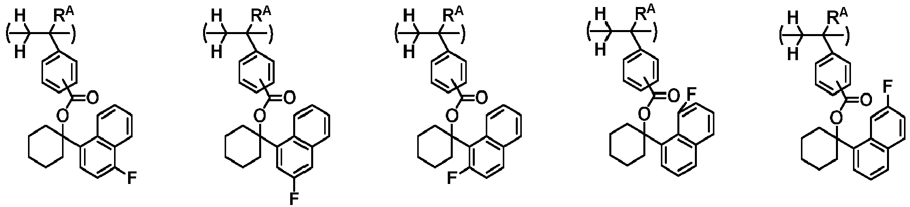

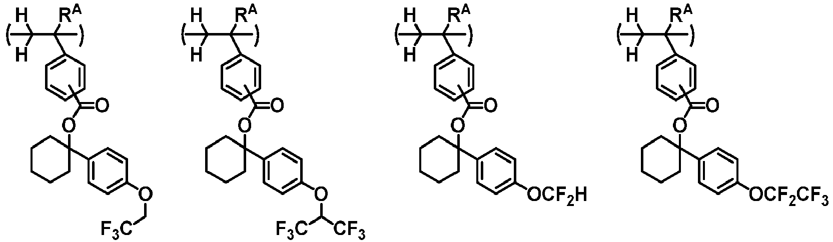

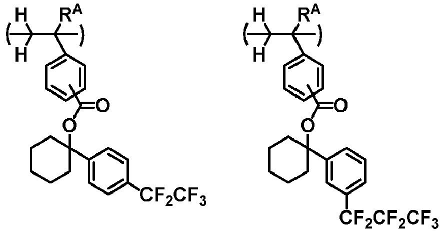

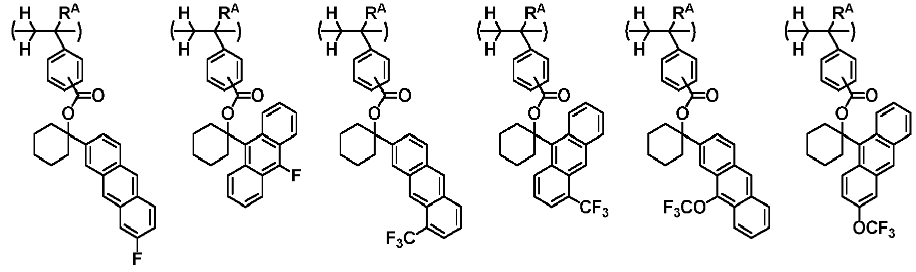

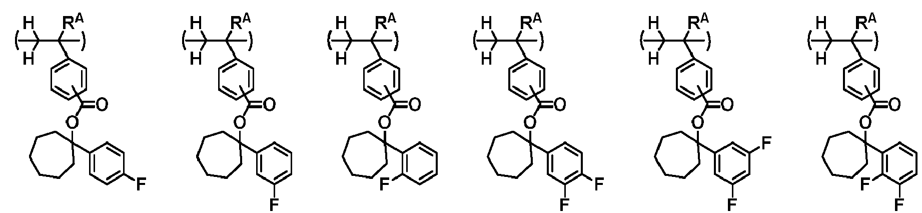

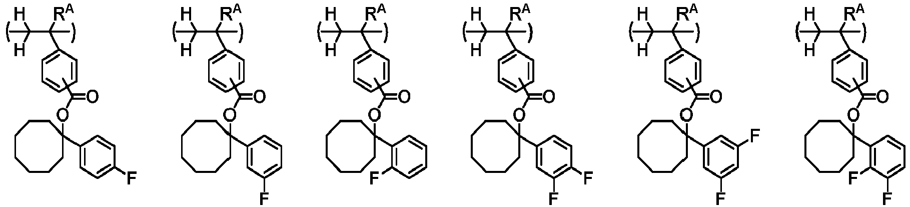

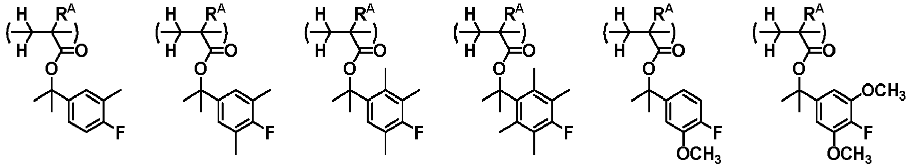

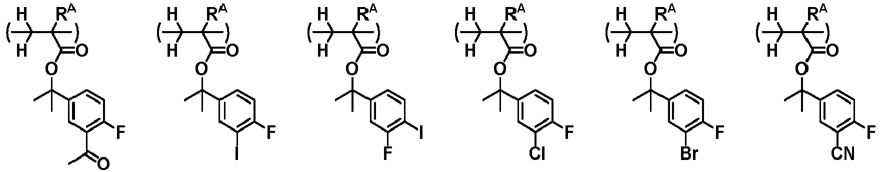

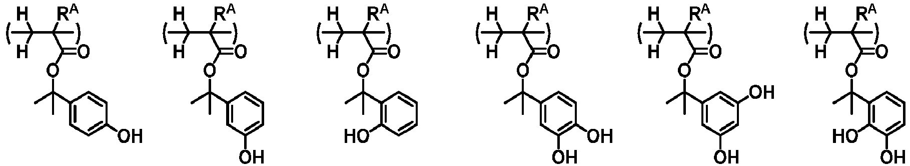

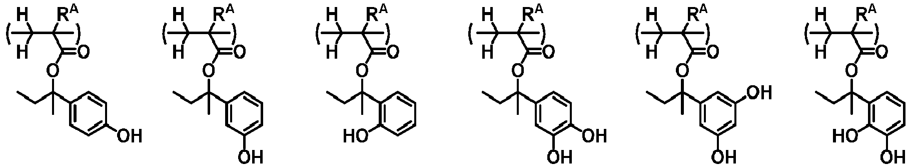

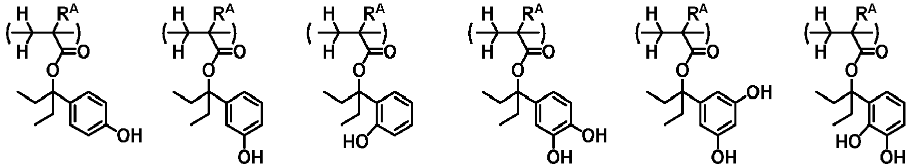

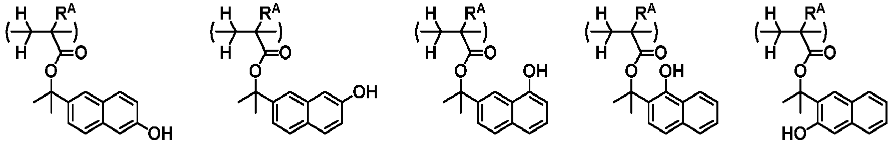

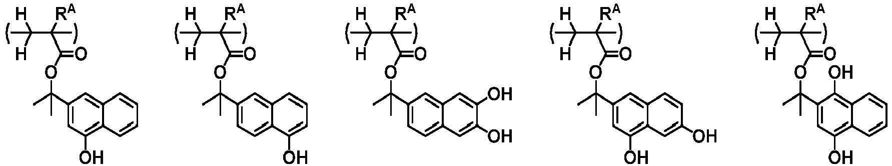

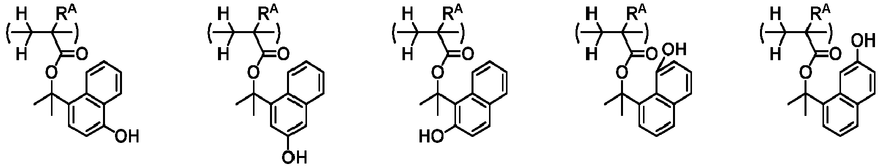

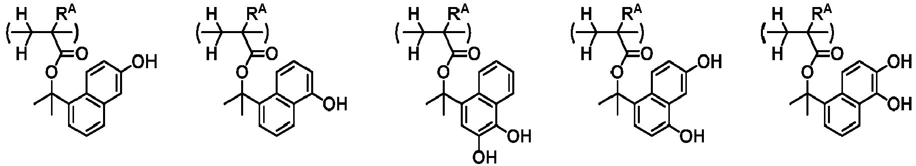

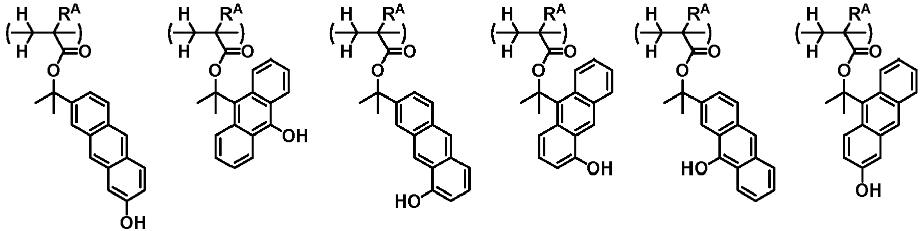

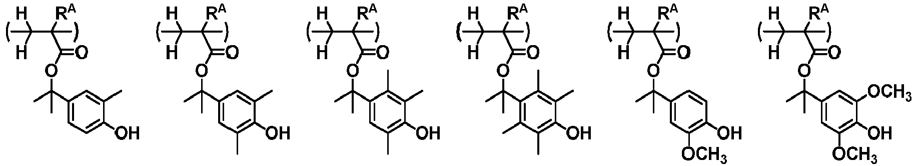

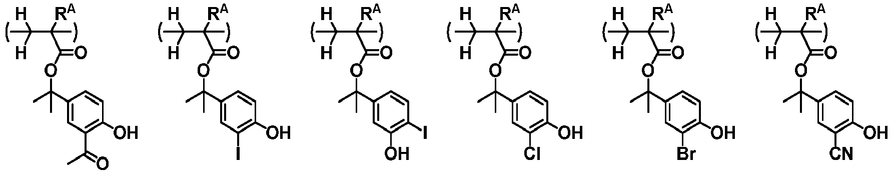

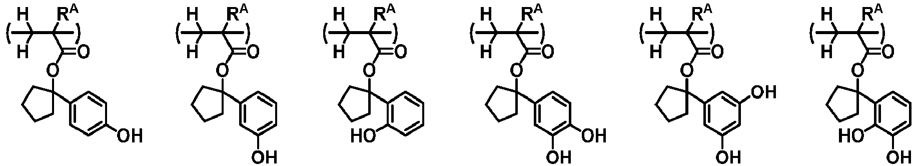

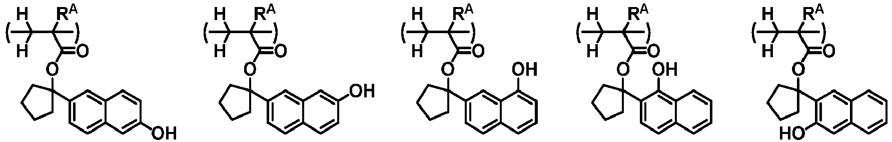

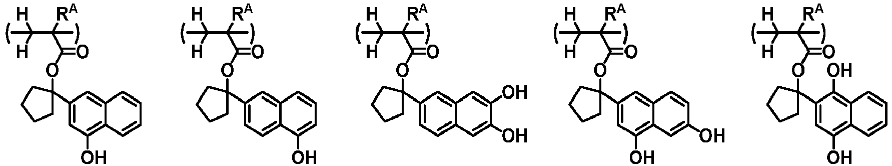

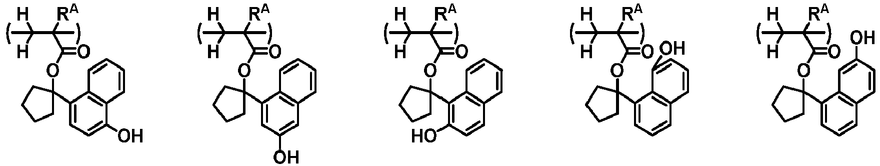

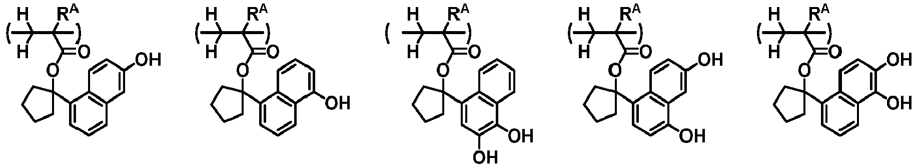

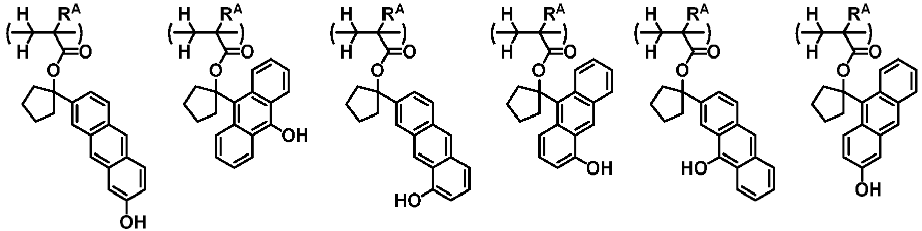

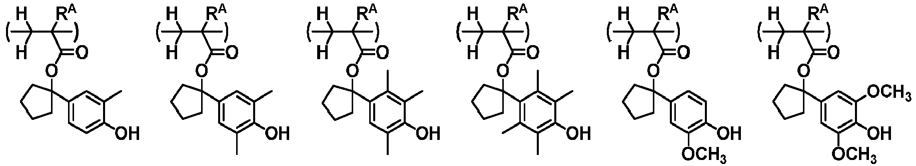

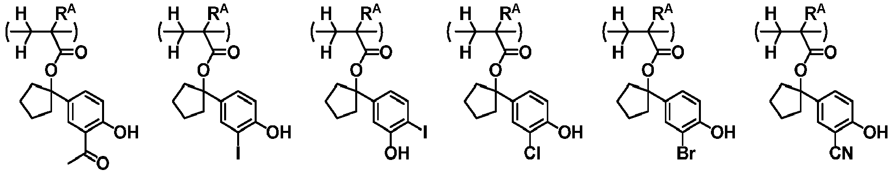

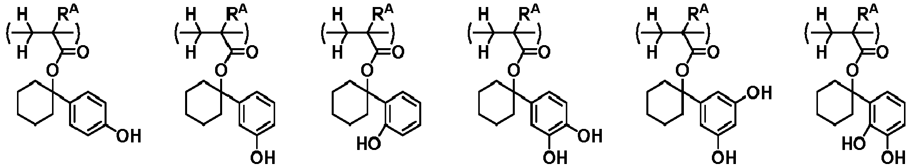

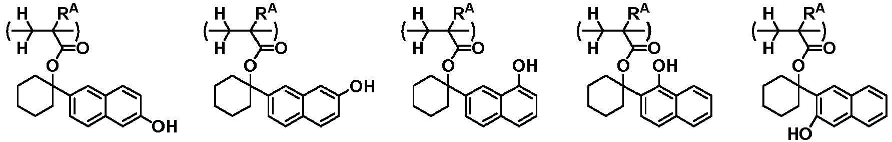

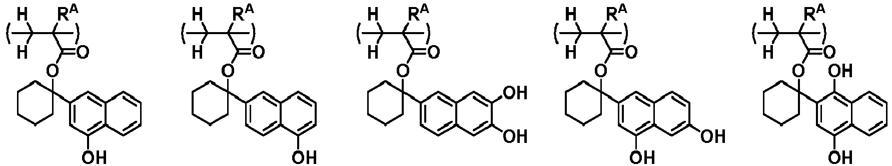

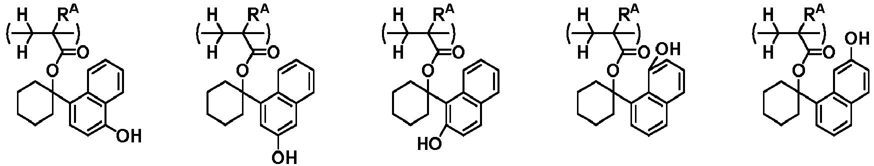

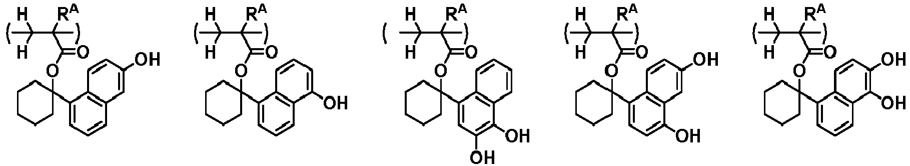

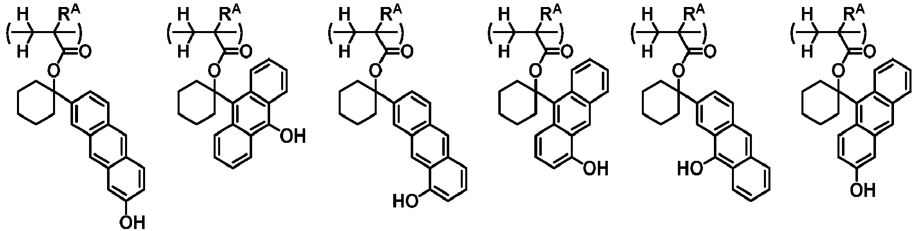

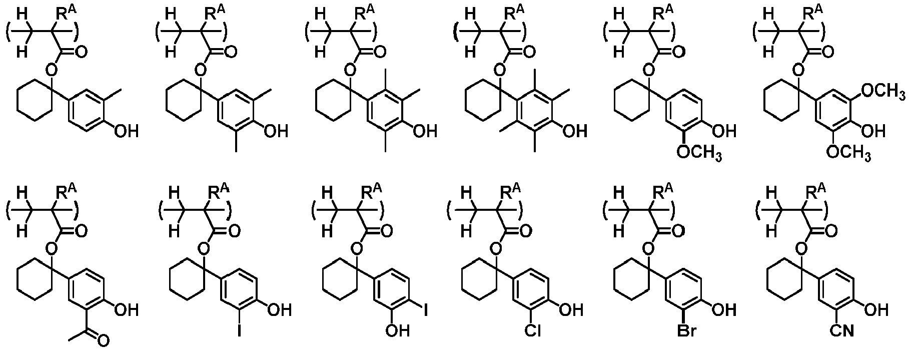

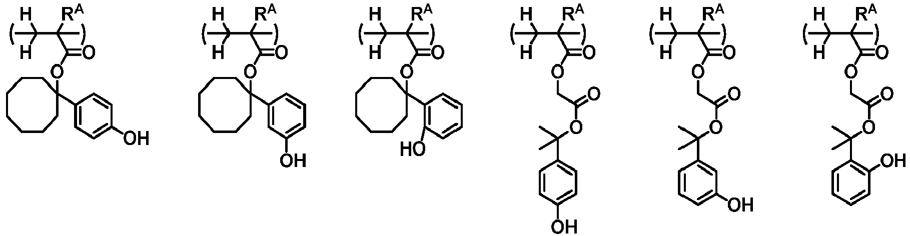

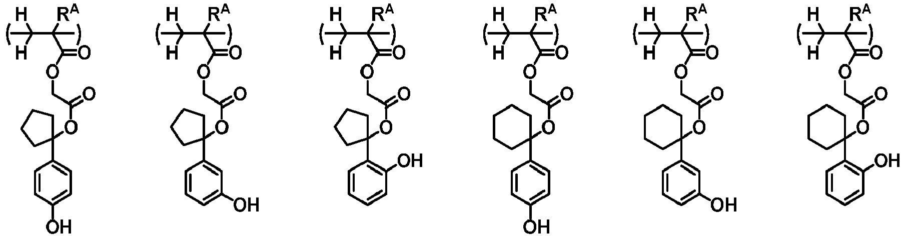

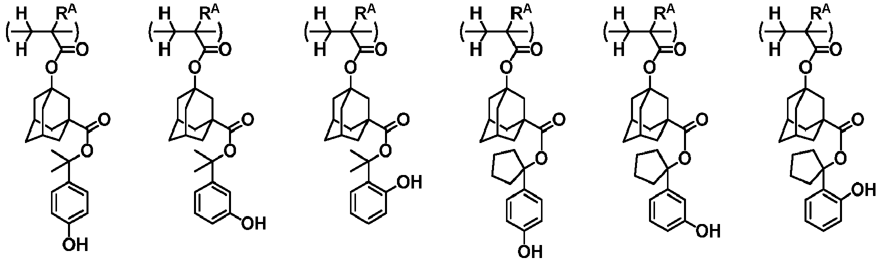

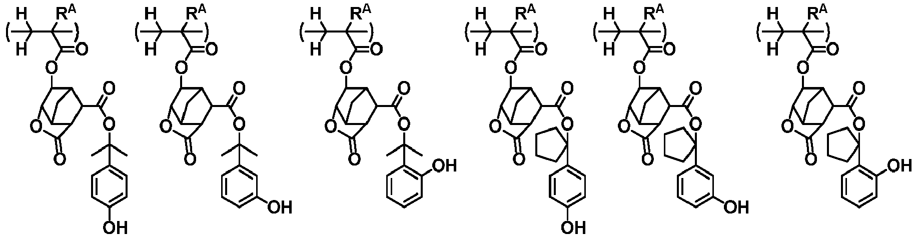

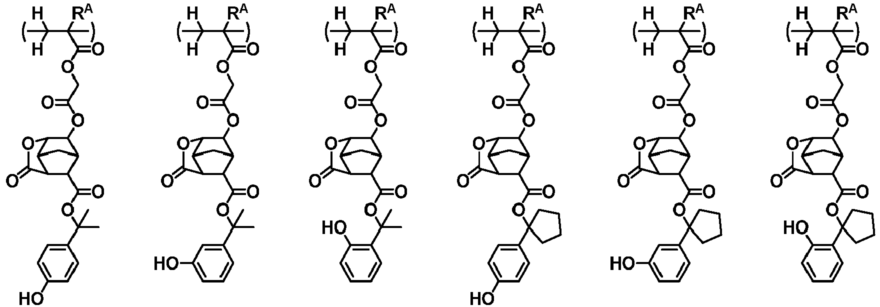

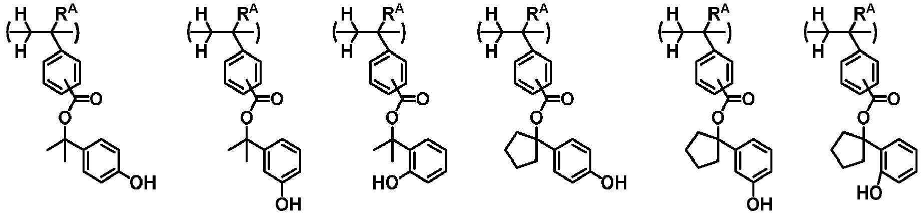

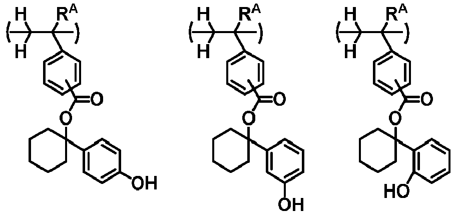

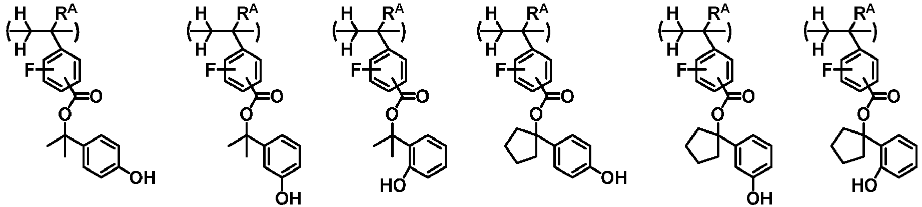

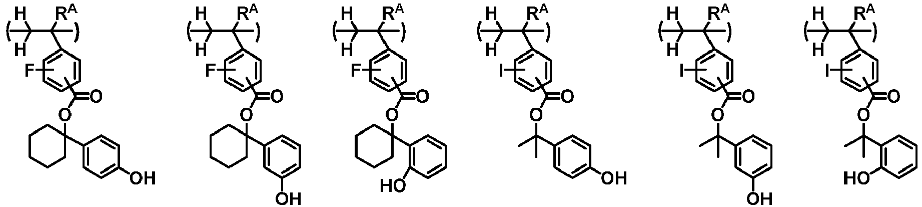

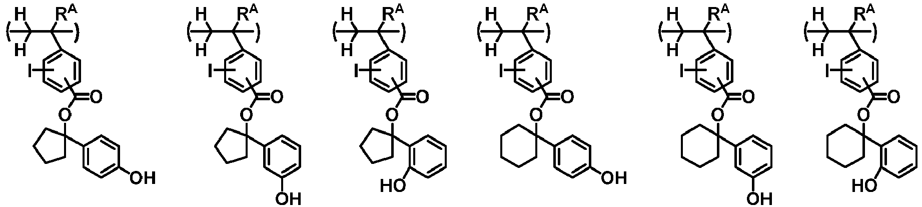

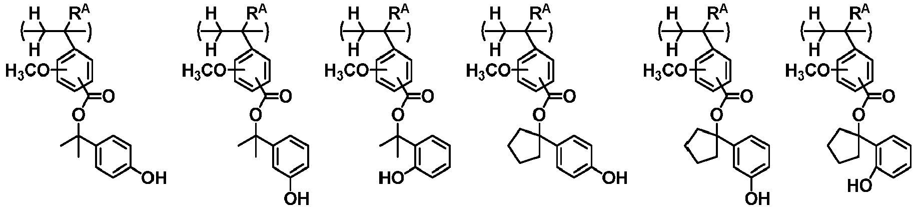

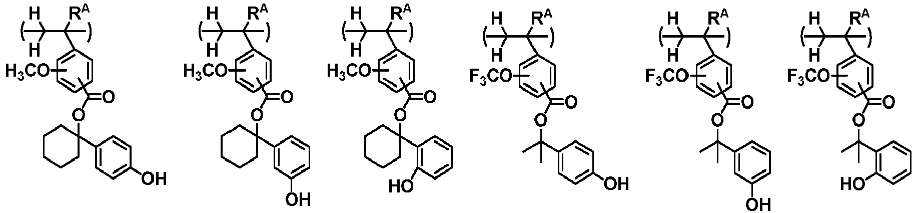

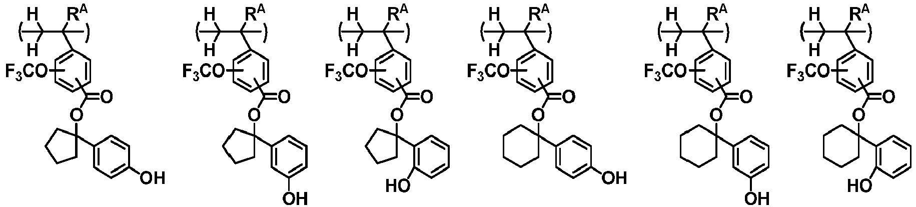

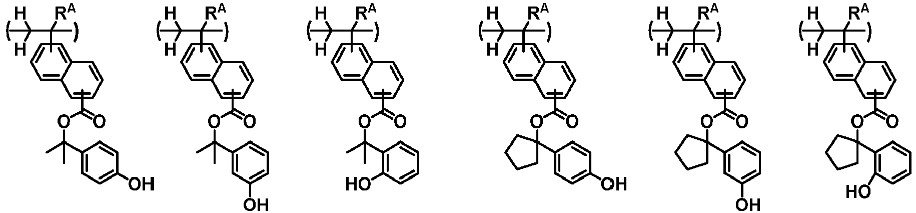

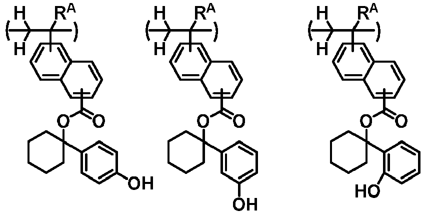

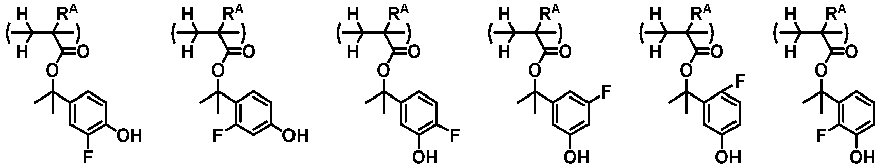

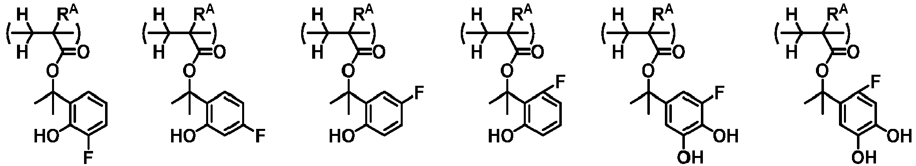

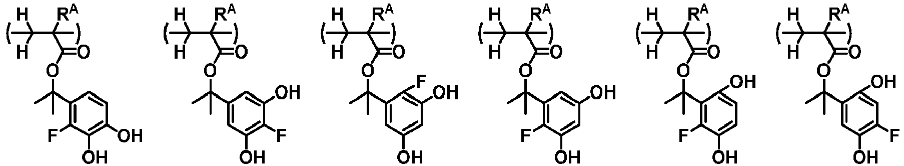

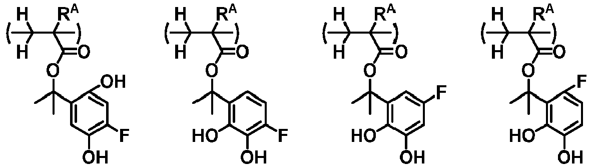

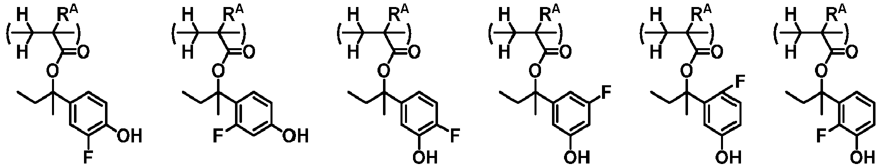

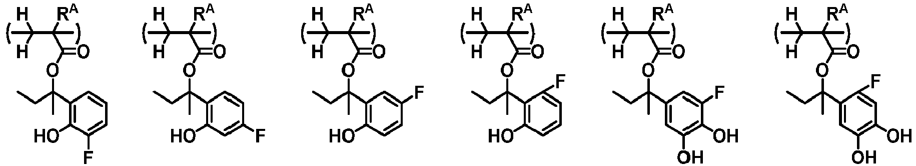

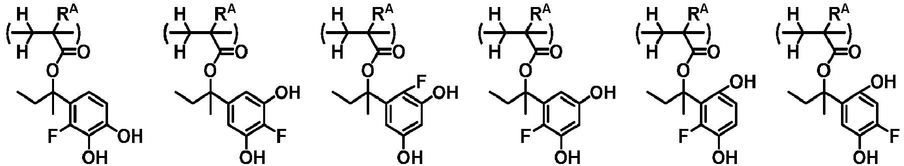

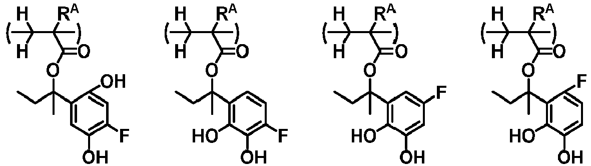

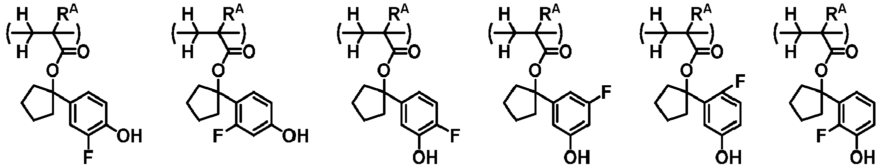

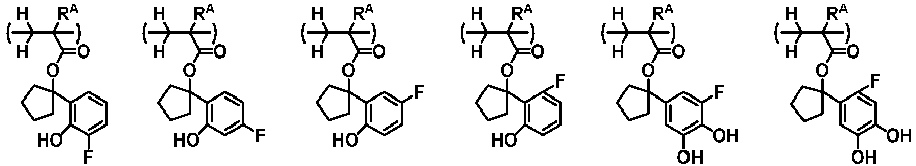

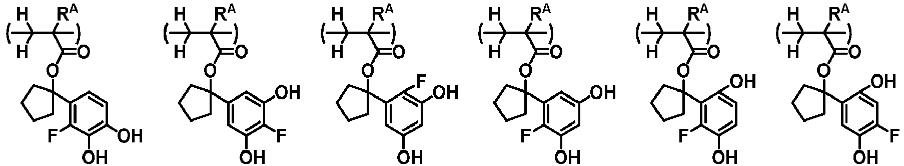

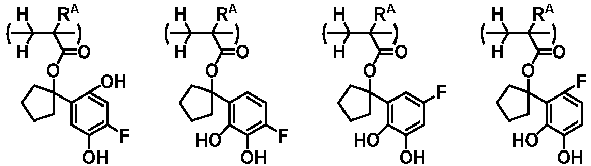

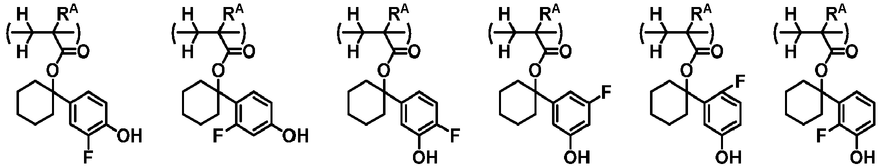

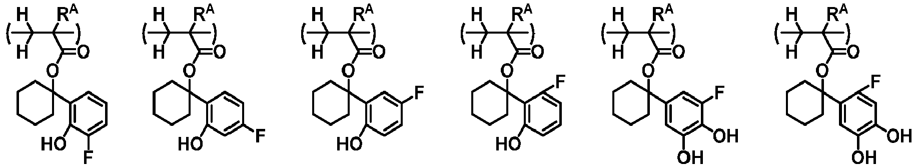

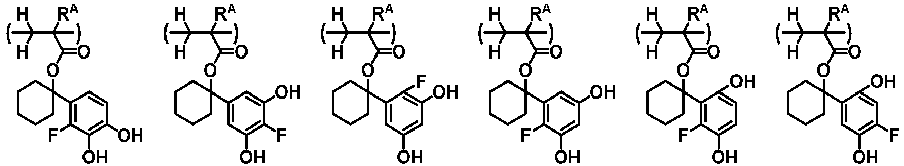

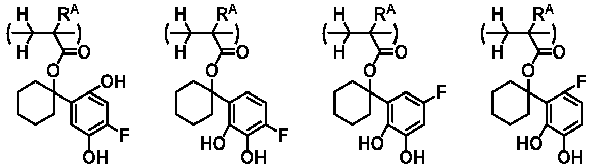

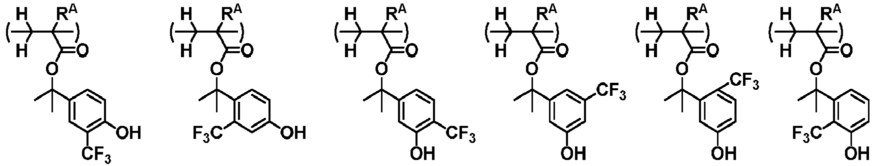

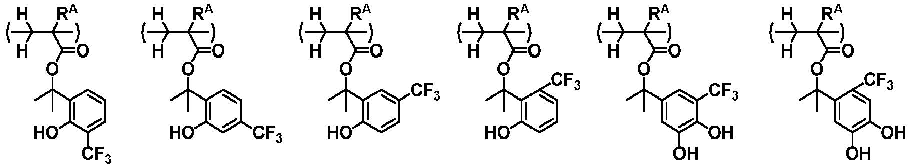

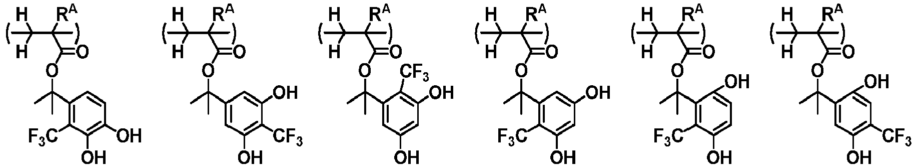

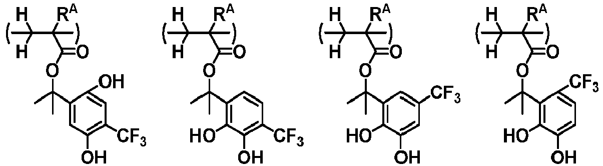

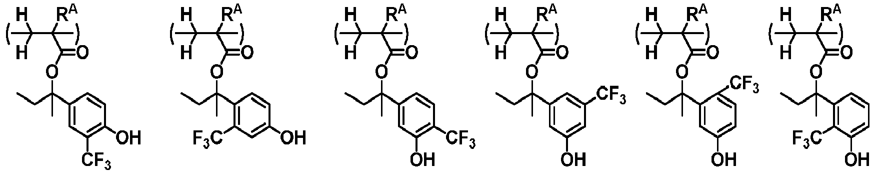

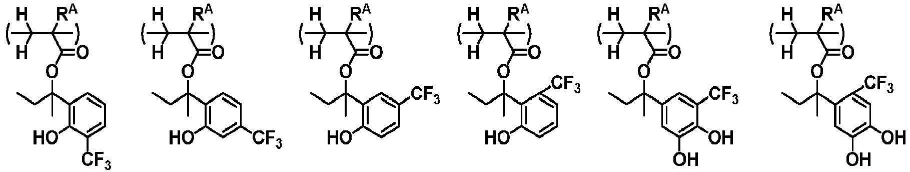

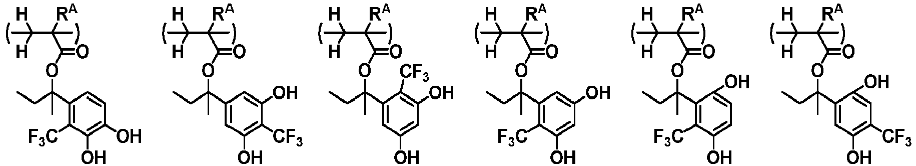

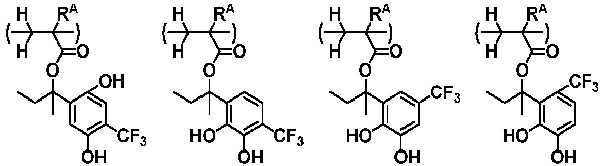

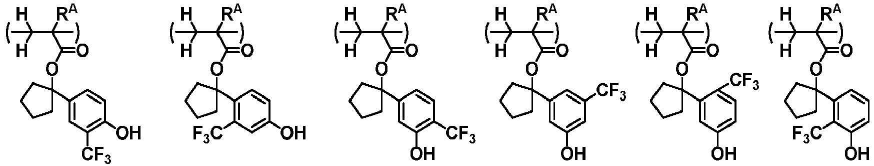

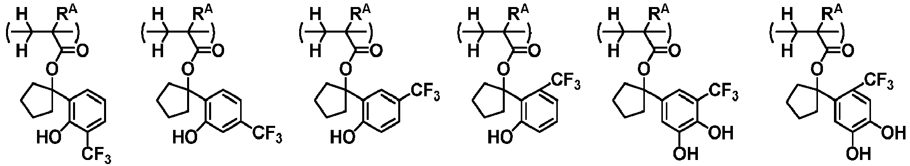

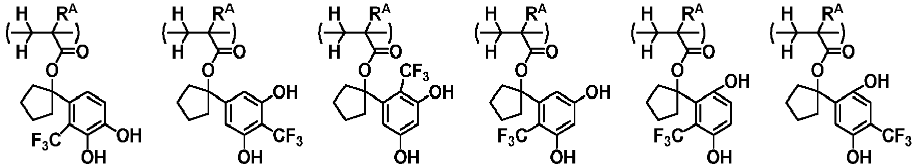

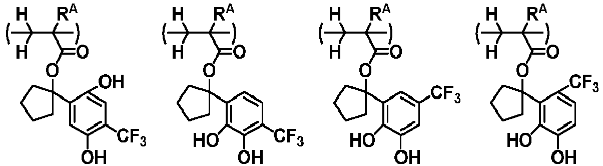

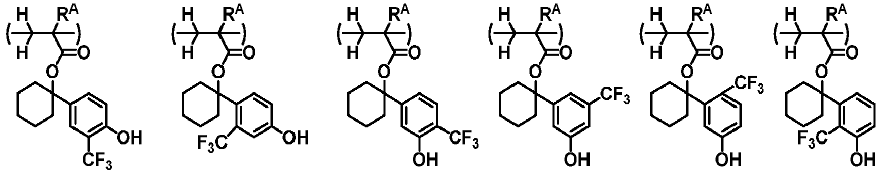

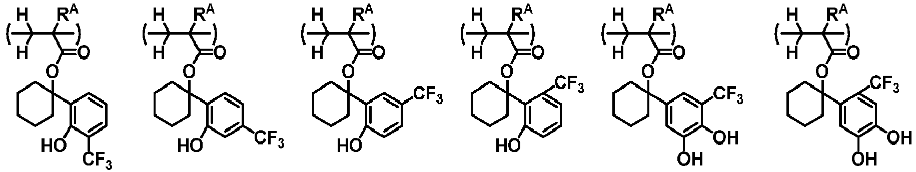

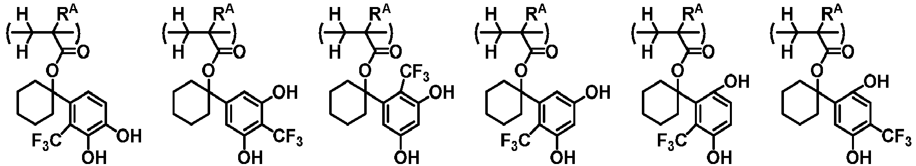

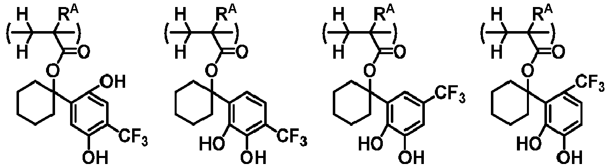

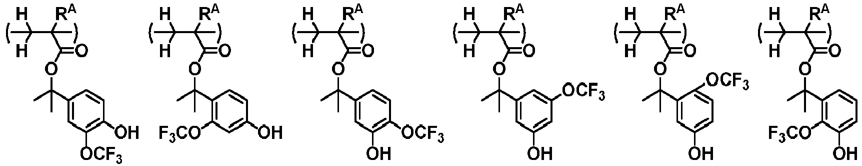

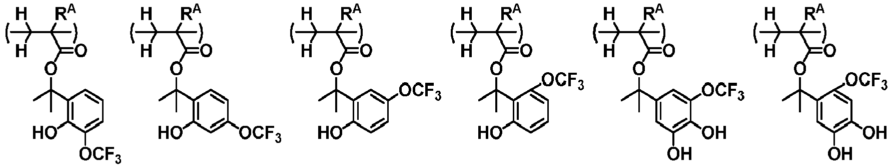

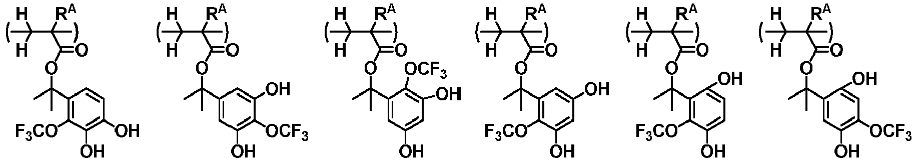

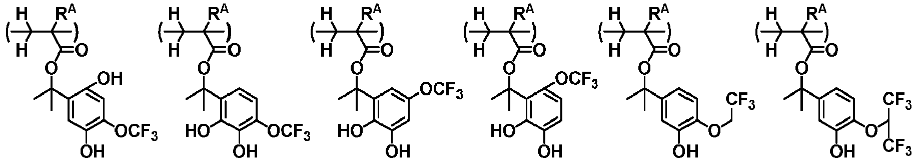

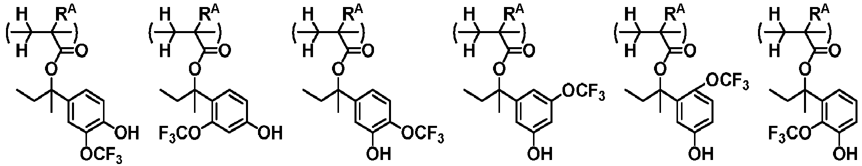

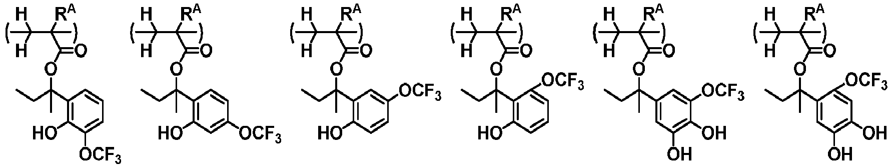

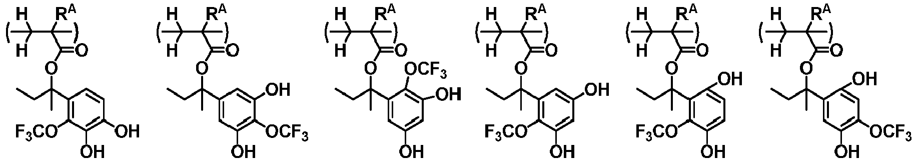

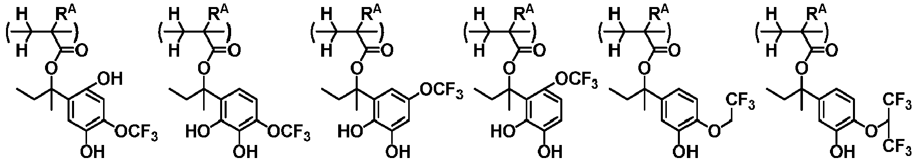

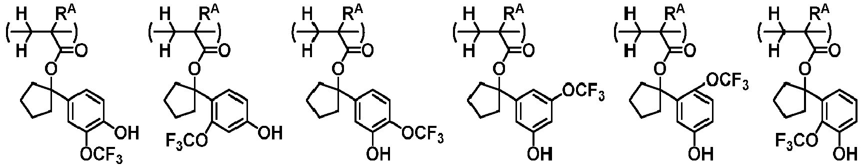

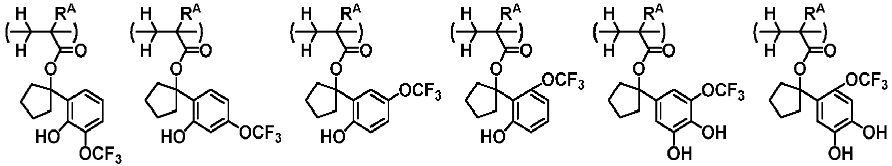

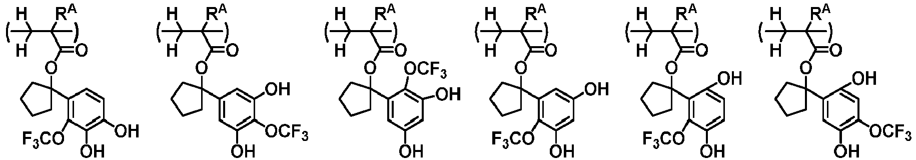

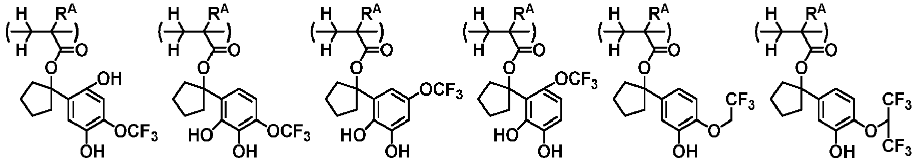

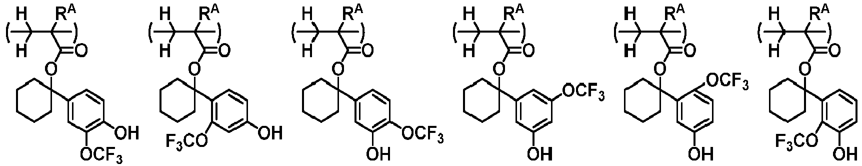

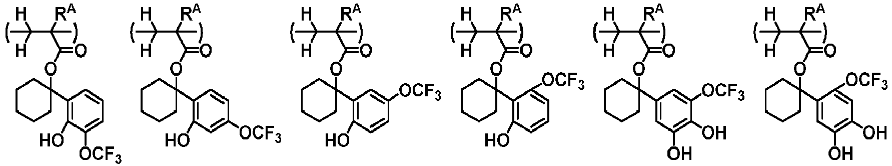

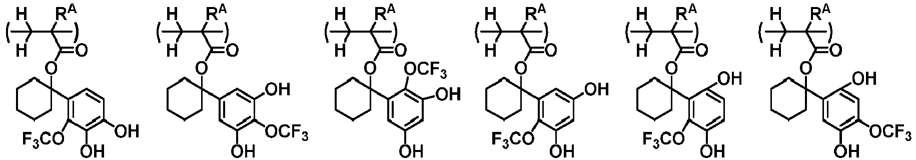

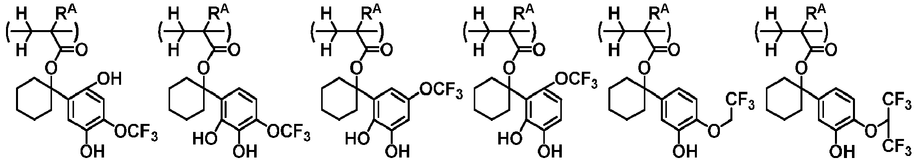

Since the acid labile group in the form of a tertiary hydrocarbyl group having a phenyl group attached to the tertiary carbon atom is extremely low in activation energy for acid-catalyzed deprotection reaction as compared with the acid labile group in the form of tertiary alkyl group, typically tert-butyl, deprotection reaction takes place even at a temperature around 50°C. When a polymer having an acid labile group with extremely low activation energy for deprotection reaction is used as the base polymer, the PEB temperature is too low, suggesting a difficulty to control the temperature uniformity or a difficulty to control the acid diffusion. If the distance of acid diffusion cannot be controlled, the dimensional uniformity or maximum resolution of patterns after development is degraded. An adequate PEB temperature is necessary for acid diffusion control. Most often a temperature in the range of 80 to 110°C is adequate.

Another problem arising from the use of an acid labile group with low-activation energy is possible elimination of the acid labile group during polymerization in the case of a polymer with which a PAG is to be copolymerized. Although the PAG in the form of onium salt is basically neutral, the onium salt can be partially dissociated by the heat during polymerization. When a repeat unit having a phenolic hydroxy group is concurrently copolymerized, an exchange reaction takes place between the proton of the phenolic hydroxy group and the cation of the PAG to generate an acid whereby elimination of the acid labile group can occur. The elimination during polymerization becomes outstanding particularly when a low-activation energy acid labile group is used.

As mentioned above, the acid labile group in the form of a tertiary hydrocarbyl group having a phenyl group attached to the tertiary carbon atom has the advantage of satisfactory etching resistance due to the benzene ring. When a PAG is copolymerized, elimination of the acid labile group occurs during polymerization. When an electron attractive group is attached to a benzene ring, the activation energy for elimination of an acid labile group becomes high. It is believed that this is because the stability of a benzyl cation in a deprotection intermediate is lowered by the electron attractive group. It is possible to attach an electron attractive group to an acid labile group which is readily eliminatable, to hold down the reactivity of deprotection reaction to an optimum level.

When fluorine is introduced into an acid labile group to suppress swell during alkaline development, an improvement in resolution is expected. However, when fluorine is introduced into an acid labile group in the form of a tertiary alkyl group, the stability of intermediate cation during deprotection reaction is largely reduced by the electron attractive effect of fluorine. As a result, creation of olefin does not occur and deprotection reaction does not take place. However, the tertiary acid labile group having a fluorinated aromatic group provides the intermediate cation with optimum stability, shows adequate reactivity for deprotection, and exerts an etch resistance-enhancing effect.

Also, when a hydroxy group is introduced into an acid labile group, the dissolution rate of a resist film in the exposed region is accelerated. This enhances the dissolution contrast, contributing to a resolution improvement and defect reduction.

Since the acid labile group is also effective for controlling the influence of backward scattering during image writing, a pattern of rectangular profile is obtained without the risk of the pattern profile being inversely tapered in a sensitivity region of at least 50 µC, preferably at least 100 µC.

As understood from the foregoing, the specific polymer is used as the base polymer in a positive resist composition, especially chemically amplified positive resist composition, for the purpose of enhancing dissolution contrast and etch resistance while suppressing acid diffusion. There are obtained many advantages including a significantly high contrast of alkaline dissolution rate before and after light exposure, a high acid diffusion-suppressing effect, high resolution, and high pattern fidelity as well as satisfactory profile, reduced LER, improved etch resistance, and low defectiveness of patterns after development.

The repeat units A2 are preferably incorporated in a range of 2 to 50 mol%, more preferably 10 to 40 mol% based on the overall repeat units of the polymer in the base polymer.

Since the polymer is designed to have a carboxy group which is protected with an acid labile group, the dissolution rate of exposed region is improved due to the carboxylate framework. Then, the dissolution contrast between exposed and unexposed regions is optimized while maintaining a satisfactory resolution in the exposed region. As a consequence, a pattern with a minimal size difference is obtained independent of pattern density while suppressing the influence of develop loading. In the fabrication of masks wherein the development conditions employed therein are stronger than in the processing of wafer substrates, it is required to form a pattern with a minimal size difference while maintaining a satisfactory resolution and suppressing the influence of develop loading. Then the mask blank and chemically amplified positive resist composition of the invention are best suited for the processing of mask substrates.

In a preferred embodiment, the polymer in the base polymer further comprises repeat units of at least one type selected from repeat units having the formula (B 1), repeat units having the formula (B2), and repeat units having the formula (B3), which are also referred to as repeat units B 1, B2 and B3, respectively.

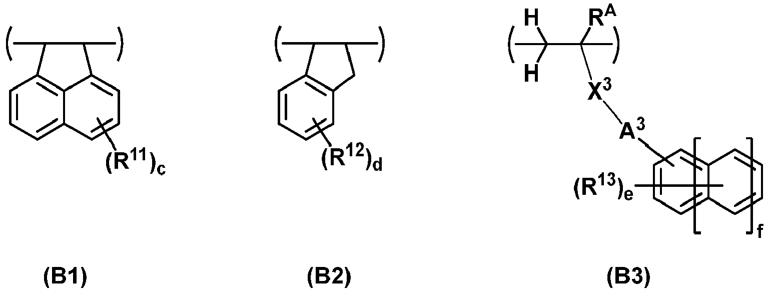

In formulae (B 1) and (B2), c and d are each independently an integer of 0 to 4.

In formulae (B 1) and (B2), R¹¹ and R¹² are each independently a hydroxy group, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group. The saturated hydrocarbyl group, saturated hydrocarbyloxy group and saturated hydrocarbylcarbonyloxy group may be straight, branched or cyclic. Groups R¹¹ may be identical or different when c is 2 or more. Groups R¹² may be identical or different when d is 2 or more.

In formula (B3), R^{A} is as defined above, e is an integer of 0 to 5, and f is an integer of 0 to 2.

In formula (B3), R¹³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group. R¹³ may also be hydroxy when f is 1 or 2. The saturated hydrocarbyl group, saturated hydrocarbyloxy group, saturated hydrocarbylcarbonyloxy group, saturated hydrocarbyloxyhydrocarbyl group and saturated hydrocarbylthiohydrocarbyl group may be straight, branched or cyclic. Groups R¹³ may be identical or different when e is 2 or more.

In formula (B3), X³ is a single bond, *-C(=O)-O- or *-C(=O)-NH-. The asterisk (*) designates a point of attachment to the carbon atom in the backbone.

In formula (B3), A³ is a single bond or a C₁-C₁₀ saturated hydrocarbylene group in which some constituent -CH₂- may be replaced by -O-. The saturated hydrocarbylene group may be straight, branched or cyclic and examples thereof are as exemplified for A¹ in formula (A1).

When repeat units of at least one type selected from repeat units B 1 to B3 are incorporated, better performance is obtained because not only the aromatic ring possesses etch resistance, but the cyclic structure incorporated into the main chain also exerts the effect of improving resistance to etching and EB irradiation during pattern inspection step.

The repeat units B 1 to B3 are preferably incorporated in a range of at least 5 mol% based on the overall repeat units of the polymer in the base polymer for obtaining the effect of improving etch resistance. Also, the repeat units B 1 to B3 are preferably incorporated in a range of up to 30 mol%, more preferably up to 25 mol% based on the overall repeat units of the polymer in the base polymer. When the relevant units are free of functional groups or have a functional group other than hydroxy, their content of up to 30 mol% is preferred because the risk of forming development defects is eliminated. Each of the repeat units B 1 to B3 may be of one type or a combination of plural types.

The total content of repeat units A1 and repeat units of at least one type selected from repeat units B1 to B3 is preferably at least 50 mol%, more preferably at least 60 mol%, even more preferably at least 65 mol% based on the overall repeat units of the polymer in the base polymer.

The polymer in the base polymer may further comprise repeat units of at least one type selected from repeat units having the formulae (C 1) to (C8).

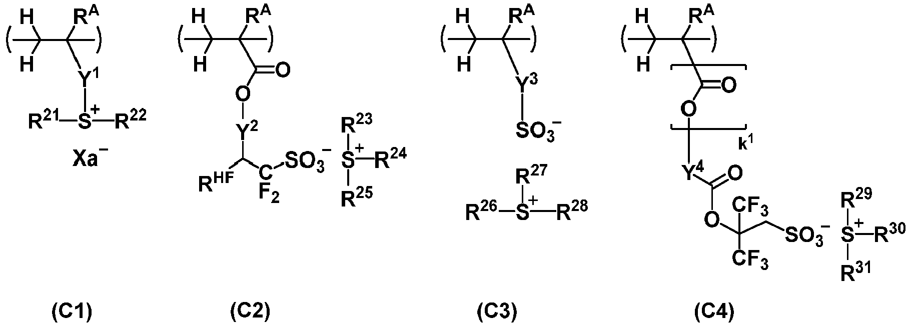

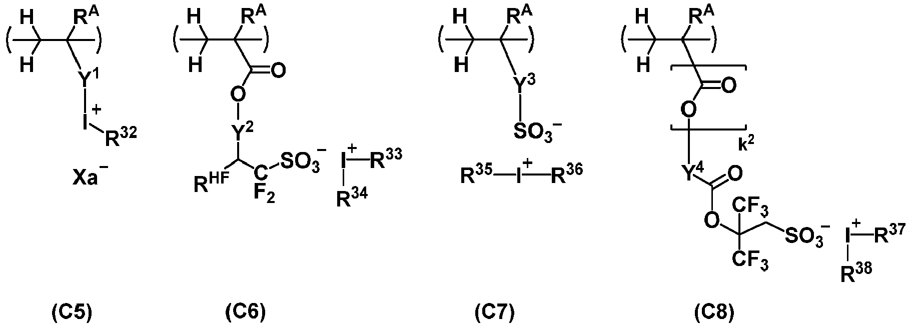

In formulae (C1) to (C8), R^{A} is as defined above. Y¹ is a single bond, a C₁-C₆ aliphatic hydrocarbylene group, phenylene group, naphthylene group or C₇-C₁₈ group obtained by combining the foregoing, ^{∗}-O-Y¹¹-, ^{∗}-C(=O)-O-Y¹¹-, or ^{∗}-C(=O)-NH-Y¹-. Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety. Y² is a single bond or ^{∗∗}-Y²¹-C(=O)-O-. Y²¹ is a C₁-C₂₀ hydrocarbylene group which may contain a heteroatom. Y³ is a single bond, methylene, ethylene, phenylene, fluorinated phenylene, trifluoromethyl-substituted phenylene, ^{∗}-O-Y³¹-, ^{∗}-C(=O)-O-Y³¹-, or ^{∗}-C(=O)-NH-Y³¹-. Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety. The asterisk (*) designates a point of attachment to the carbon atom in the backbone, and the double asterisk (**) designates a point of attachment to the oxygen atom in the formula. Y⁴ is a single bond or C₁-C₃₀ hydrocarbylene group which may contain a heteroatom. The subscripts k¹ and k² are each independently 0 or 1, k¹ and k² are 0 when Y⁴ is a single bond.

The repeat unit having formula (C4) or (C8) is a unit which generates an acid upon exposure to high-energy radiation, the acid having a sulfonyl group and being difluoromethylated at β-position thereof. The acid has an acid strength adequate for the deprotection of a polymer comprising repeat units A2. When a polymer comprising repeat units having formula (C4) or (C8) is used as a base polymer in a resist composition, it is possible to properly control the movement and diffusion of the generated acid.

A photoacid generator capable of generating an arene sulfonic acid upon exposure to high-energy radiation is also commonly used for the deprotection of a polymer comprising units protected with an acetal, tertiary alkyl or tert-butoxycarbonyl group. However, when an arene sulfonic acid-generating unit is introduced as the repeat unit in a base polymer with the intention of attaining the same effect as in the present invention, the resulting base polymer is not always dissolvable in a solvent because of low solvent solubility. In contrast, the polymer comprising repeat units having formula (C4) or (C8) is fully lipophilic and easy to prepare and handle, and a resist composition is readily prepared therefrom.

In formulae (C2) and (C6), Y² is a single bond or -Y²¹-C(=O)-O- wherein Y²¹ is a C₁-C₂₀ hydrocarbylene group which may contain a heteroatom. Examples of the hydrocarbylene group Y²¹ are given below, but not limited thereto.

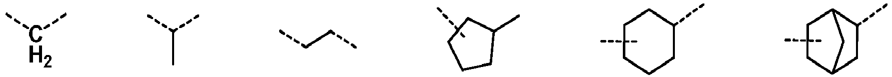

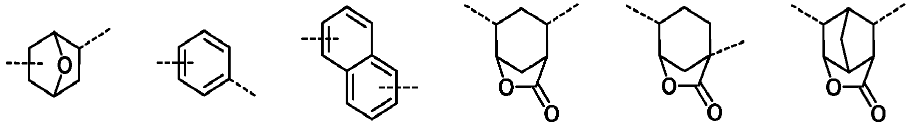

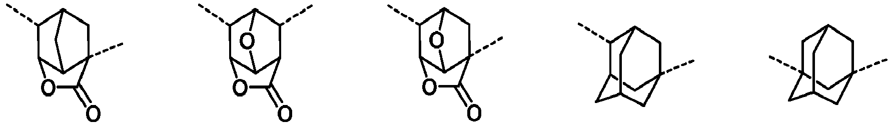

In formulae (C2) and (C6), R^{HF} is hydrogen or trifluoromethyl. Examples of the repeat units C2 and C6 wherein R^{HF} is hydrogen are as exemplified in USP 8,105,748 (JP-A 2010-116550). Examples of the repeat units A2 and A6 wherein R^{HF} is trifluoromethyl are as exemplified in USP 8,057,985 (JP-A 2010-077404). Examples of the repeat units C3 and C7 are as exemplified in USP 8,835,097 (JP-A 2012-246265) and USP 8,900,793 (JP-A 2012-246426).

In formulae (C1) and (C5), Xa⁻ is a non-nucleophilic counter ion. Examples of the non-nucleophilic counter ion Xa⁻ are as exemplified in USP 8,349,533 (JP-A 2010-113209) and USP 7,511,169 (JP-A 2007-145797).

In formulae (C4) and (C8), Y⁴ is a single bond or C₁-C₃₀ hydrocarbylene group which may contain a heteroatom. The hydrocarbylene group may be saturated or unsaturated and straight, branched or cyclic. Examples thereof include alkanediyl groups such as methanediyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, dodecane-1,12-diyl, tridecane-1,13-diyl, tetradecane-1,14-diyl, pentadecane-1,15-diyl, hexadecane-1,16-diyl, and heptadecane-1,17-diyl; cyclic saturated hydrocarbylene groups such as cyclopentanediyl, cyclohexanediyl, norbornanediyl, and adamantanediyl; arylene groups such as phenylene, methylphenylene, ethylphenylene, n-propylphenylene, isopropylphenylene, n-butylphenylene, isobutylphenylene, sec-butylphenylene, tert-butylphenylene, naphthylene, methylnaphthylene, ethylnaphthylene, n-propylnaphthylene, isopropylnaphthylene, n-butylnaphthylene, isobutylnaphthylene, sec-butylnaphthylene, and tert-butylnaphthylene; and combinations thereof.

In the hydrocarbylene group, some or all of the hydrogen atoms may be substituted by a moiety containing a heteroatom such as oxygen, sulfur, nitrogen or halogen and some constituent -CH₂- may be replaced by a moiety containing a heteroatom such as oxygen, sulfur or nitrogen, so that the group may contain a hydroxy moiety, cyano moiety, fluorine, chlorine, bromine, iodine, carbonyl moiety, ether bond, ester bond, sulfonic ester bond, carbonate bond, lactone ring, sultone ring, carboxylic anhydride (-C(=O)-O-C(=O)-), or haloalkyl moiety.

Preferred examples of the anion in the monomer from which repeat units C4 and C8 are derived are shown below, but not limited thereto.

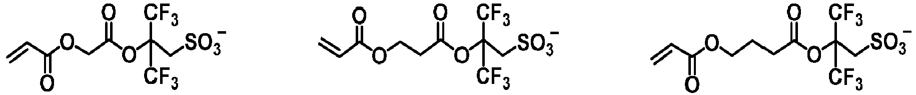

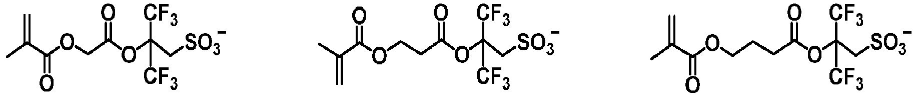

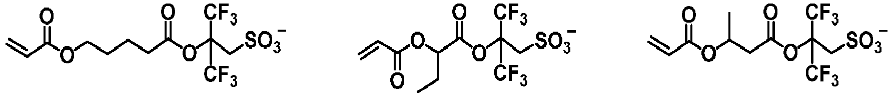

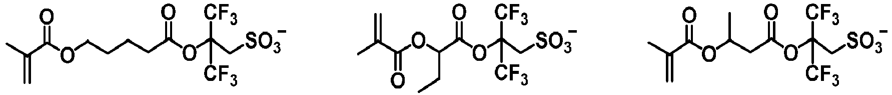

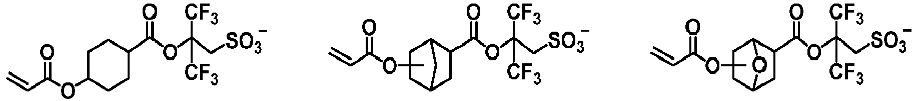

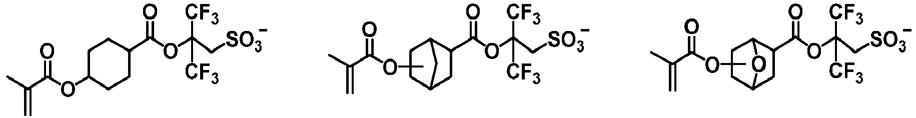

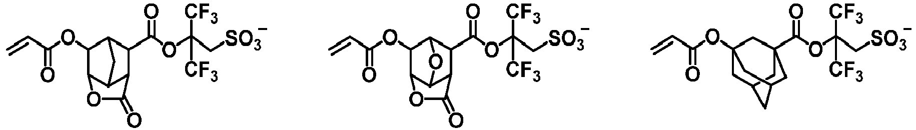

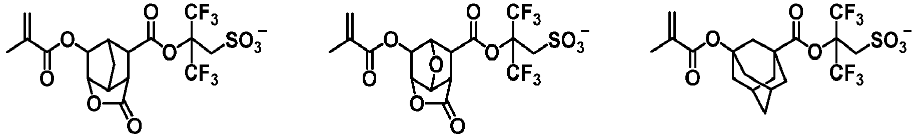

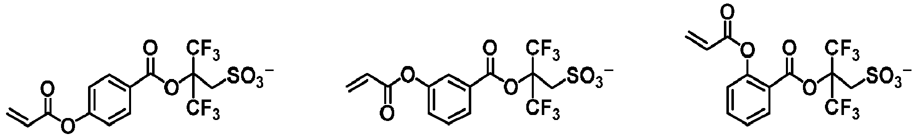

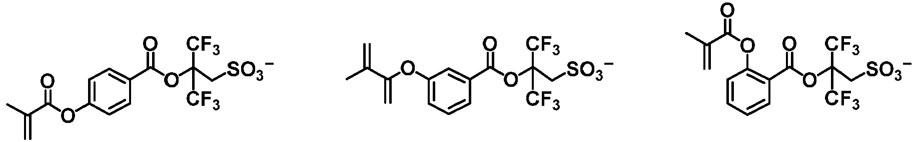

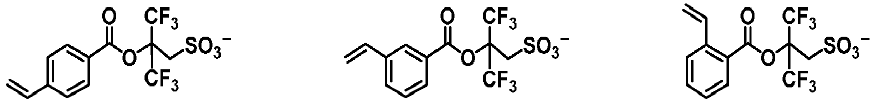

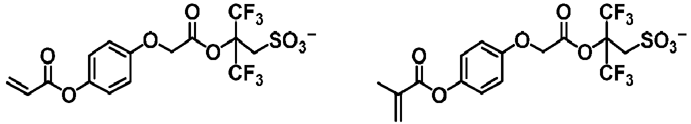

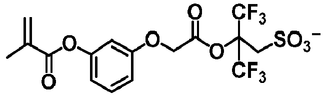

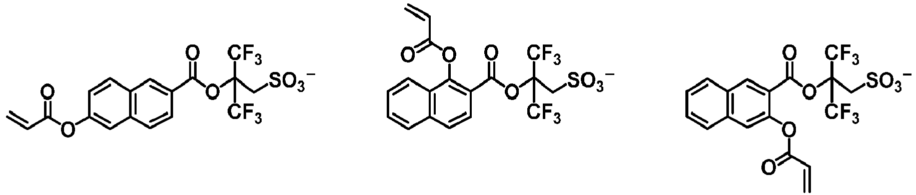

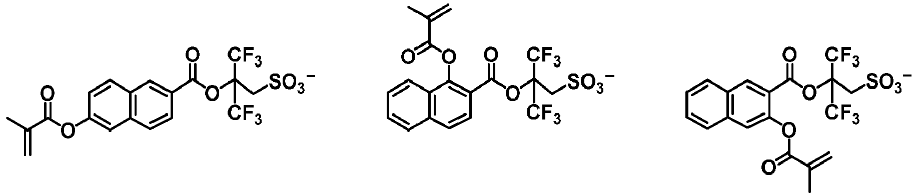

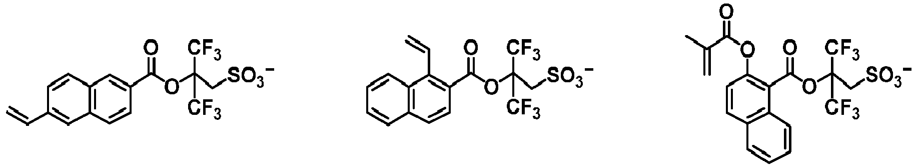

In formulae (C1) to (C8), R²¹ to R³⁸ are each independently halogen or a C₁-C₂₀ hydrocarbyl group which may contain a heteroatom.

Suitable halogen atoms include fluorine, chlorine, bromine and iodine.

The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, sec-butyl, tert-butyl, tert-pentyl, n-pentyl, n-hexyl, n-octyl, 2-ethylhexyl, n-nonyl and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; and C₆-C₂₀ aryl groups such as phenyl, naphthyl and anthracenyl. In the hydrocarbyl groups, some or all of the hydrogen atoms may be substituted by a moiety containing a heteroatom such as oxygen, sulfur, nitrogen or halogen, and a moiety containing a heteroatom such as oxygen, sulfur or nitrogen may intervene in a carbon-carbon bond, so that the group may contain a hydroxy, fluorine, chlorine, bromine, iodine, cyano, carbonyl, ether bond, ester bond, sulfonic ester bond, carbonate bond, lactone ring, sultone ring, carboxylic anhydride (-C(=O)-O-C(=O)-) or haloalkyl.

Also, R²¹ and R²² may bond together to form a ring with the sulfur atom to which they are attached. R²³ and R²⁴, R²⁶ and R²⁷, or R²⁹ and R³⁰ may bond together to form a ring with the sulfur atom to which they are attached. Examples of the ring are shown below.

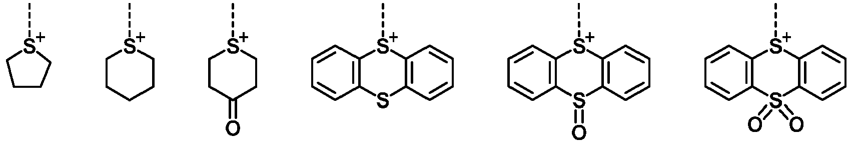

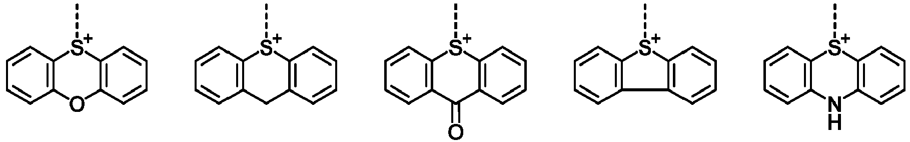

Exemplary structures of the sulfonium cation in formulae (C2) to (C4) are shown below, but not limited thereto.

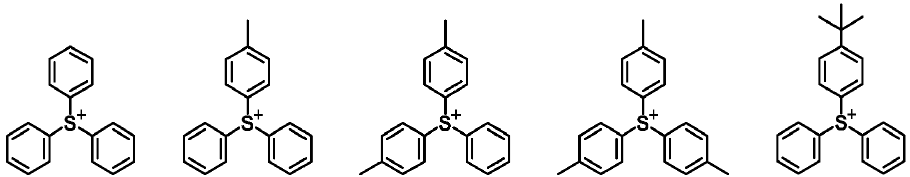

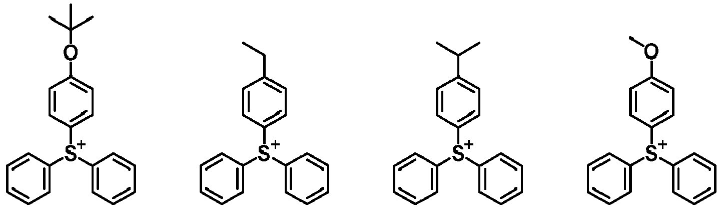

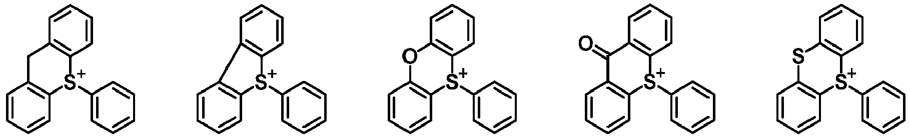

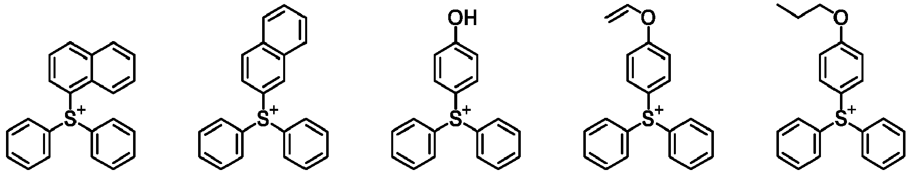

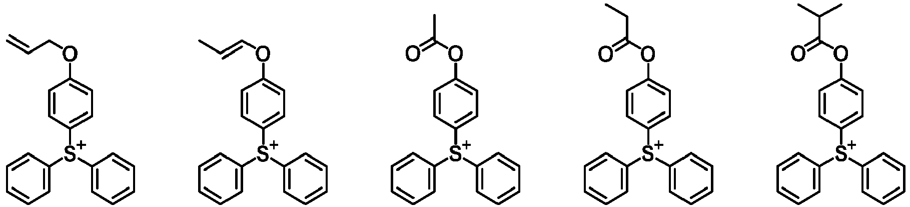

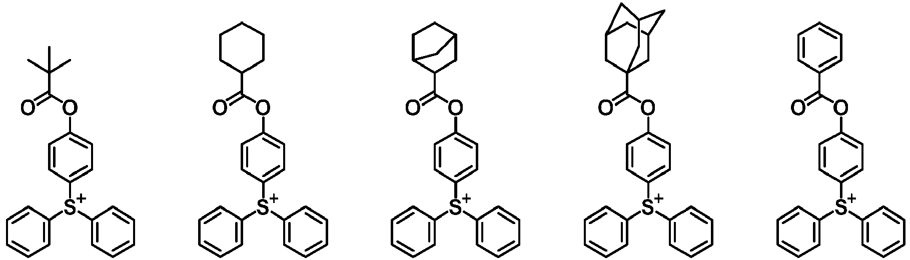

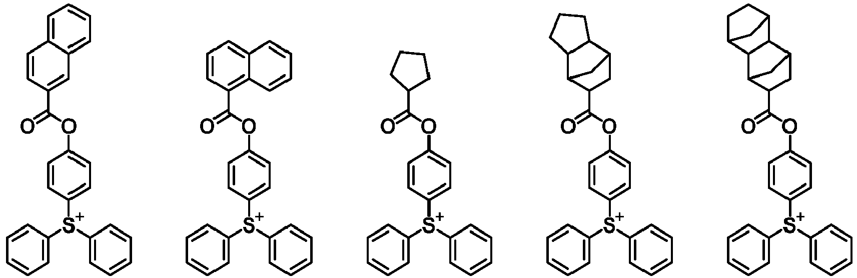

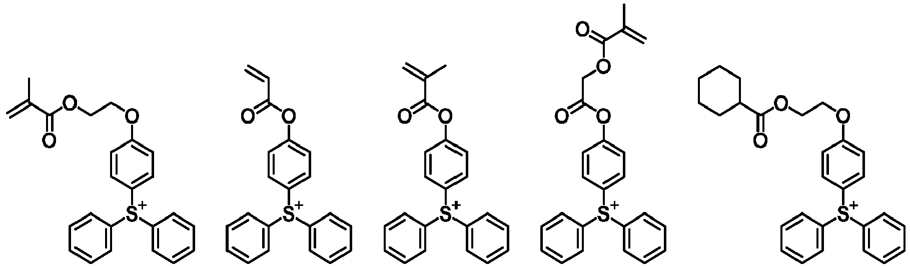

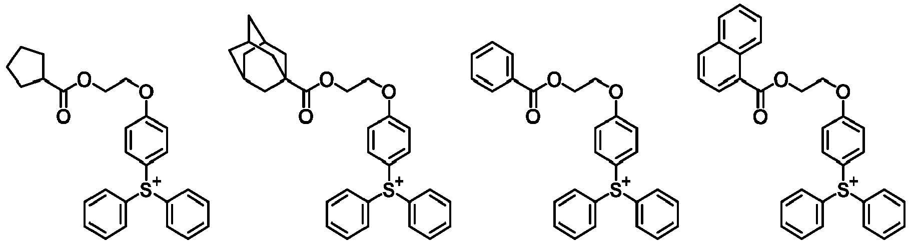

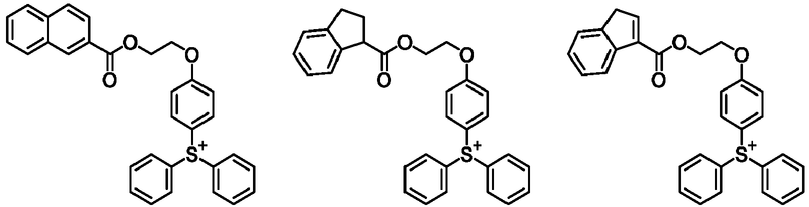

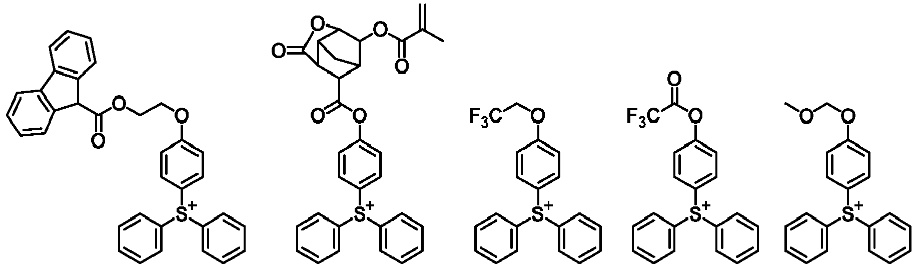

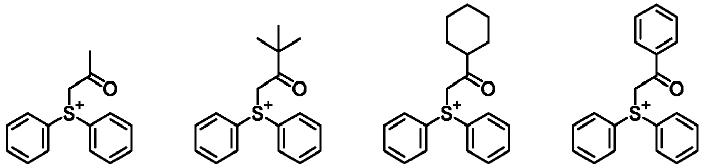

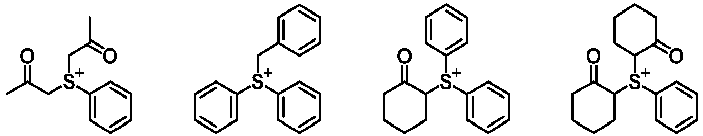

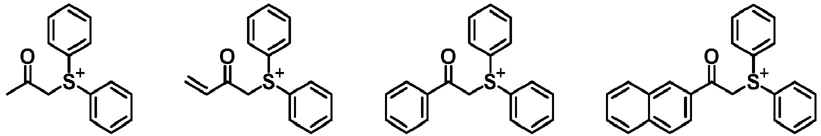

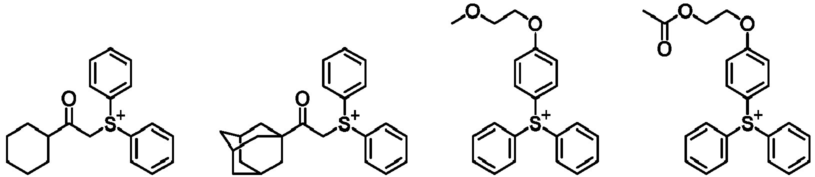

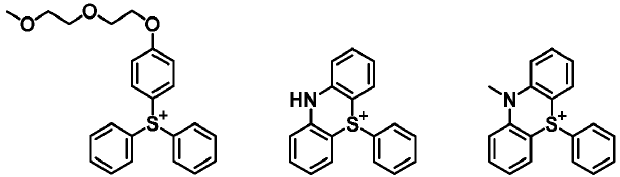

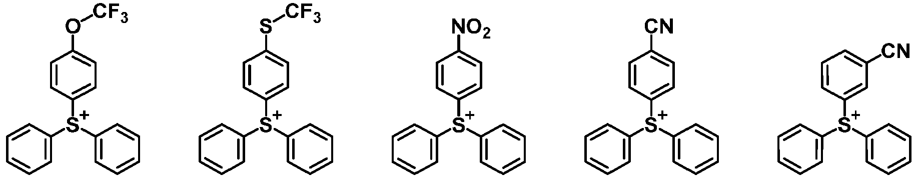

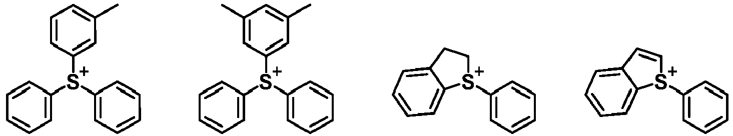

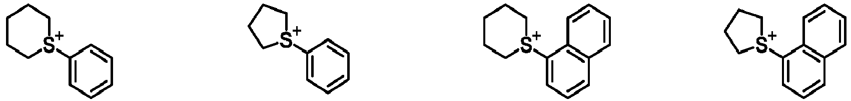

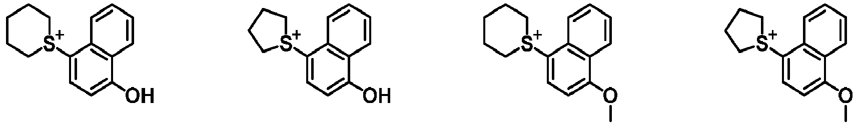

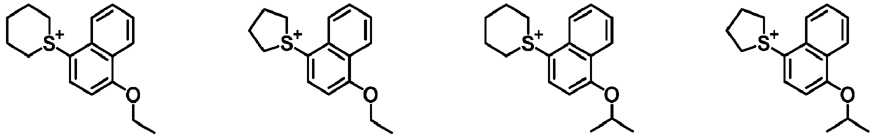

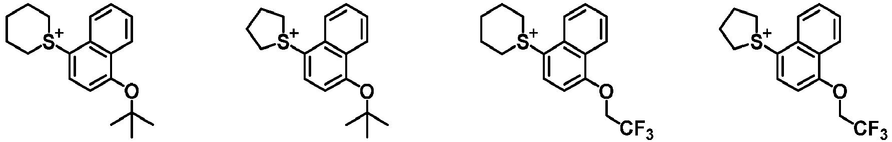

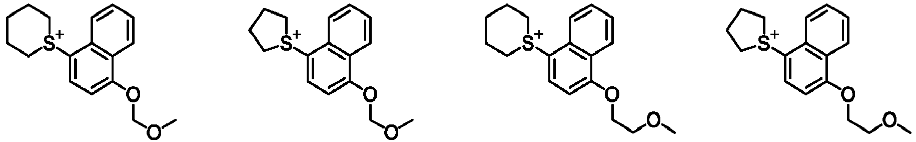

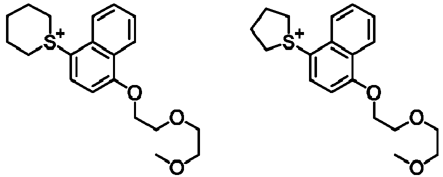

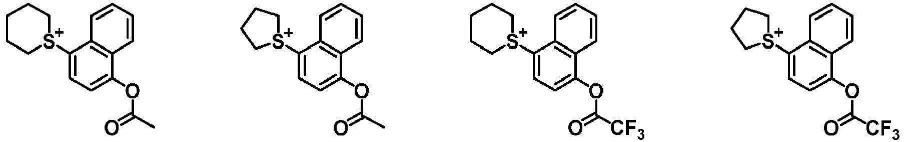

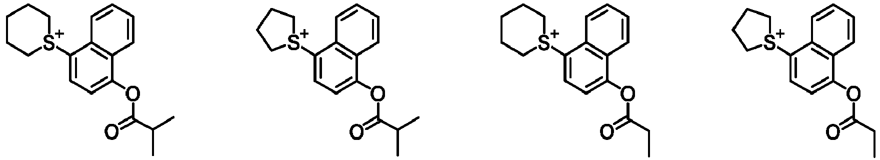

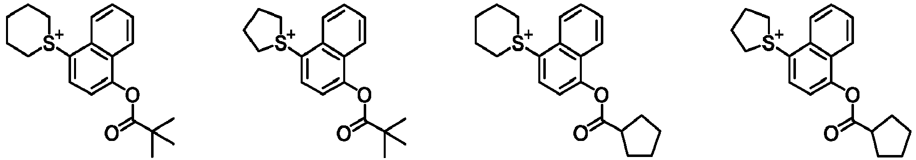

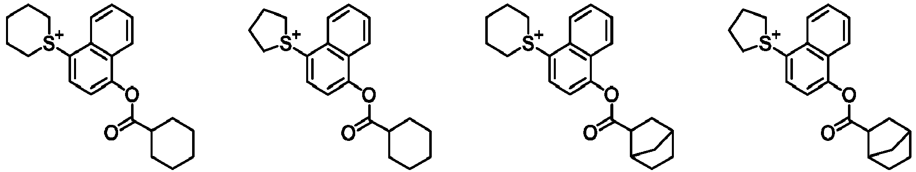

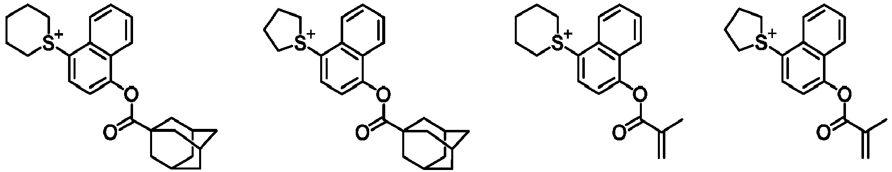

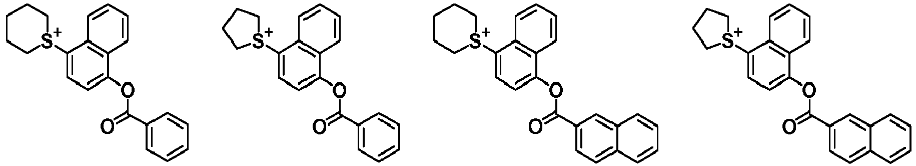

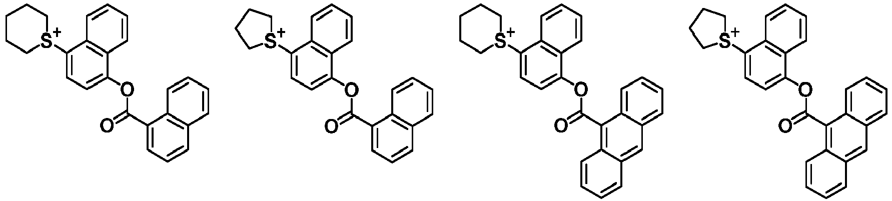

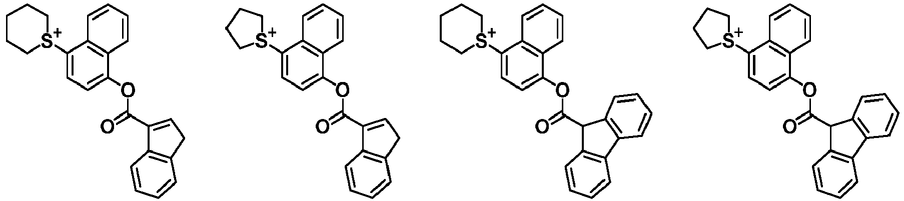

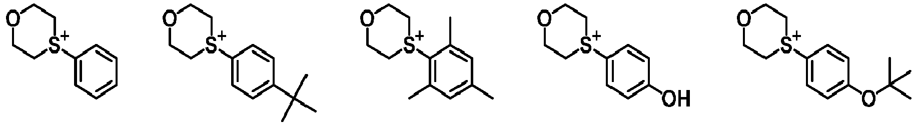

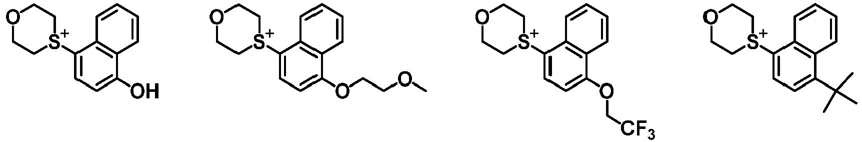

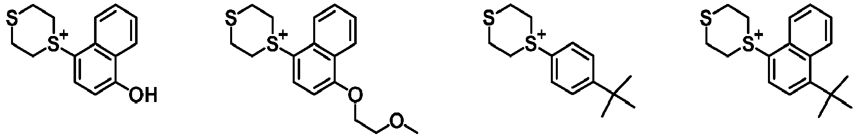

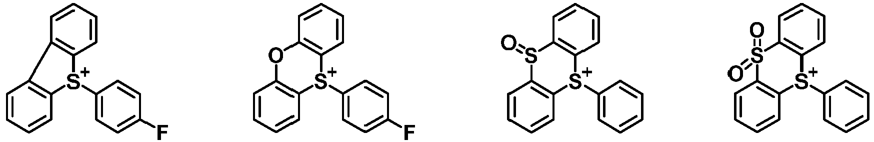

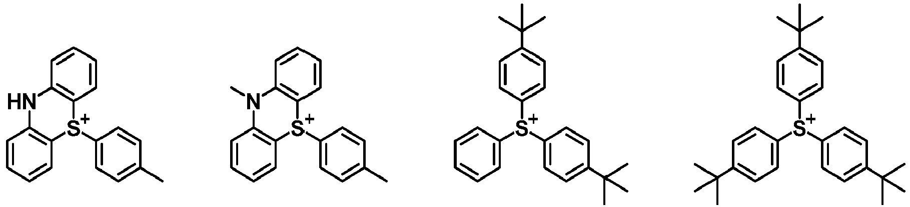

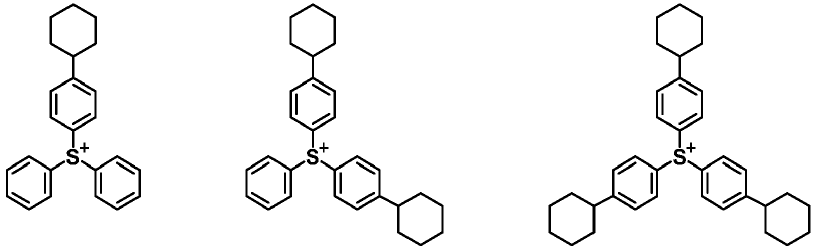

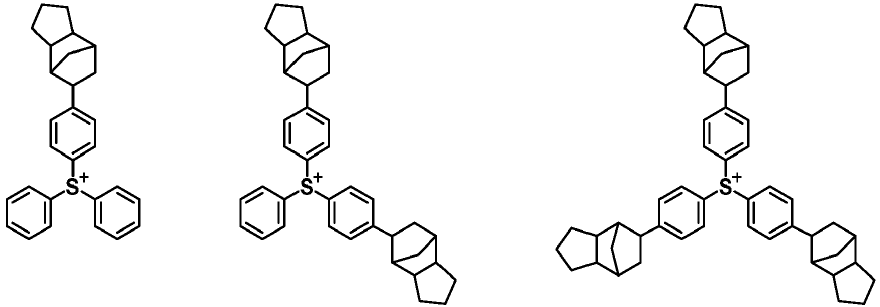

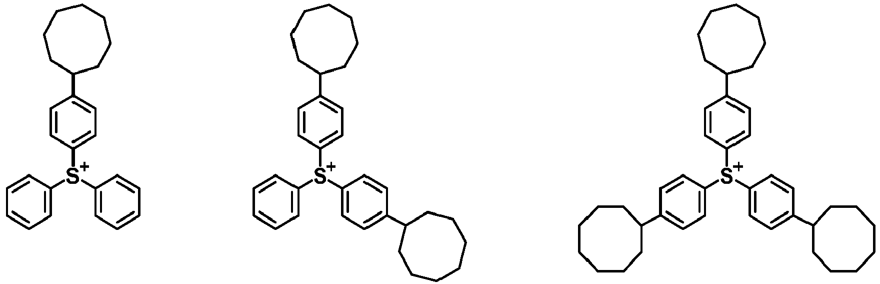

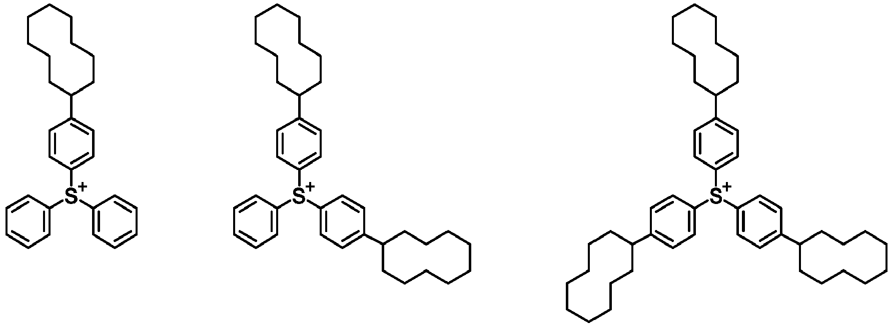

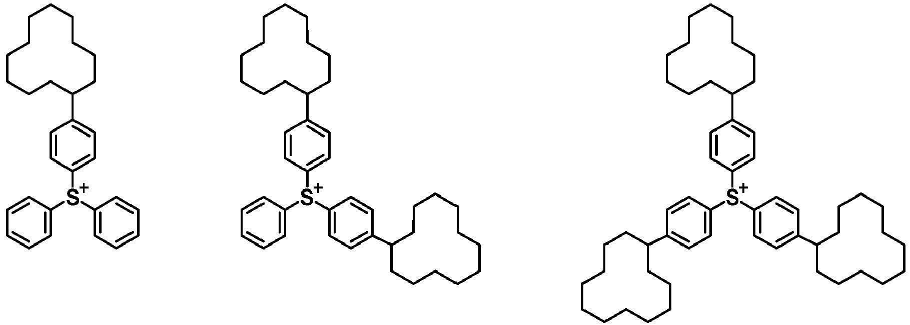

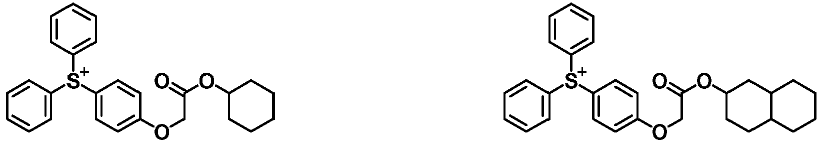

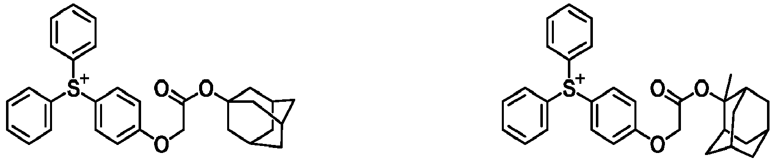

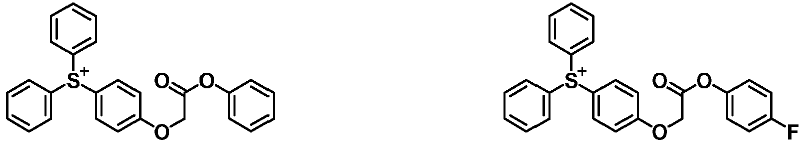

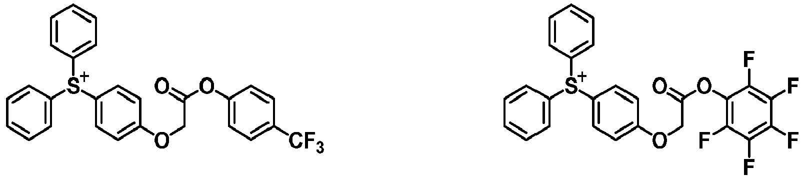

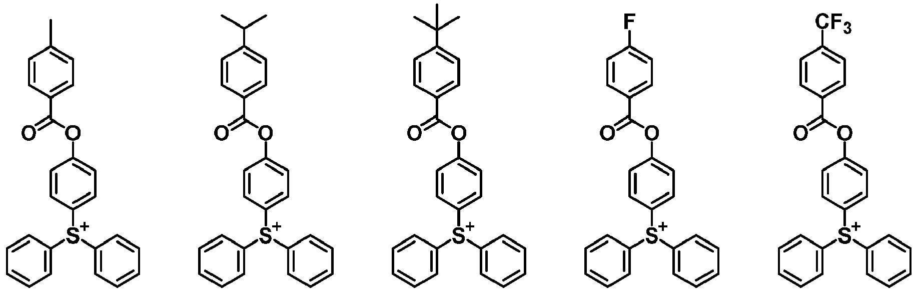

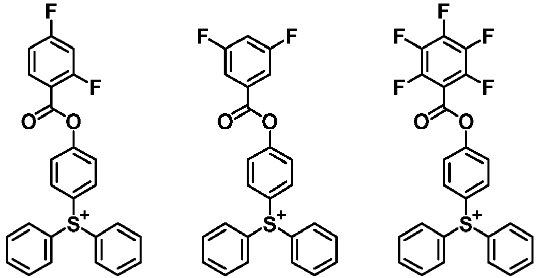

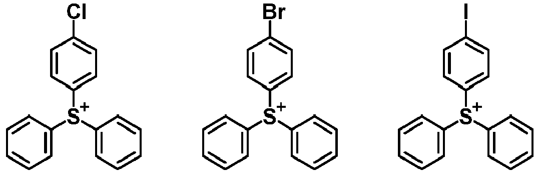

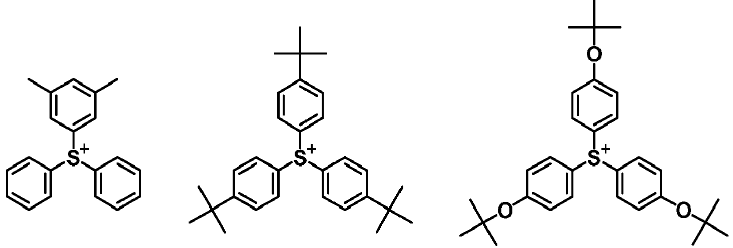

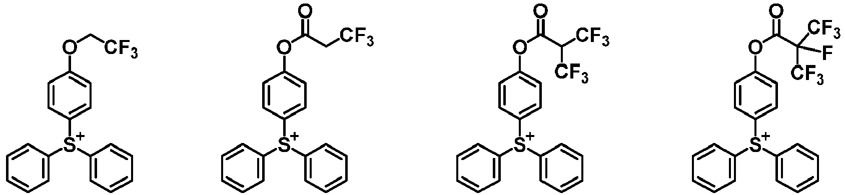

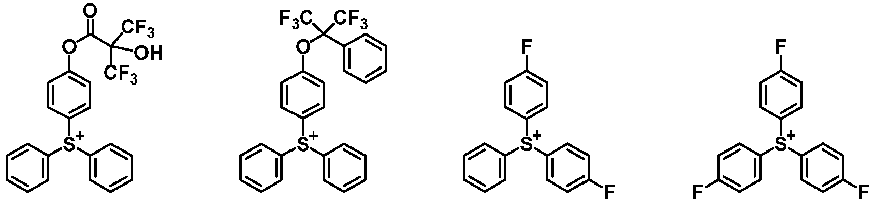

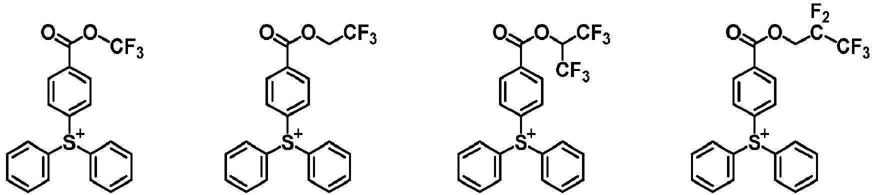

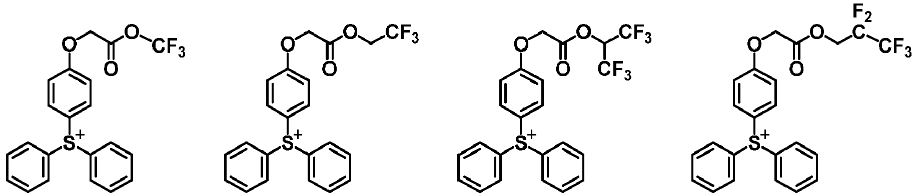

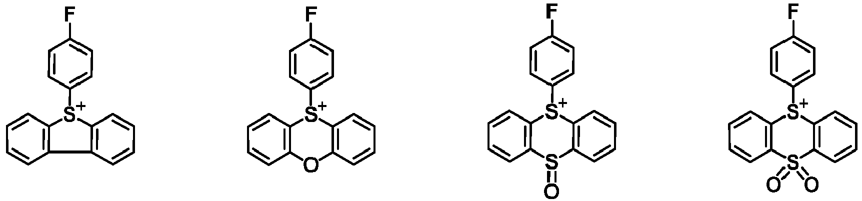

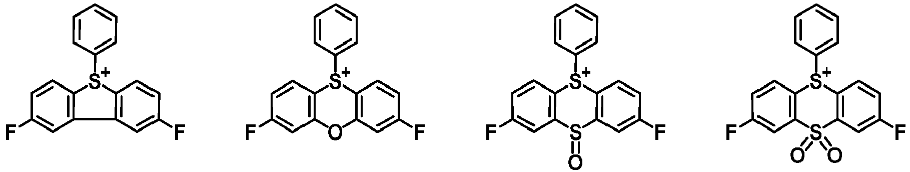

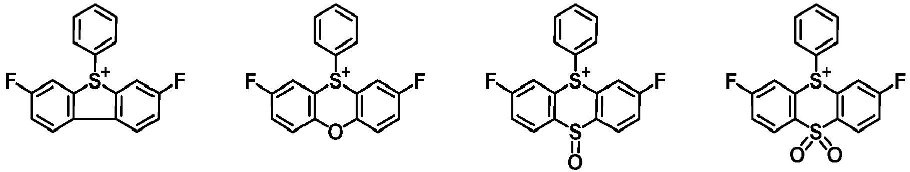

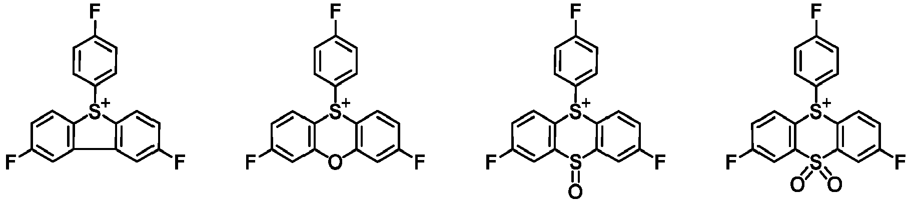

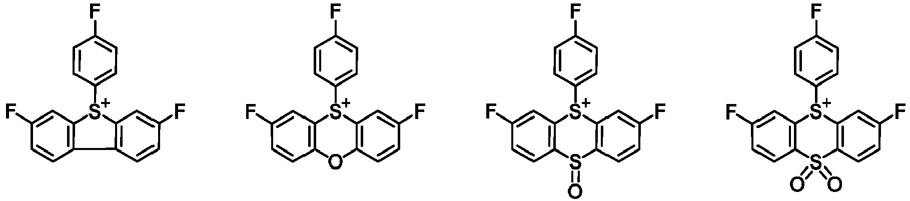

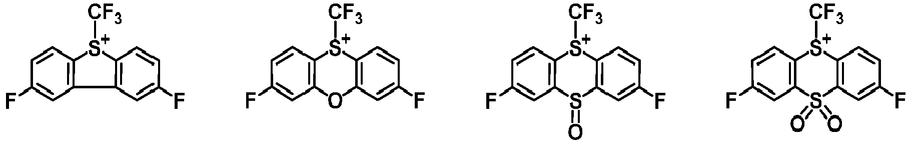

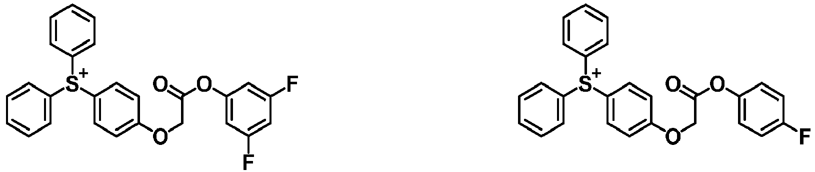

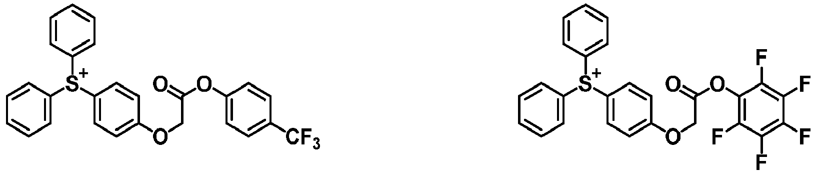

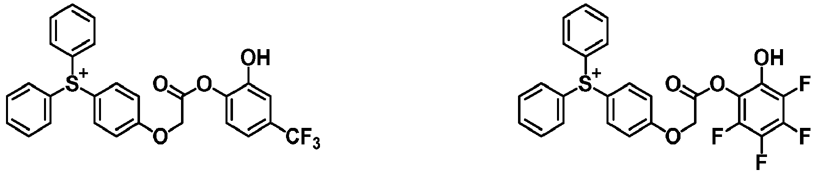

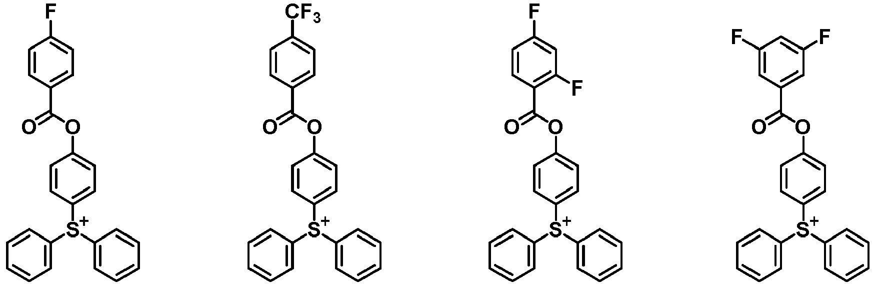

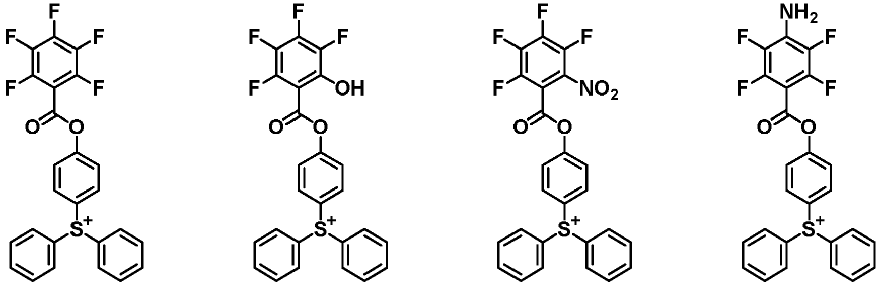

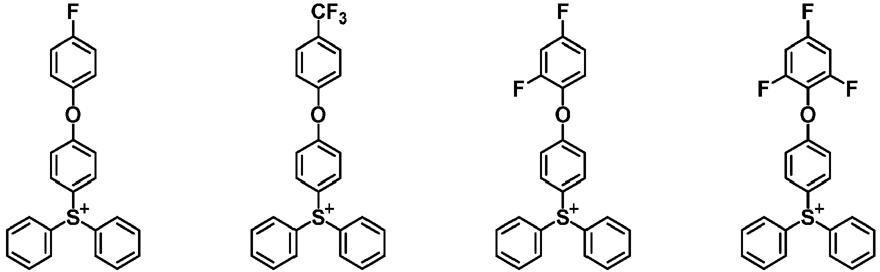

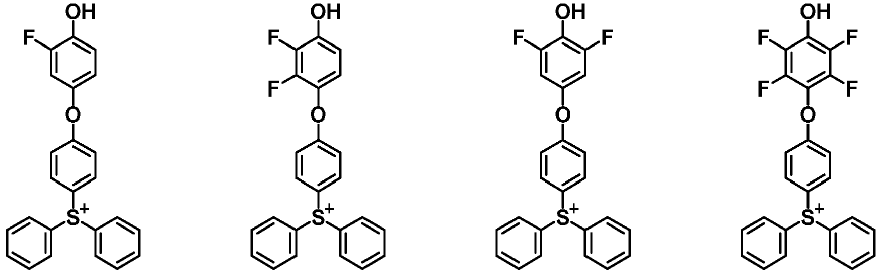

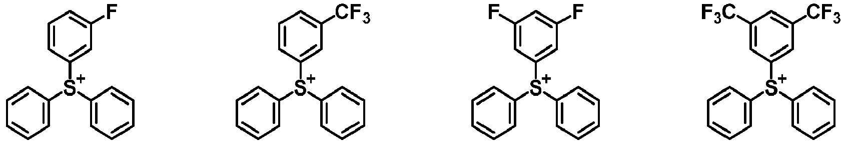

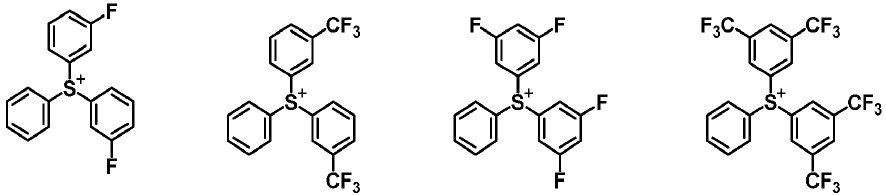

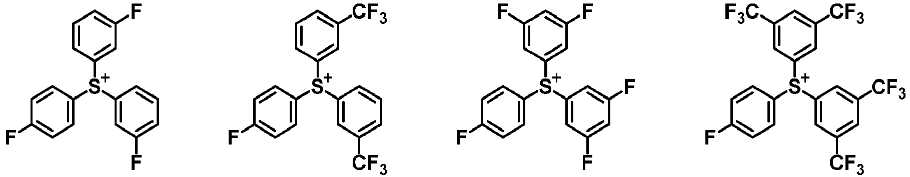

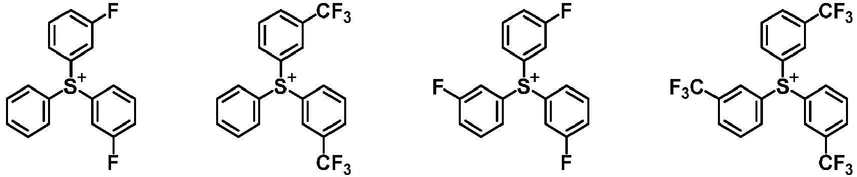

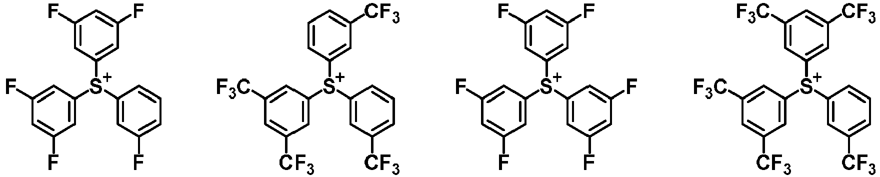

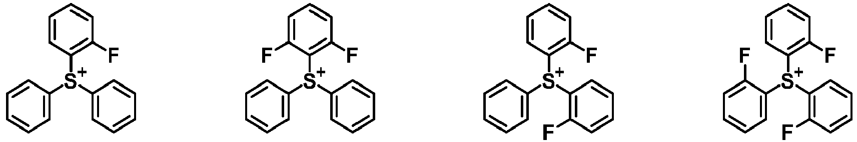

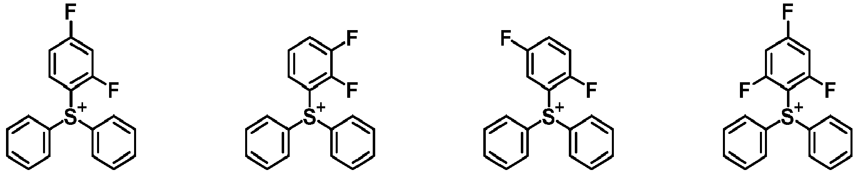

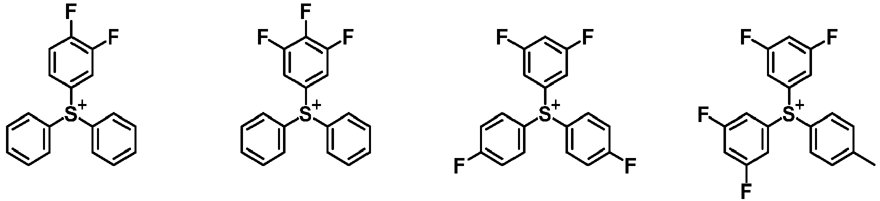

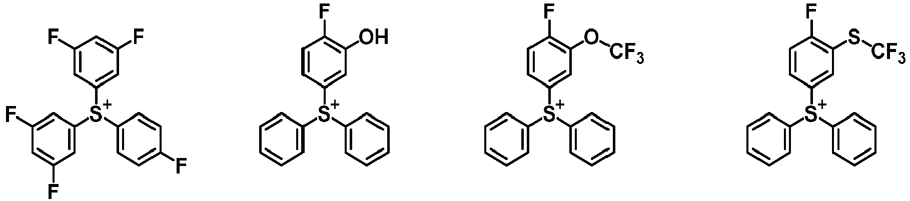

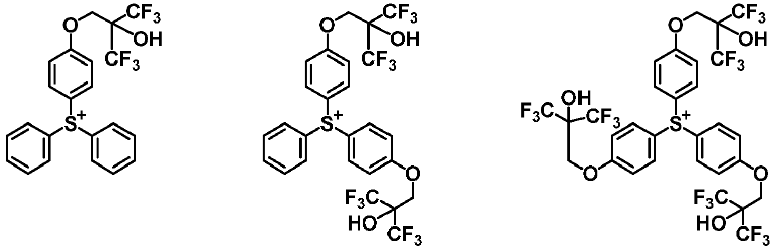

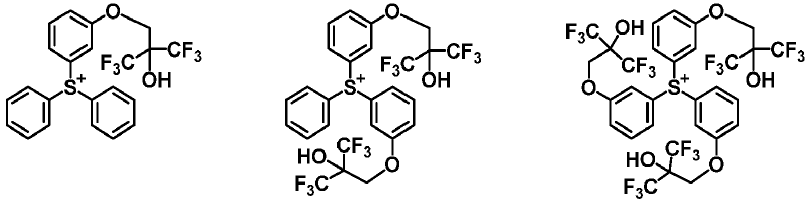

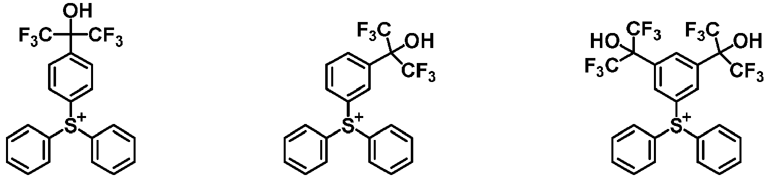

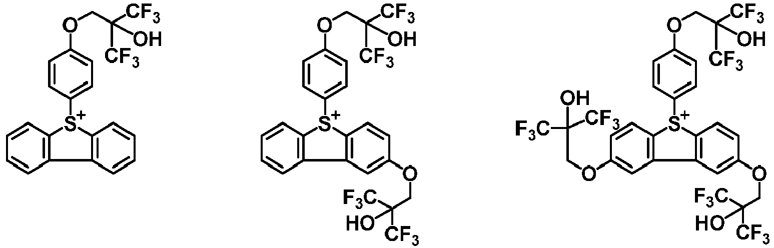

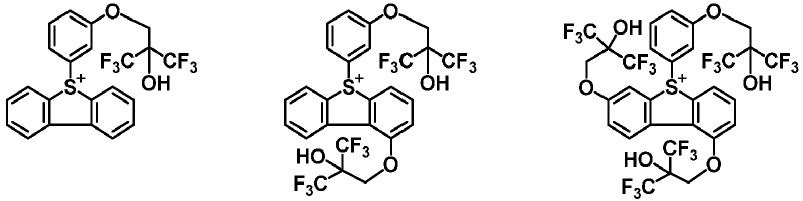

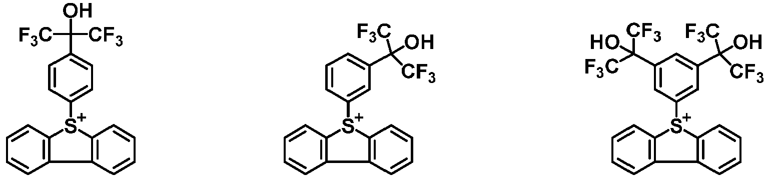

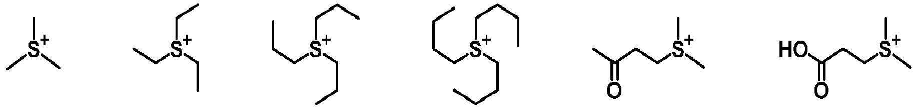

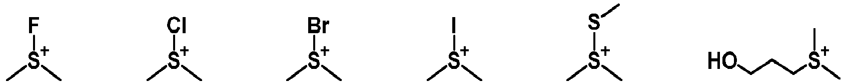

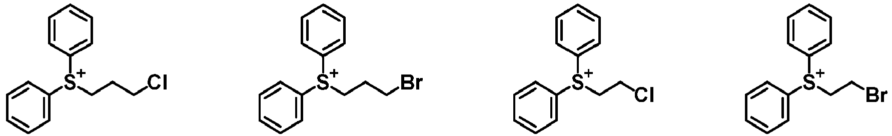

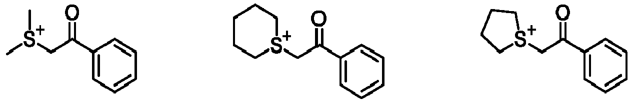

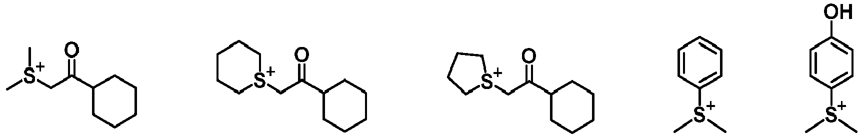

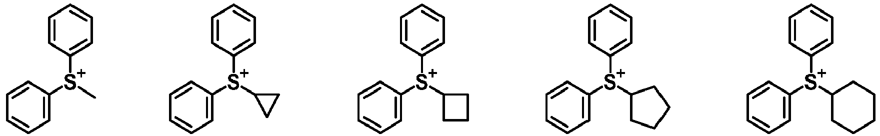

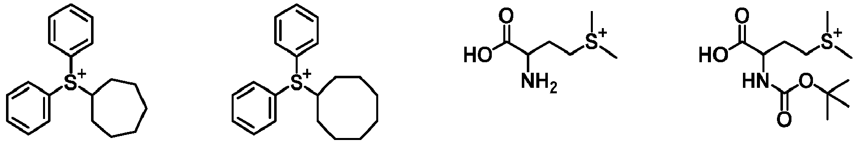

Exemplary structures of the iodonium cation in formulae (C5) to (C8) are shown below, but not limited thereto.

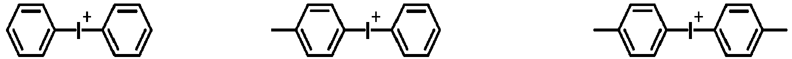

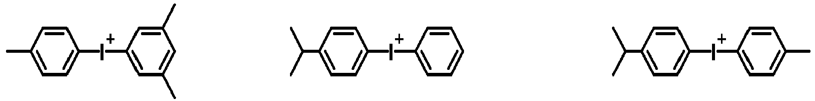

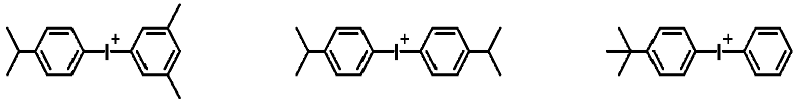

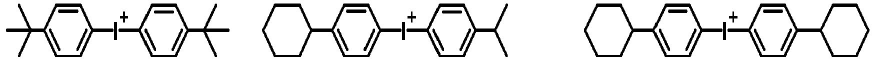

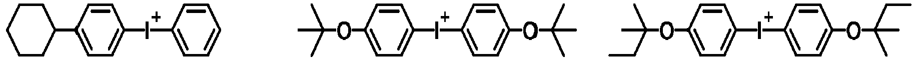

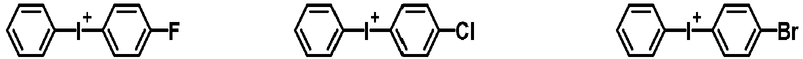

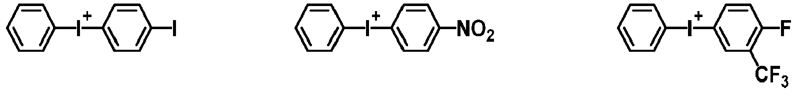

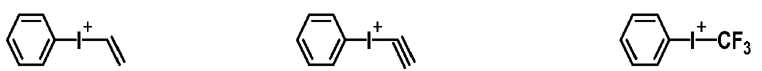

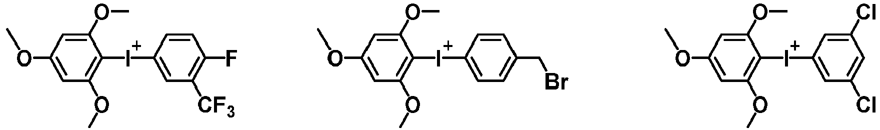

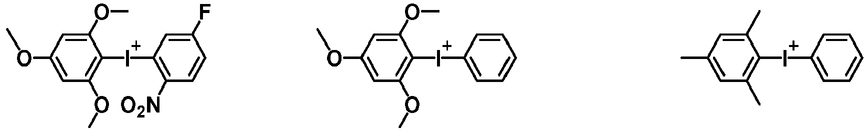

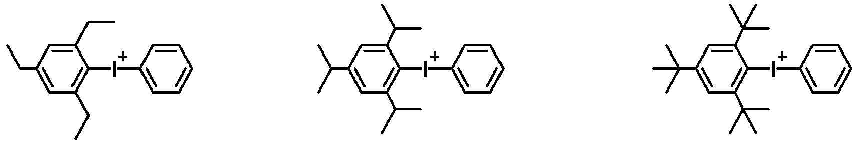

Of the repeat units C1 to C8, repeat unit C4 is preferred for the processing of photomask blanks because its acid strength is most appropriate in designing the acid labile group on a polymer.

The repeat units C1 to C8 are capable of generating an acid upon exposure to high-energy radiation. The acid-generating units bound to a polymer enable to appropriately control acid diffusion and hence, to form a pattern with reduced LER. Since the acid-generating unit is bound to a polymer, the phenomenon that acid volatilizes from the exposed region and re-deposits on the unexposed region during bake in vacuum is suppressed. This is effective for reducing LER and for mitigating any geometric degradation due to an unwanted film thickness loss in the unexposed region.

The repeat units C1 to C8 are preferably incorporated in a range of 0.1 to 30 mol%, more preferably 0.5 to 20 mol% based on the overall repeat units of the polymer in the base polymer. The repeat units C1 to C8 used herein may be of one type or a mixture of two or more types.

The repeat units having an aromatic ring structure are preferably incorporated in a range of at least 65 mol%, more preferably at least 75 mol%, even more preferably at least 85 mol%, based on the overall repeat units of the polymer in the base polymer. In the case of a polymer not containing repeat units C1 to C8, it is preferred that all the repeat units have an aromatic ring structure.

The total content of repeat units A1, repeat units A2, and repeat units of at least one type selected from repeat units B 1 to B3 is preferably at least 80 mol%, more preferably at least 85 mol% based on the overall repeat units of the polymer in the base polymer.

The polymer may further comprise (meth)acrylate units protected with an acid labile group and/or (meth)acrylate units having an adhesive group such as a lactone structure or a hydroxy group other than phenolic hydroxy, as commonly used in the art. These repeat units are effective for fine adjustment of properties of a resist film, but not essential.

Examples of the (meth)acrylate unit having an adhesive group include repeat units having the following formula (B4), repeat units having the following formula (B5), and repeat units having the following formula (B6), which are also referred to as repeat units B4, B5, and B6, respectively. While these units do not exhibit acidity, they may be used as auxiliary units for providing adhesion to substrates or adjusting solubility.

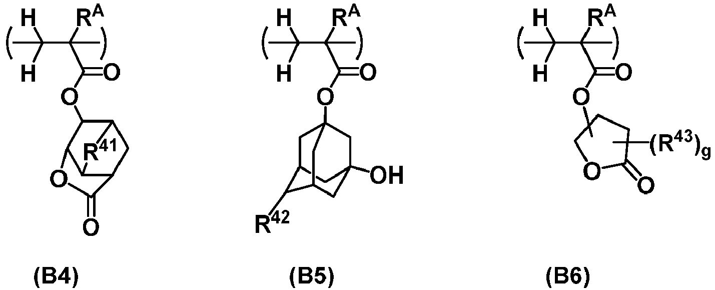

In formulae (B4) to (B6), R^{A} is as defined above. R⁴¹ is -O- or methylene. R⁴² is hydrogen or hydroxy. R⁴³ is a C₁-C₄ saturated hydrocarbyl group, and g is an integer of 0 to 3.

When the repeat units B4 to B6 are included, their content is preferably 0 to 20 mol%, more preferably 0 to 10 mol% based on the overall repeat units of the polymer. Each of the repeat units B4 to B6 may be of one type or a combination of plural types.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER is degraded when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.9, even more preferably 1.0 to 1.8. A polymer with such a narrow dispersity eliminates the risk that foreign particles are left on the pattern after development and the pattern profile is aggravated.

The base polymer is designed such that the dissolution rate in alkaline developer is preferably up to 10 nm/min, more preferably up to 7 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 10 nm/min, pattern collapse occurs, i.e., a small size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

### Fluorinated polymer

The positive resist composition may further comprise a fluorinated polymer which contains repeat units of at least one type selected from repeat units having the formula (D1), repeat units having the formula (D2), repeat units having the formula (D3), and repeat units having the formula (D4), and which may contain repeat units of at least one type selected from repeat units having the formula (D5) and repeat units having the formula (D6), for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

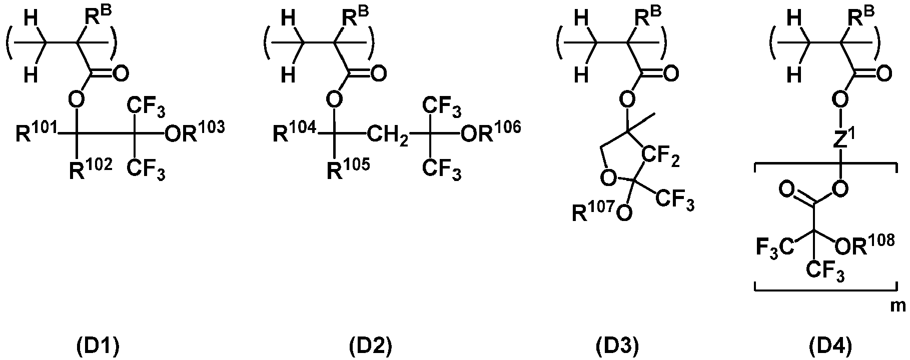

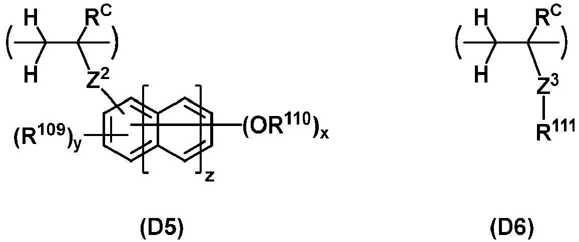

In formulae (D1) to (D6), R^{B} is each independently hydrogen, fluorine, methyl or trifluoromethyl. R^{C} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is hydrogen or a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. The subscript x is an integer of 1 to 3, y is an integer satisfying: 0 ≤ y ≤ 5+2z-x, z is 0 or 1, and m is an integer of 1 to 3. Z¹ is a C₁-C₂₀ (m+1)-valent hydrocarbon group or C₁-C₂₀ (m+1)-valent fluorinated hydrocarbon group. Z² is a single bond, *-C(=O)-O- or *-C(=O)-NH- wherein * designates a point of attachment to the carbon atom in the backbone. Z³ is a single bond, -O-, ^{∗}-C(=O)-O-Z³¹-Z³²- or ^{∗}-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and * designates a point of attachment to the carbon atom in the backbone.

Examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

Examples of the C₁-C₁₅ hydrocarbyl group represented by R¹⁰³, R¹⁰⁶, R¹⁰⁷ and R¹⁰⁸ include C₁-C₁₅ alkyl, C₂-C₁₅ alkenyl and C₂-C₁₅ alkynyl groups, with the C₁-C₁₅ alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

Examples of the C₁-C₂₀ (m+1)-valent hydrocarbon group Z¹ include the foregoing C₁-C₂₀ alkyl groups and C₃-C₂₀ cyclic saturated hydrocarbyl groups, with m number of hydrogen atoms being eliminated. Examples of the C₁-C₂₀ (m+1)-valent fluorinated hydrocarbon groups include the foregoing (m+1)-valent hydrocarbon groups, with at least one hydrogen being substituted by fluorine.

Examples of the repeat units D1 to D4 are given below, but not limited thereto. Herein R^{B} is as defined above.

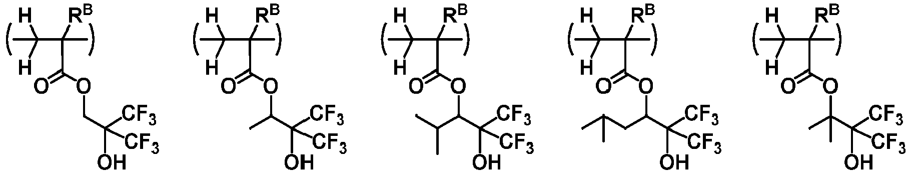

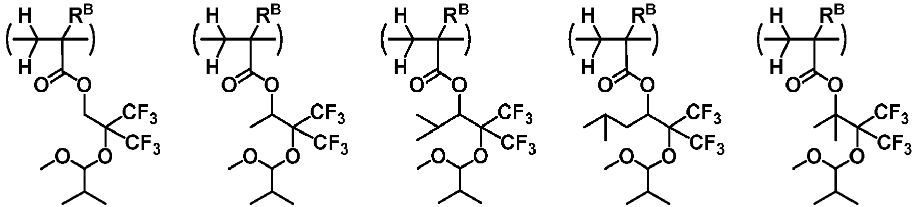

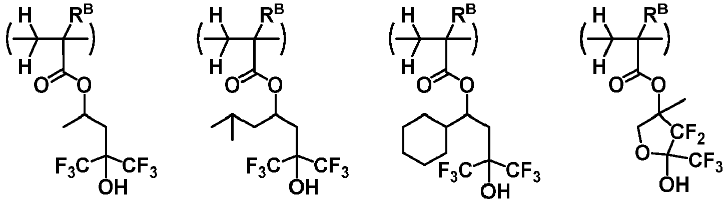

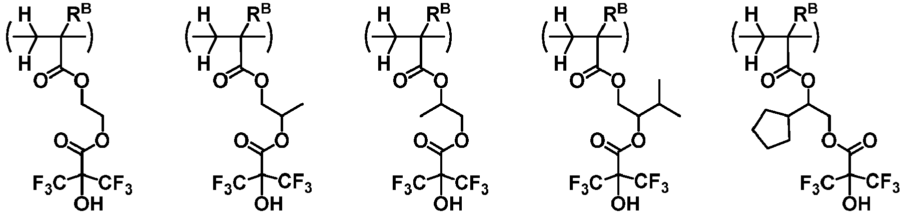

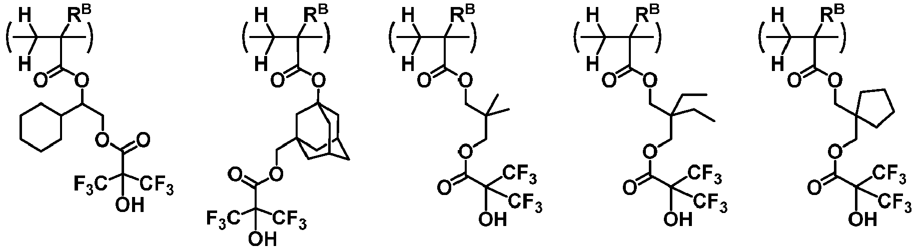

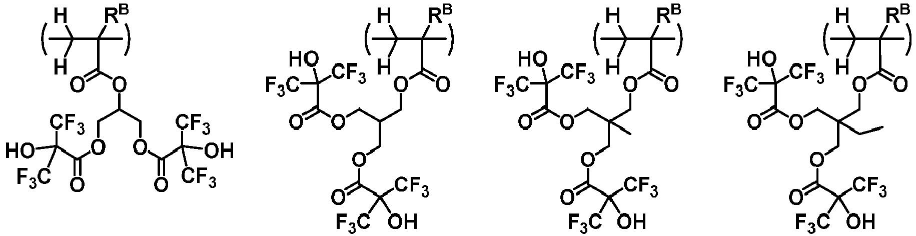

Examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹¹⁰ is preferably a hydrophilic group. In this case, R¹¹⁰ is preferably hydrogen or a C₁-C₅ alkyl group in which oxygen intervenes in a carbon-carbon bond.

Z² is preferably *-C(=O)-O- or *-C(=O)-NH-. Also preferably R^{C} is methyl. The inclusion of carbonyl in Z² enhances the ability to trap the acid originating from the anti-charging film. A polymer wherein R^{C} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{C} is as defined above.

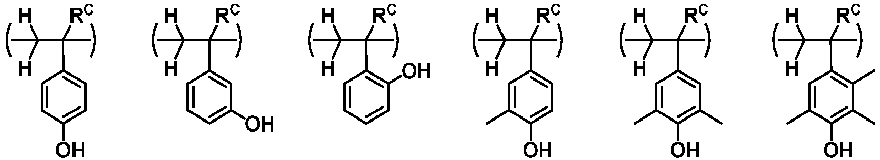

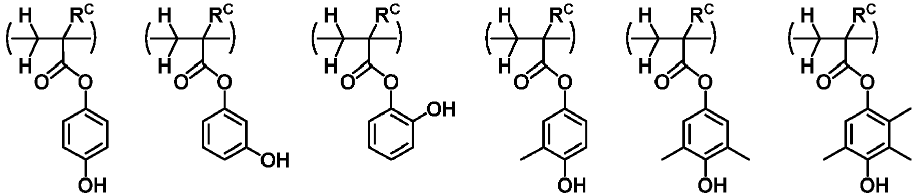

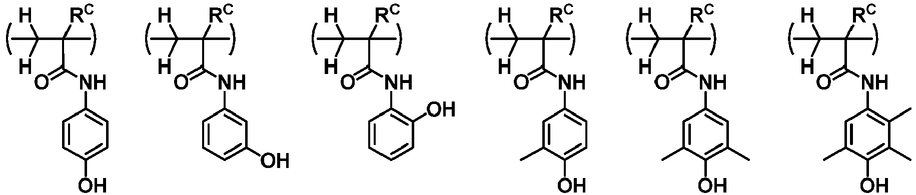

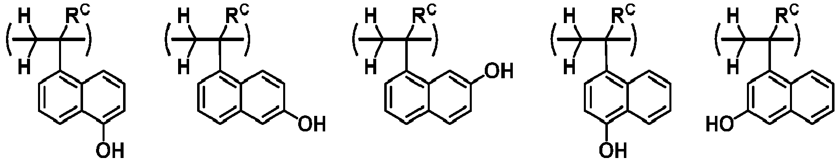

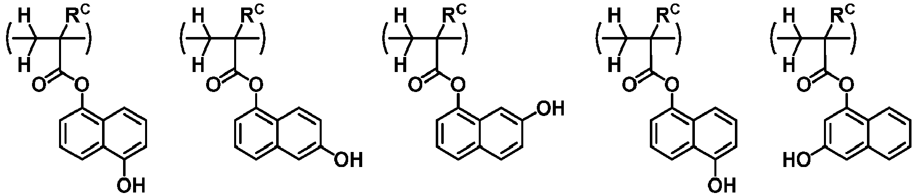

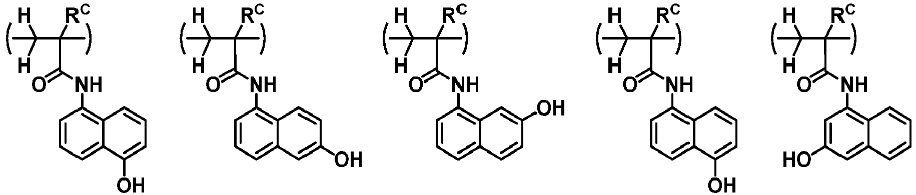

The C₁-C₁₀ saturated hydrocarbylene group Z³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic. Examples thereof correspond to the above exemplified C₁-C₂₀ alkyl and C₃-C₂₀ cyclic saturated hydrocarbyl groups in which at least one hydrogen is substituted by fluorine.

Examples of the repeat unit D6 are given below, but not limited thereto. Herein R^{C} is as defined above.

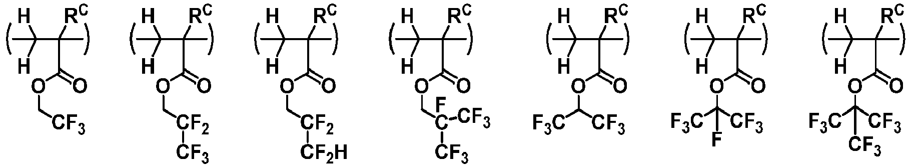

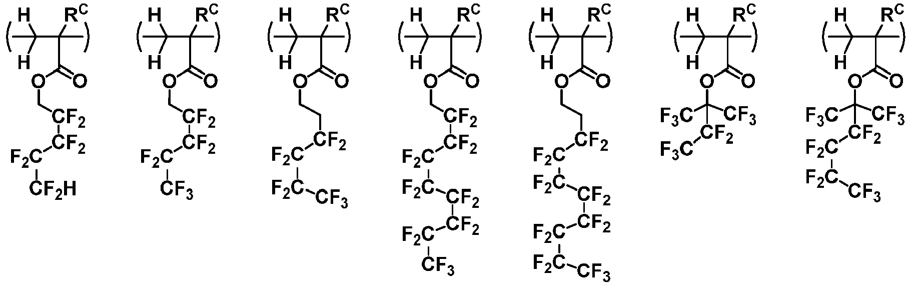

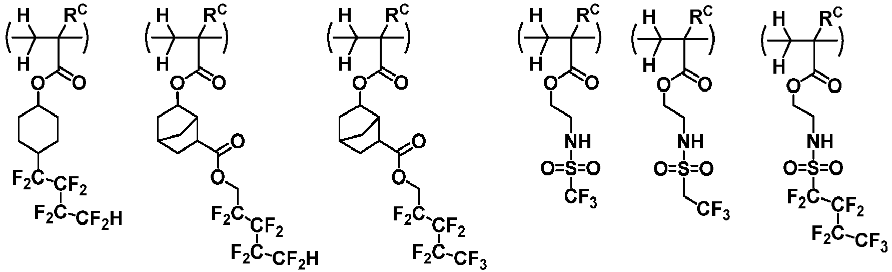

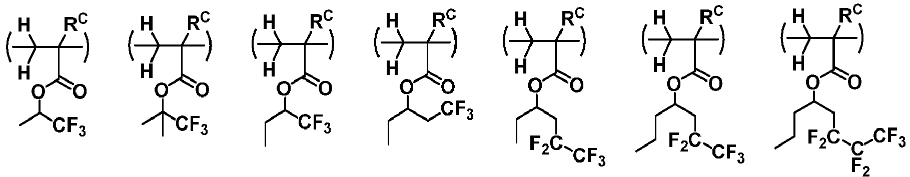

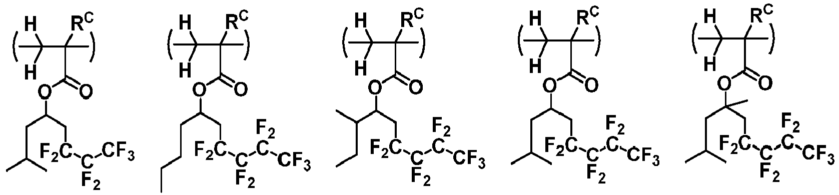

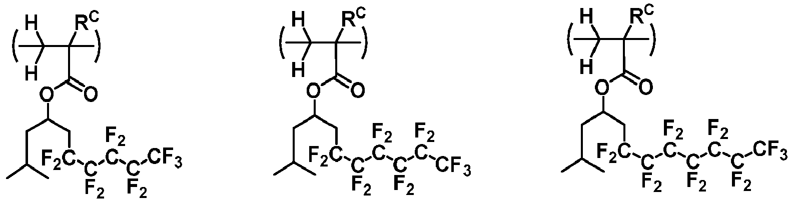

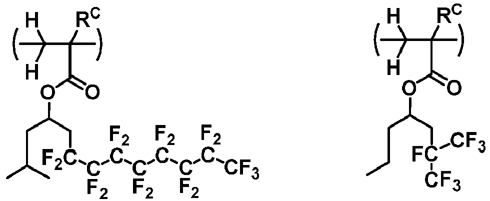

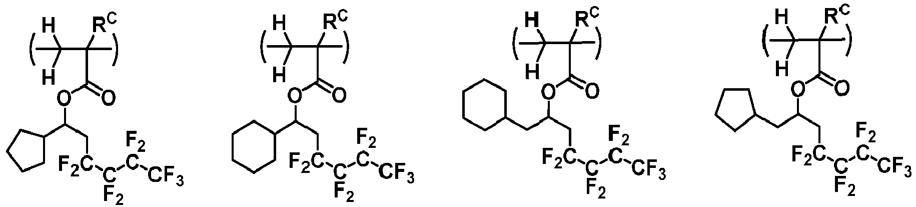

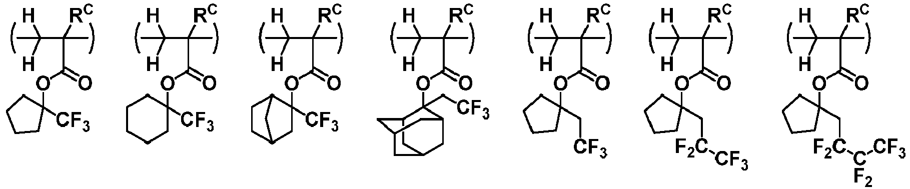

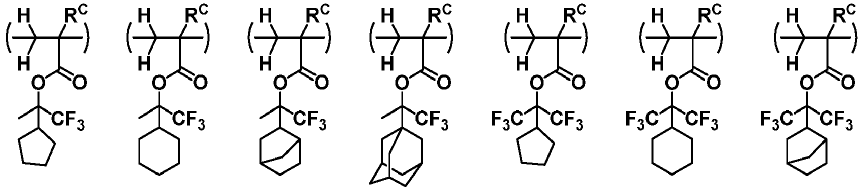

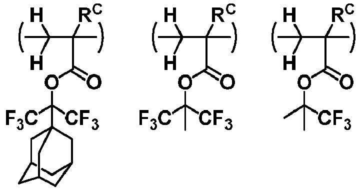

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the positive resist composition, the fluorinated polymer is preferably used in an amount of 0.01 to 30 parts, more preferably 0.1 to 20 parts, even more preferably 0.5 to 10 parts by weight per 80 parts by weight of the base polymer.

### Organic solvent

The chemically amplified positive resist composition may further comprise an organic solvent. The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone and methyl-2-n-pentyl ketone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof. Where an acid labile group of acetal form is used, a high-boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent is preferably used in an amount of 200 to 10,000 parts, more preferably 400 to 5,000 parts by weight per 80 parts by weight of the base polymer. The organic solvent may be used alone or in admixture.

### Photoacid generator

The positive resist composition may further comprise a photoacid generator (PAG). The PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in the repeat units having formula (A2).

The preferred PAGs are compounds having a sulfonium anion of the structure shown below.

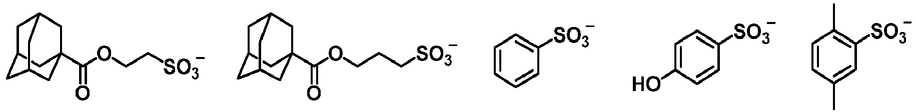

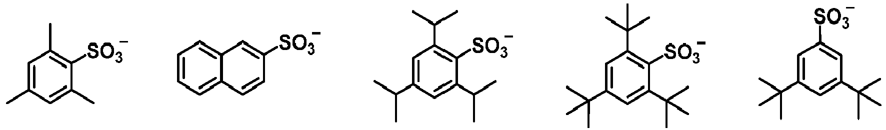

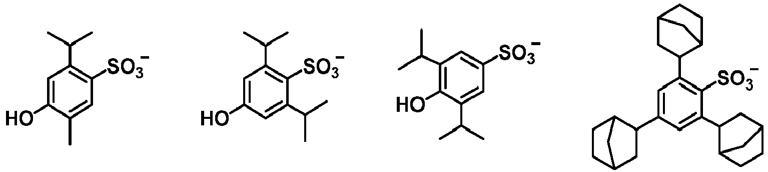

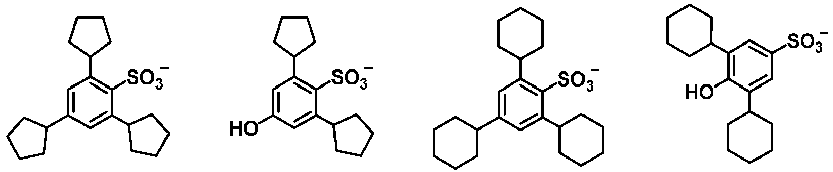

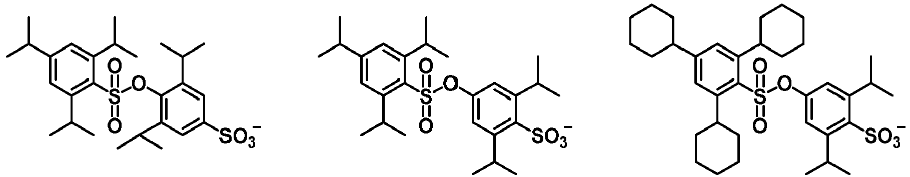

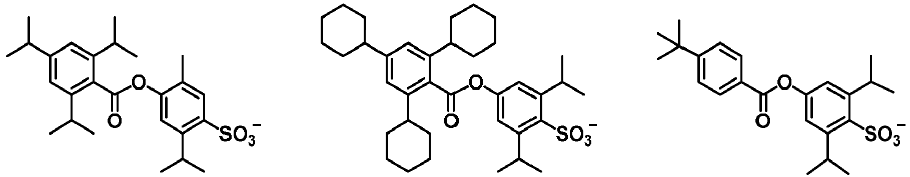

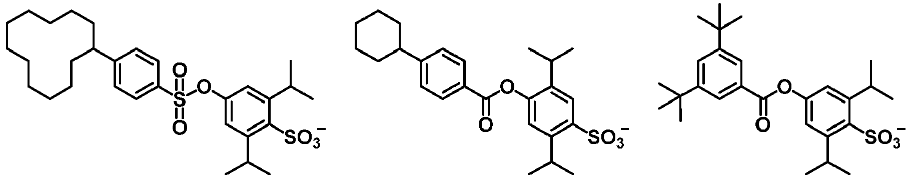

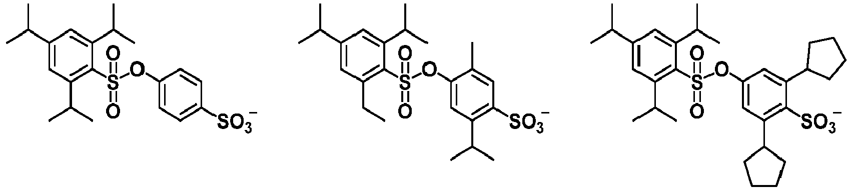

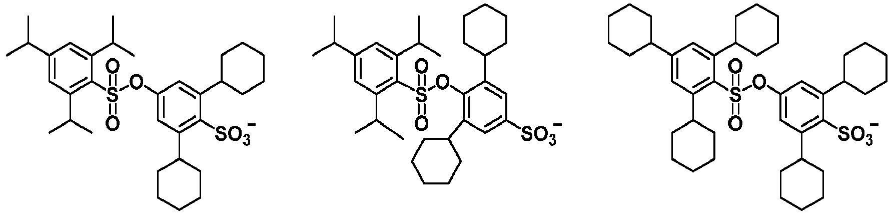

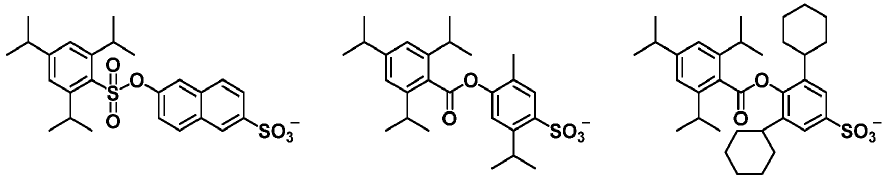

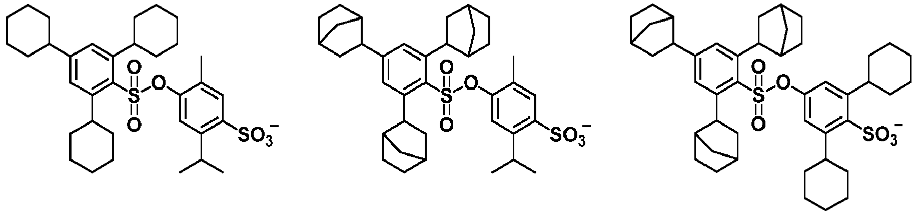

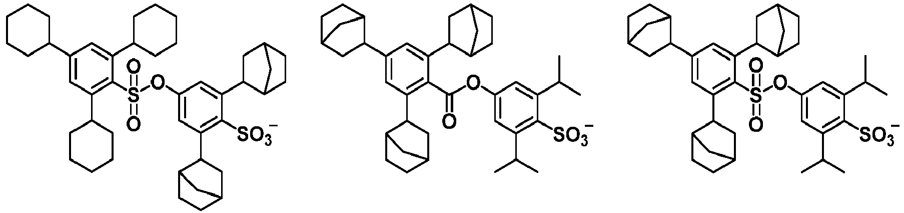

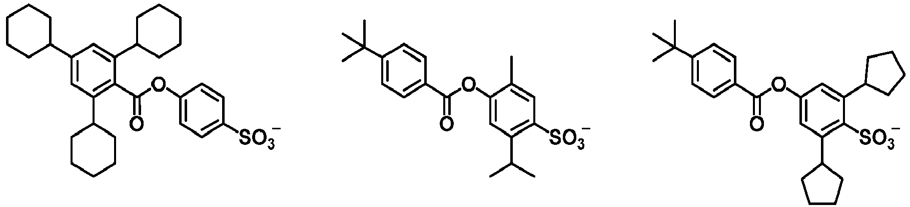

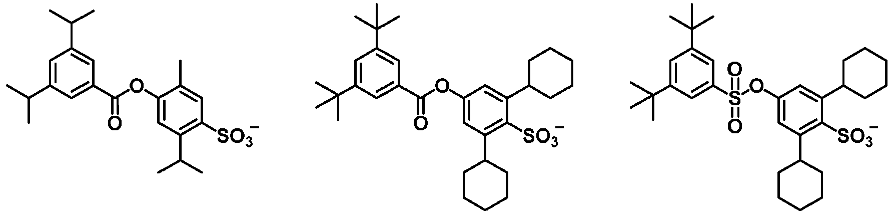

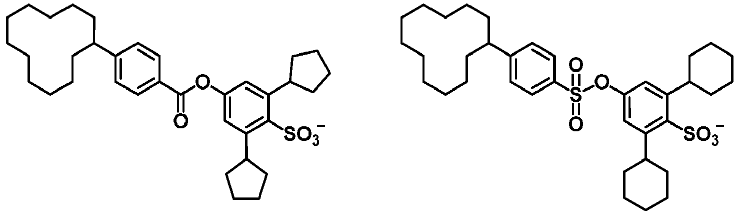

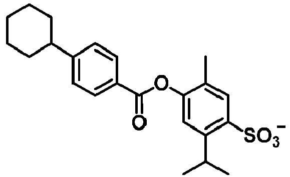

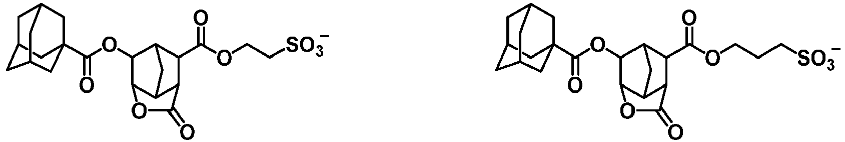

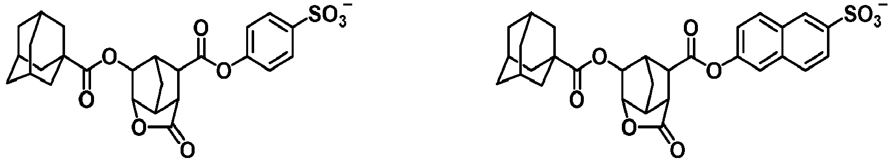

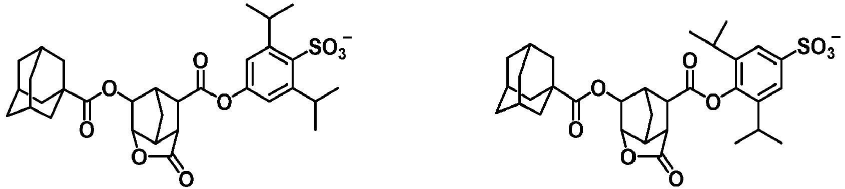

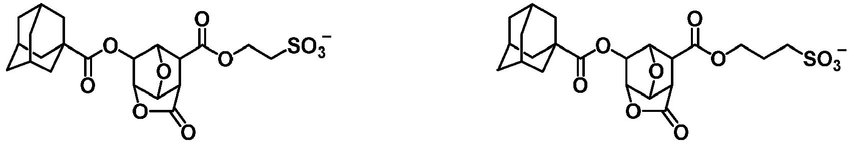

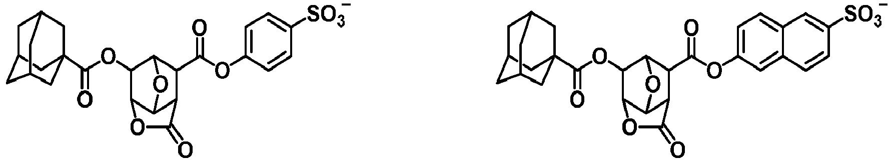

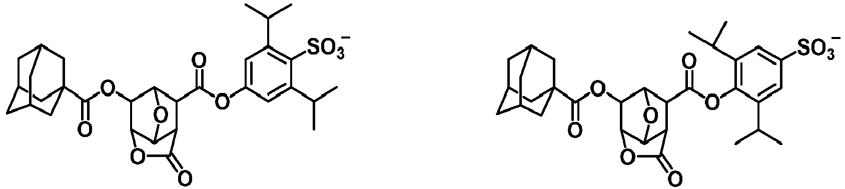

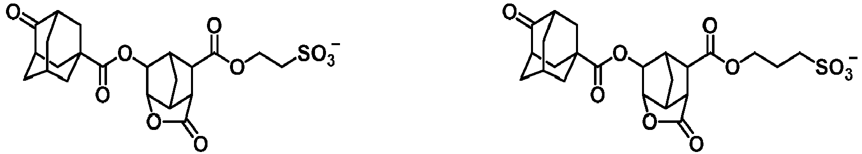

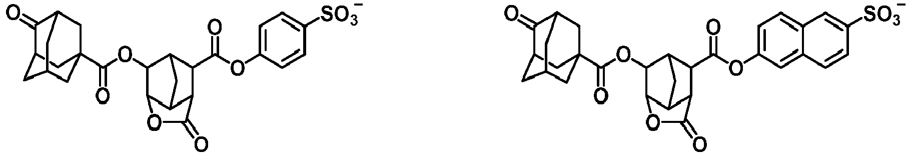

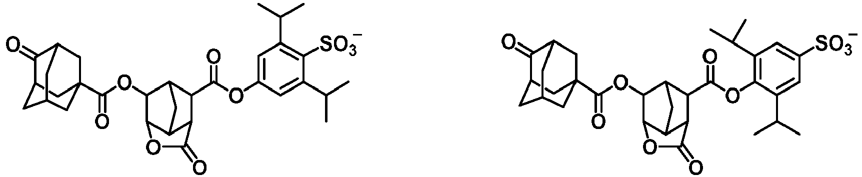

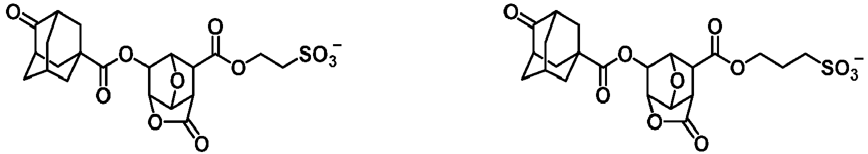

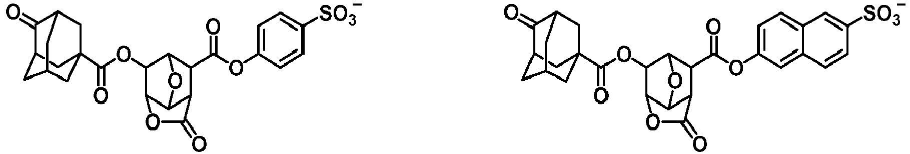

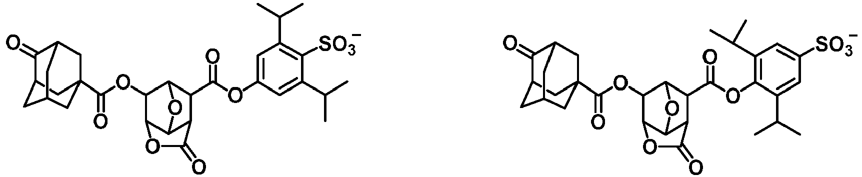

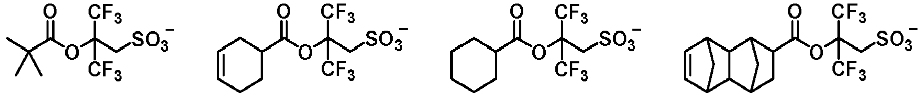

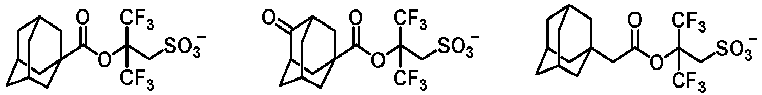

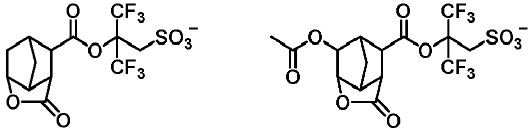

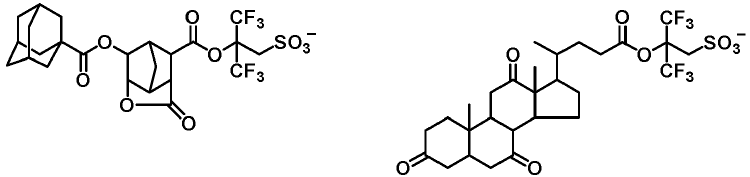

Preferred examples of the cation that pairs with the anion include sulfonium cations having the formula (E) and iodonium cations having the formula (F).

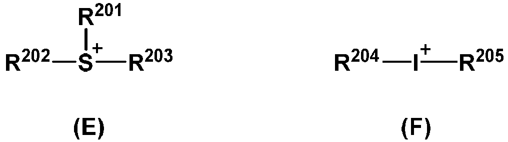

In formulae (E) and (F), R²⁰¹ to R²⁰¹ are each independently halogen or a C₁-C₂₀ hydrocarbyl group which may contain a heteroatom.

Suitable halogen atoms include fluorine, chlorine, bromine and iodine.

The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, sec-butyl, tert-butyl, tert-pentyl, n-pentyl, n-hexyl, n-octyl, 2-ethylhexyl, n-nonyl and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; and C₆-C₂₀ aryl groups such as phenyl, naphthyl and anthracenyl. In the hydrocarbyl groups, some or all of the hydrogen atoms may be substituted by a moiety containing a heteroatom such as oxygen, sulfur, nitrogen or halogen, and a moiety containing a heteroatom such as oxygen, sulfur or nitrogen may intervene in a carbon-carbon bond, so that the group may contain a hydroxy, fluorine, chlorine, bromine, iodine, cyano, carbonyl, ether bond, ester bond, sulfonic ester bond, carbonate bond, lactone ring, sultone ring, carboxylic anhydride (-C(=O)-O-C(=O)-) or haloalkyl moiety.

Also, R²⁰¹ and R²⁰² may bond together to form a ring with the sulfur atom to which they are attached. Examples of the ring are as exemplified above for the ring that R²³ and R²⁴, R²⁶ and R²⁷, or R²⁹ and R³⁰ in formulae (C1) to (C8), taken together, form with the sulfur atom to which they are attached.

Examples of the sulfonium cation having formula (E) are as exemplified above for the sulfonium cation in formulae (C2) to (C4). Examples of the iodonium cation having formula (F) are as exemplified above for the iodonium cation in formulae (C5) to (C8).

Preferably, the PAG generates an acid having a pKa value of -2.0 or larger. The upper limit of pKa is preferably 2.0. Notably, the pKa value is computed using pKa DB in software ACD/Chemsketch ver: 9.04 of Advanced Chemistry Development Inc.

An appropriate amount of the PAG used is 1 to 30 parts, more preferably 2 to 20 parts by weight per 80 parts by weight of the base polymer. The PAG may be used alone or in admixture.

### Quencher

The positive resist composition preferably contains a quencher or acid diffusion-suppressing agent. The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonic ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium salts, iodonium salts and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (G1).

**R³⁰¹-CO₂⁻ Mq⁺** **(G1)**

In formula (G1), R³⁰¹ is hydrogen or a C₁-C₄₀ hydrocarbyl group which may contain a heteroatom, exclusive of the hydrocarbyl group in which the hydrogen bonded to the carbon atom at α-position of the sulfo group is substituted by fluorine or fluoroalkyl.

The hydrocarbyl group may be saturated or unsaturated and straight, branched or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), dialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the hydrocarbyl groups, some hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonic ester bond, carbonate bond, lactone ring, sultone ring, carboxylic anhydride (-C(=O)-O-C(=O)-), or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (G1), Mq⁺ is an onium cation. The onium cation is preferably selected from sulfonium, iodonium and ammonium cations, more preferably sulfonium and iodonium cations. Exemplary sulfonium cations are as exemplified above for the sulfonium cation in formulae (C2) to (C4). Exemplary iodonium cations are as exemplified above for the iodonium cation in formulae (C5) to (C8).

Examples of the anion of the salt having formula (G1) are shown below, but not limited thereto.

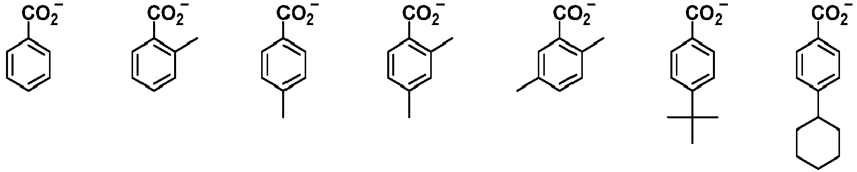

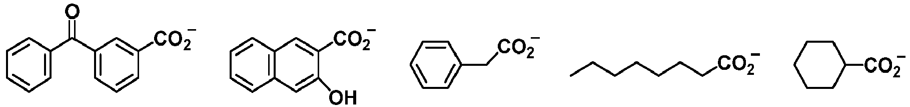

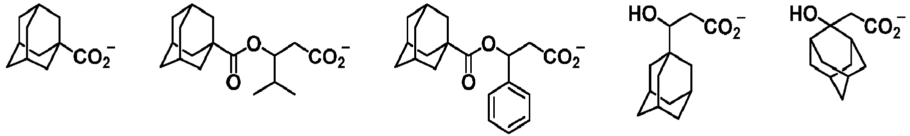

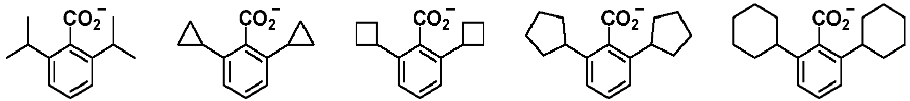

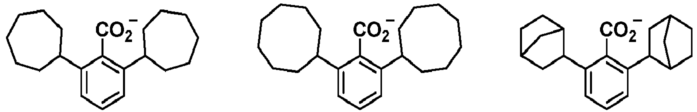

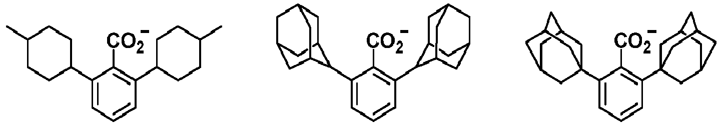

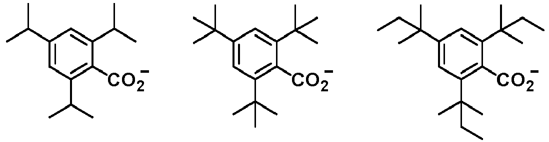

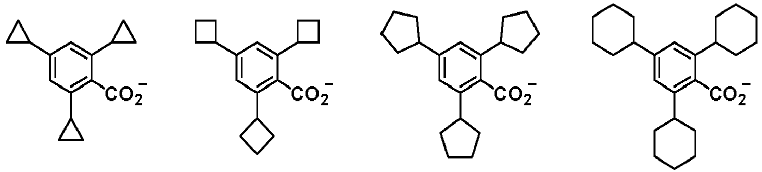

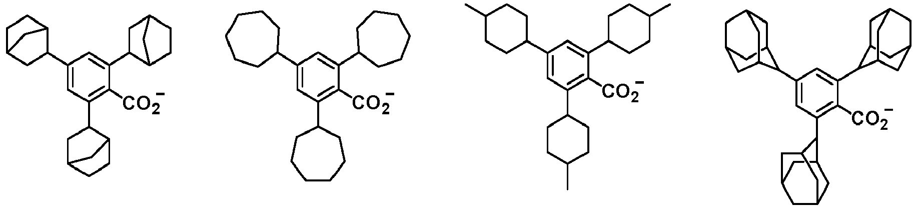

A sulfonium salt of iodized benzene ring-containing carboxylic acid having the formula (G2) is also useful as the quencher.

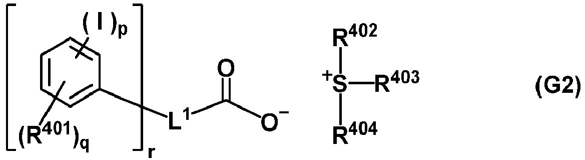

In formula (G2), R⁴⁰¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{401A})-C(=O)-R^{401B}, or -N(R^{401A})-C(=O)-O-R^{401B}. R^{401A} is hydrogen or a C₁-C₆ saturated hydrocarbyl group. R^{401B} is a C₁-C₆ saturated hydrocarbyl or C₂-C₈ unsaturated aliphatic hydrocarbyl group.

In formula (G2), p is an integer of 1 to 5, q is an integer of 0 to 3, and r is an integer of 1 to 3. L¹ is a single bond, or a C₁-C₂₀ (r+1)-valent linking group which may contain at least one moiety selected from ether bond, carbonyl moiety, ester bond, amide bond, sultone ring, lactam ring, carbonate bond, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic. Groups R⁴⁰¹ may be the same or different when q and/or r is 2 or 3.

In formula (G2), R⁴⁰², R⁴⁰³ and R⁴⁰⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy, carboxy, halogen, oxo, cyano, nitro, sultone ring, sulfo, or sulfonium salt-containing moiety, or some -CH₂- may be replaced by an ether bond, ester bond, carbonyl moiety, amide bond, carbonate moiety or sulfonic ester bond. Also R⁴⁰² and R⁴⁰³ may bond together to form a ring with the sulfur atom to which they are attached.

Examples of the compound having formula (G2) include those described in USP 10,295,904 (JP-A 2017-219836). These compounds exert a sensitizing effect due to remarkable absorption and an acid diffusion-controlling effect.

A nitrogen-containing carboxylic acid salt compound having the formula (G3) is also useful as the quencher.

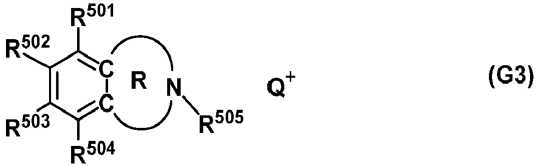

In formula (G3), R⁵⁰¹ to R⁵⁰⁴ are each independently hydrogen, -L²-CO₂⁻, or a C₁-C₂₀ hydrocarbyl group which may contain a heteroatom. R⁵⁰¹ and R⁵⁰², R⁵⁰² and R⁵⁰³, or R⁵⁰³ and R⁵⁰⁴ may bond together to form a ring with the carbon atom to which they are attached. L² is a single bond or a C₁-C₂₀ hydrocarbylene group which may contain a heteroatom. R⁵⁰⁵ is hydrogen or a C₁-C₂₀ hydrocarbyl group which may contain a heteroatom.

In formula (G3), the ring R is a C₂-C₆ ring containing the carbon and nitrogen atoms in the formula, in which some or all of the carbon-bonded hydrogen atoms may be substituted by a C₁-C₂₀ hydrocarbyl group or -L²-CO₂⁻ and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (G3) has at least one -L²-CO₂⁻. That is, at least one of R⁵⁰¹ to R⁵⁰⁴ is -L²-CO₂⁻, and/or at least one of hydrogen atoms bonded to carbon atoms in the ring R is substituted by -L²-CO₂⁻.

In formula (G3), Q⁺ is a sulfonium, iodonium or ammonium cation, with the sulfonium cation being preferred. Examples of the sulfonium cation are as exemplified above for the cation in formula (E).

Examples of the anion in the compound having formula (G3) are shown below, but not limited thereto.

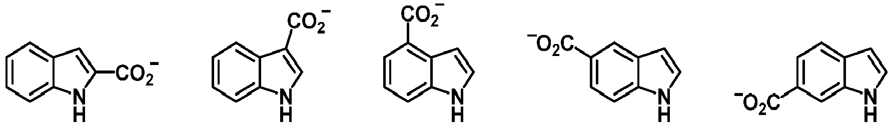

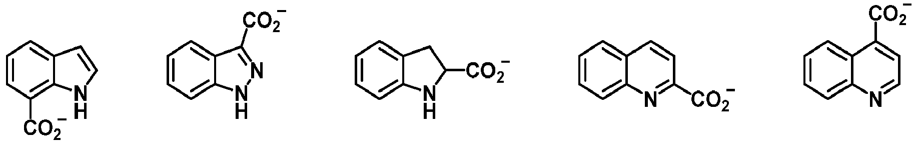

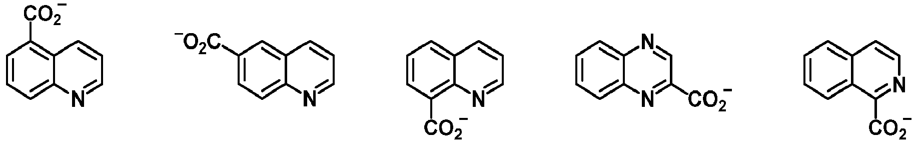

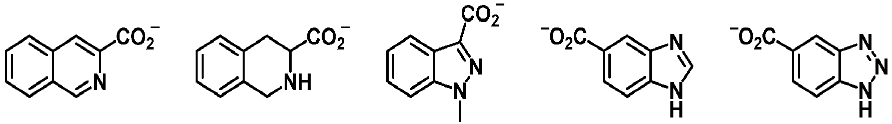

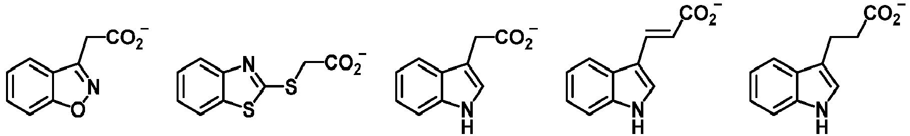

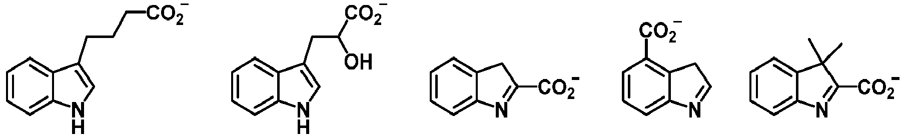

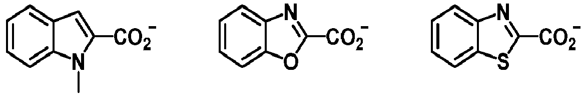

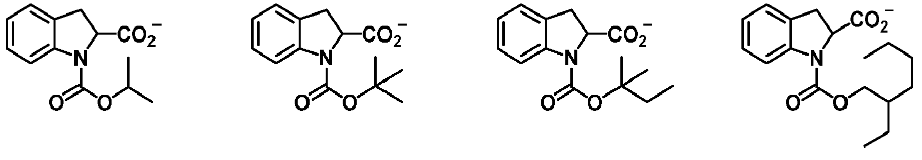

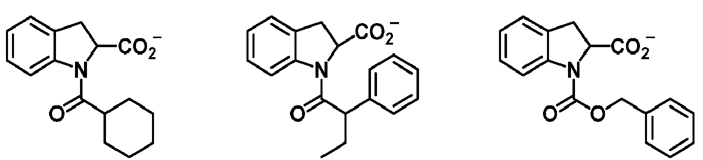

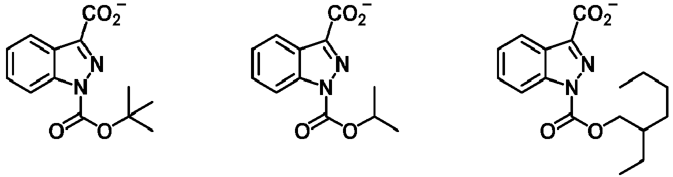

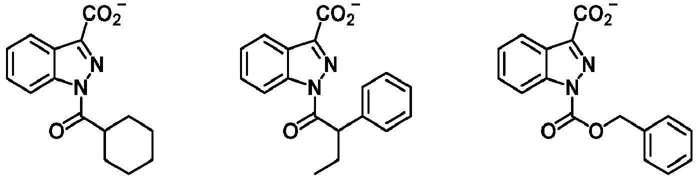

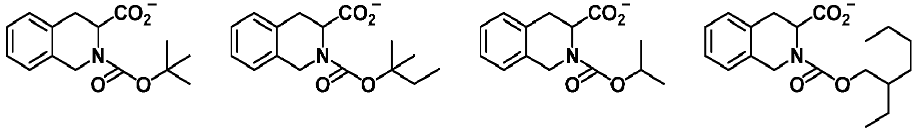

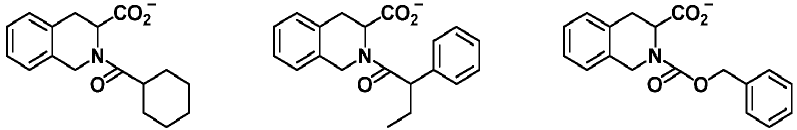

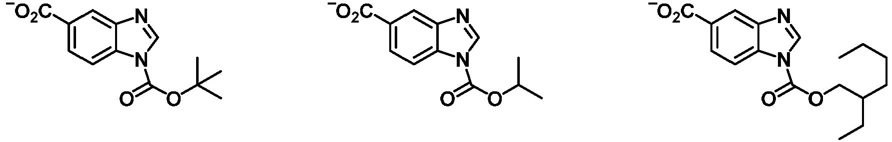

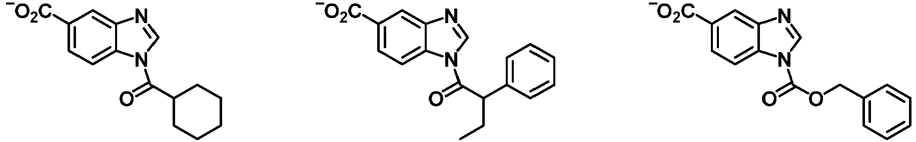

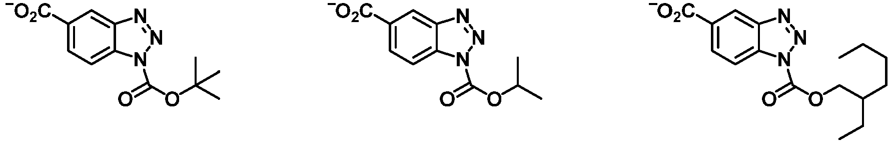

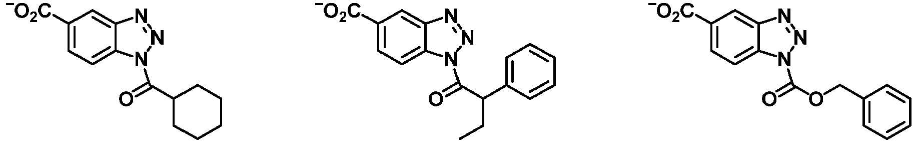

Weak acid betaine compounds are also useful as the quencher. Non-limiting examples thereof are shown below.

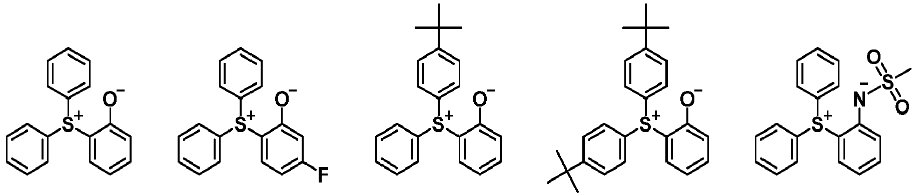

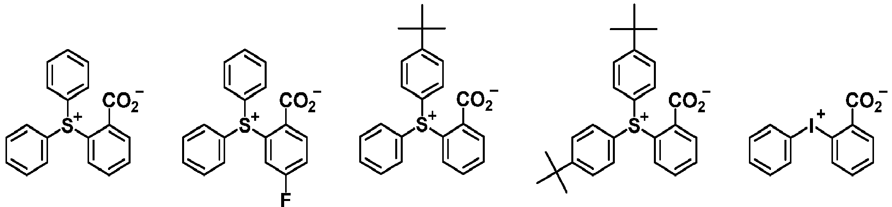

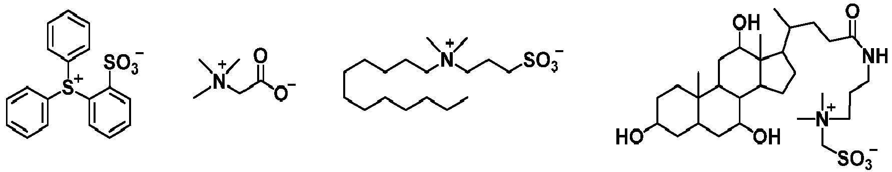

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When used, the quencher is preferably added in an amount of 0 to 50 parts, more preferably 0.1 to 40 parts by weight per 80 parts by weight of the base polymer. The quencher may be used alone or in admixture.

When the chemically amplified positive resist composition contains both the PAG and the quencher, the weight ratio of the PAG to the quencher is preferably less than 6/1, more preferably less than 5/1, even more preferably less than 4/1. As long as the weight ratio of the PAG to the quencher is in the range, the resist composition is able to fully suppress acid diffusion, leading to improved resolution and dimensional uniformity.

### Surfactant

The positive resist composition may contain any conventional surfactants for facilitating to coat the composition to the substrate. A number of surfactants are known in the art as described in JP-A 2004-115630, and any suitable one may be chosen therefrom. The amount of surfactant added is preferably 0 to 5 parts by weight per 80 parts by weight of the base polymer. It is noted that the surfactant need not be added when the positive resist composition contains a fluorinated polymer as mentioned above, which also plays the role of a surfactant.

From the standpoint of improving the develop loading effect, the chemically amplified positive resist composition is preferably designed such that a resist film formed therefrom in an over-exposed region may have a dissolution rate in alkaline developer of at least 100 nm/sec, more preferably at least 200 nm/sec, even more preferably at least 300 nm/sec. As long as the dissolution rate is at least 100 nm/sec, the resist film is uniformly dissolved in alkaline developer independent of a pattern layout difference in the case of a grouped/isolated pattern, and the variation of line width can be minimized. It is noted that the dissolution rate of an over-exposed region is computed by spin coating the positive resist composition onto a 8-inch silicon wafer, baking at 110°C for 60 seconds to form a resist film of 90 nm thick, exposing the resist film to KrF excimer laser radiation in a sufficient energy dose to complete deprotection reaction on the polymer, baking at 110°C for 60 seconds, developing the film in a 2.38 wt% TMAH aqueous solution at 23°C, and measuring a loss of film thickness by means of a resist development analyzer.

Also preferably, the resist film formed from the positive resist composition in an unexposed region has a dissolution rate in alkaline developer of up to 10 nm/min, more preferably up to 8 nm/min, even more preferably up to 6 nm/min. Where the resist film is in the thin film range of up to 100 nm, the influence of pattern film thickness loss in alkaline developer becomes greater. If the dissolution rate in unexposed region is more than 10 nm/min, pattern collapse will occur, failing to form a small size pattern. The problem becomes outstanding in the fabrication of photomasks requiring to be defectless and having a tendency of strong development process. It is noted that the dissolution rate of an unexposed region is computed by spin coating the positive resist composition onto a 6-inch silicon wafer, baking at 110°C for 240 seconds to form a resist film of 80 nm thick, developing the film in a 2.38 wt% TMAH aqueous solution at 23°C for 80 seconds, and measuring a loss of film thickness.

### Mask blank

The mask blank includes a substrate and the resist film thereon. Examples of the mask substrate include Cr, CrO, CrON, MoSi₂, Si, SiO, SiO₂, SiON, SiONC, CoTa, NiTa, TaBN, and SnO₂. The resist composition is applied onto a substrate by a suitable coating technique such as spin coating. The coating is prebaked on a hot plate at a temperature of preferably 60 to 150°C for 1 to 20 minutes, more preferably at 80 to 140°C for 1 to 10 minutes. The resulting resist film is generally 0.03 to 2 µm thick.

The mask blank is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The reflection type mask blank of the invention includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

### Pattern forming process

A further embodiment of the invention is a resist pattern forming process comprising the steps of applying the chemically amplified positive resist composition onto a mask blank to form a resist film thereon, exposing the resist film patternwise to high-energy radiation, and developing the exposed resist film in an alkaline developer.

After coating, the resist film is exposed to a desired pattern of high-energy radiation. Examples of the high-energy radiation include UV, deep-UV, excimer laser radiation (KrF, ArF, etc.), EUV, x-ray, γ-ray, synchrotron radiation, and EB. Exposure using EUV or EB is preferred herein.

When UV, deep-UV, excimer laser, EUV, x-ray, γ-ray or synchrotron radiation is used as the high-energy radiation, the resist film is exposed thereto through a mask having a desired pattern in a dose of preferably 1 to 500 mJ/cm², more preferably 10 to 400 mJ/cm². When EB is used as the high-energy radiation, the resist film is exposed thereto directly in a dose of preferably 1 to 500 µC/cm², more preferably 10 to 400 µC/cm².

The exposure may be performed by conventional lithography whereas the immersion lithography of holding a liquid, typically water between the resist film and the mask may be employed if desired. In the case of immersion lithography, a protective film which is insoluble in water may be formed on the resist film.

After the exposure, the resist film may be baked (PEB) on a hotplate preferably at 60 to 150°C for 1 to 20 minutes, more preferably at 80 to 140°C for 1 to 10 minutes.

After the exposure or PEB, the resist film is developed in a developer in the form of an aqueous alkaline solution for preferably 0.1 to 3 minutes, more preferably 0.5 to 2 minutes by conventional techniques such as dip, puddle and spray techniques. A typical developer is a 0.1 to 5 wt%, preferably 2 to 3 wt% aqueous solution of tetramethylammonium hydroxide (TMAH) or another alkali. In this way, the desired pattern is formed on the substrate.

The mask blank and positive resist composition of the invention are useful in forming a resist pattern having a satisfactory resolution, pattern fidelity and reduced LER. The positive resist composition is also useful in forming a resist pattern on a substrate which is prone to the influence of back scattering during EB writing and which is difficult to form a resist pattern of rectangular profile thereon. Examples of such substrate include substrates having sputter deposited on their outermost surface a layer of metallic chromium or a chromium compound containing one or more light elements such as oxygen, nitrogen and carbon, and substrates having an outermost layer of SiO, SiOₓ, or a tantalum, molybdenum, cobalt, nickel, tungsten or tin compound. The mask blank and positive resist composition most effectively work for the mask blank of reflection type.

The resist pattern forming process is successful in forming patterns having a high resolution, minimized influence of develop loading, and a reduced size difference independent of a pattern density (grouped or isolated) even on a substrate (typically mask blank of transmission or reflection type) whose outermost surface is made of a material tending to affect resist pattern profile by backward scattering during EB writing, such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards.

### [1] Synthesis of polymer

### Synthesis Example 1-1: Synthesis of Polymer P-2

In nitrogen atmosphere, a 300-mL dropping cylinder was charged with 43.4 g of 4-acetoxystyrene, 6.8 g of acenaphthylene, 29.8 g of 2-(4-fluorophenyl)propan-2-yl methacrylate, 8.2 g of dimethyl 2,2'-azobis(2-methylpropionate) (tradename V-601 by Fujifilm Wako Pure Chemical), and 124 g of methyl ethyl ketone (MEK) solvent to form a monomer solution. In nitrogen atmosphere, a 500-mL flask was charged with 62 g of MEK and heated at 80°C. The monomer solution was added dropwise to the flask over 4 hours. After the completion of dropwise addition, the polymerization solution was continuously stirred for 18 hours while maintaining its temperature at 80°C. Thereafter, the polymerization solution was cooled to room temperature and added dropwise to 1,300 g of hexane for precipitation. The copolymer precipitated was collected by filtration and washed twice with 500 g of hexane. In a 1-L flask under nitrogen atmosphere, the copolymer was dissolved in a mixture of 144 g of THF and 48 g of methanol. 22.3 g of ethanol amine was added to the solution, which was stirred at 60°C for 3 hours. The reaction solution was concentrated under reduced pressure. The concentrate was dissolved in a mixture of 240 g of ethyl acetate and 60 g of water. The solution was transferred to a separatory funnel, to which 11.1 g of acetic acid was added, followed by separatory operation. The lower layer was distilled off, after which 60 g of water and 14.8 g of pyridine were added to the organic layer, followed by separatory operation. The lower layer was distilled off, after which 60 g of water was added to the organic layer. This was followed by 5 cycles of water washing and separation. The organic layer after separation was concentrated and dissolved in 130 g of acetone. The acetone solution was added dropwise to 1,200 g of water for crystallization and precipitation. The precipitate was filtered, washed with water, and suction filtered for 2 hours. The precipitate was dissolved in 130 g of acetone again. The acetone solution was added dropwise to 1,200 g of water for crystallization and precipitation. The precipitate was subjected to filtration, water washing and drying, obtaining 50.7 g of a polymer as white solid. The polymer designated Polymer P-2 was analyzed by ¹H-NMR, ¹³C-NMR and GPC, with the results shown below.

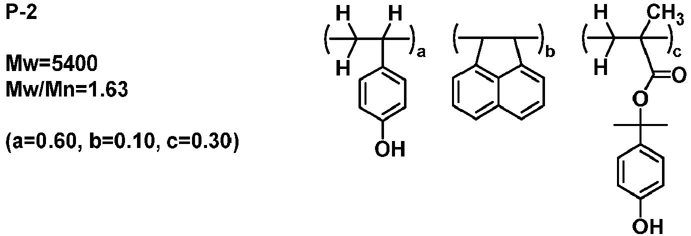

### Synthesis Examples 1-2 to 1-28 and Comparative Synthesis Example 1-1: Synthesis of Polymers P-1, P-3 to P-28 and Comparative Polymer cP-1

Polymers P-1, P-3 to P-28 and Comparative Polymer cP-1 were synthesized by the same procedure as in Synthesis Example 1-1 except that the type and amount (mol%) of monomers were changed. In Table 1, the incorporation ratio is a molar ratio.

**Table 1**

| | Unit 1 | Incorporation ratio (mol%) | Unit 2 | Incorporation ratio (mol%) | Unit 3 | Incorporation ratio (mol%) | Unit 4 | Incorporation ratio (mol%) | Mw | Mw/Mn |
|---|---|---|---|---|---|---|---|---|---|---|
| P-1 | A-1 | 60.0 | C-1 | 40.0 | | | | | 5,500 | 1.63 |
| P-2 | A-1 | 60.0 | B-1 | 10.0 | C-1 | 30.0 | | | 5,400 | 1.63 |
| P-3 | A-1 | 60.0 | B-2 | 15.0 | C-1 | 25.0 | | | 5,100 | 1.59 |
| P-4 | A-1 | 60.0 | B-2 | 10.0 | C-1 | 30.0 | | | 5,200 | 1.60 |
| P-5 | A-1 | 60.0 | B-3 | 10.0 | C-1 | 30.0 | | | 5,100 | 1.65 |
| P-6 | A-1 | 60.0 | B-4 | 10.0 | C-1 | 30.0 | | | 5,300 | 1.64 |
| P-7 | A-1 | 60.0 | B-2 | 10.0 | C-2 | 30.0 | | | 5,600 | 1.63 |
| P-8 | A-1 | 60.0 | B-2 | 10.0 | C-3 | 35.0 | | | 5,200 | 1.64 |
| P-9 | A-1 | 60.0 | B-2 | 10.0 | C-4 | 30.0 | | | 6,100 | 1.65 |
| P-10 | A-1 | 60.0 | B-2 | 10.0 | C-5 | 30.0 | | | 5,600 | 1.64 |
| P-11 | A-1 | 60.0 | B-2 | 10.0 | C-6 | 30.0 | | | 5,300 | 1.68 |
| P-12 | A-1 | 60.0 | B-2 | 10.0 | C-7 | 30.0 | | | 5,200 | 1.67 |
| P-13 | A-1 | 65.0 | B-2 | 10.0 | C-8 | 30.0 | | | 5,700 | 1.68 |
| P-14 | A-1 | 60.0 | B-2 | 10.0 | C-9 | 30.0 | | | 5,600 | 1.67 |
| P-15 | A-2 | 60.0 | B-2 | 15.0 | C-10 | 25.0 | | | 5,500 | 1.66 |
| P-16 | A-2 | 60.0 | B-2 | 15.0 | C-11 | 25.0 | | | 5,400 | 1.65 |
| P-17 | A-2 | 60.0 | B-2 | 15.0 | C-12 | 25.0 | | | 5,800 | 1.67 |
| P-18 | A-2 | 60.0 | B-2 | 15.0 | C-13 | 25.0 | | | 5,700 | 1.65 |
| P-19 | A-2 | 60.0 | B-2 | 15.0 | C-14 | 25.0 | | | 5,600 | 1.64 |
| P-20 | A-2 | 60.0 | B-2 | 15.0 | C-15 | 25.0 | | | 5,500 | 1.64 |
| P-21 | A-2 | 60.0 | B-2 | 15.0 | C-16 | 25.0 | | | 5,600 | 1.63 |
| P-22 | A-2 | 60.0 | B-2 | 15.0 | C-17 | 25.0 | | | 5,700 | 1.66 |
| P-23 | A-3 | 60.0 | B-2 | 10.0 | C-1 | 30.0 | | | 7,600 | 1.76 |
| P-24 | A-1 | 50.0 | B-2 | 10.0 | C-1 | 30.0 | C-11 | 10.0 | 5,700 | 1.64 |
| P-25 | A-2 | 55.0 | B-2 | 10.0 | C-1 | 20.0 | C-11 | 15.0 | 5,700 | 1.65 |
| P-26 | A-2 | 55.0 | B-2 | 10.0 | C-1 | 20.0 | C-15 | 15.0 | 5,800 | 1.67 |
| P-27 | A-2 | 70.0 | C-1 | 30.0 | | | | | 6,100 | 1.68 |
| P-28 | A-2 | 70.0 | C-2 | 30.0 | | | | | 6,300 | 1.71 |
| cP-1 | A-1 | 80.0 | B-2 | 12.0 | C-1 | 8.0 | | | 5,100 | 1.65 |

The structure of repeat units incorporated in the polymers is shown below.

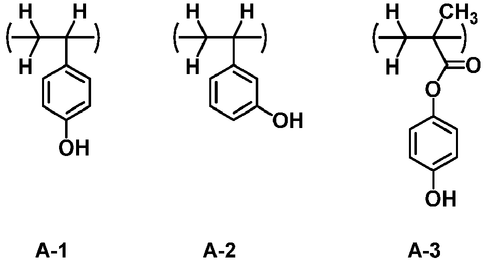

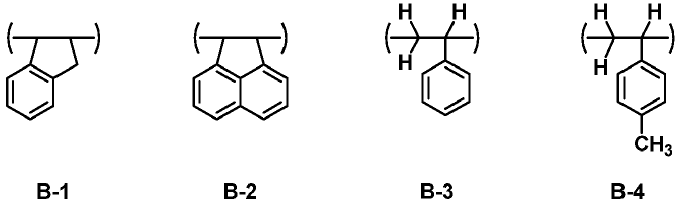

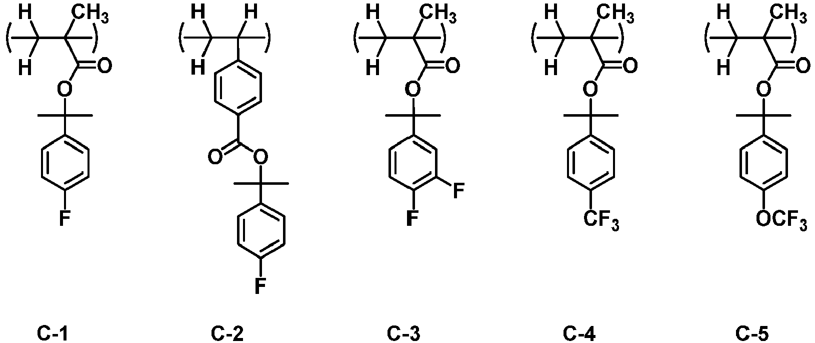

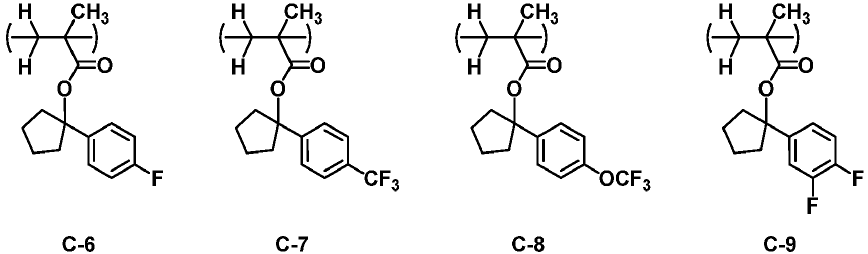

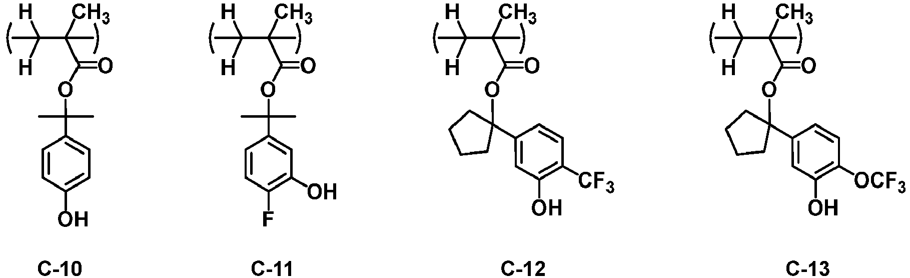

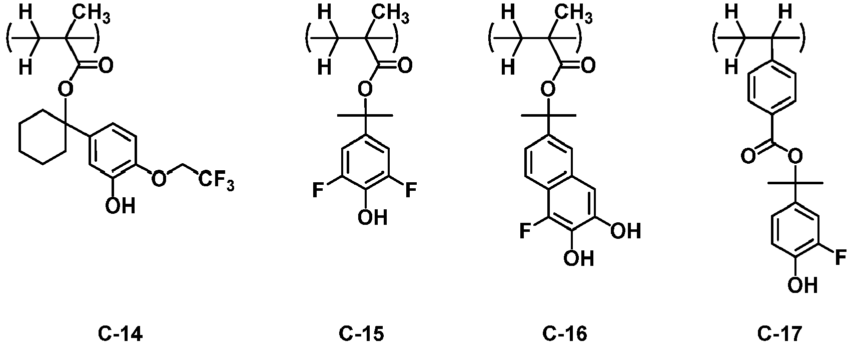

The dissolution rate of a polymer in alkaline developer was determined by spin coating a 16.7 wt% solution of the polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness. Polymers P-1 to P-28 showed a dissolution rate of up to 10 nm/min whereas Comparative Polymer cP-1 showed a dissolution rate of 20 nm/min.

### Synthesis Examples 2-1 to 2-6 and Comparative Synthesis Examples 1-2 to 1-5: Synthesis of Polymers AP-1 to AP-6 and Comparative Polymers cP-2 to cP-5

Polymers AP-1 to AP-6 and Comparative Polymers cP-2 to cP-5 were synthesized by the same procedure as Synthesis Example 1-1 except that the monomers were changed. Polymers AP-1 to AP-6 and Comparative Polymers cP-2 to cP-5 showed a dissolution rate in alkaline developer of up to 10 nm/min.

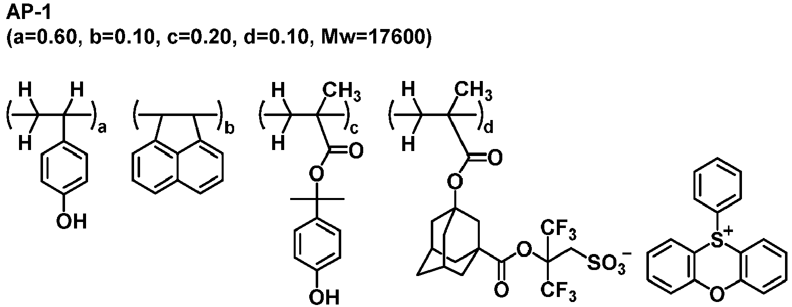

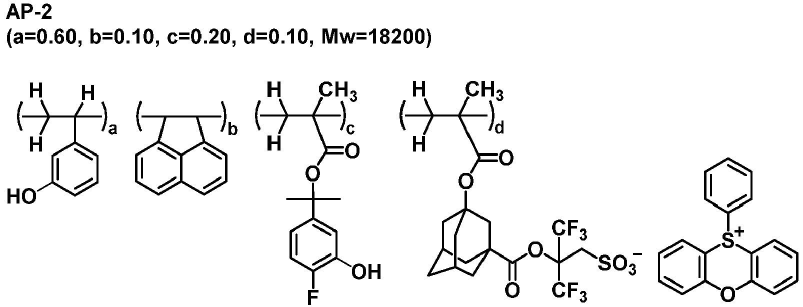

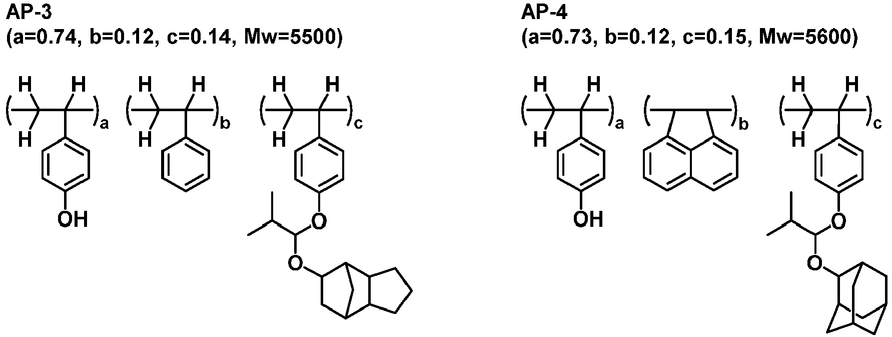

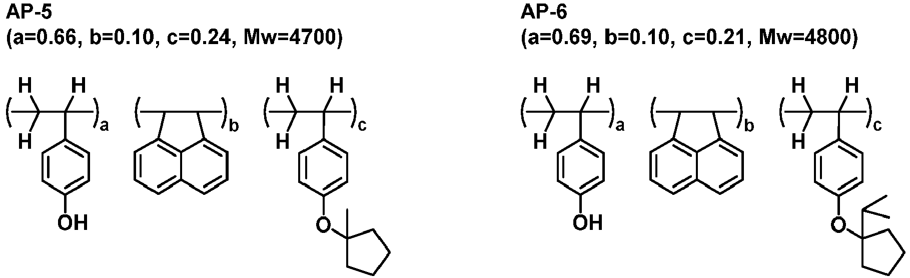

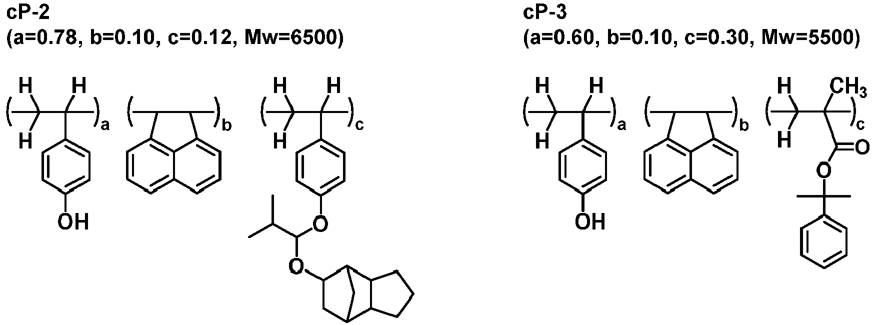

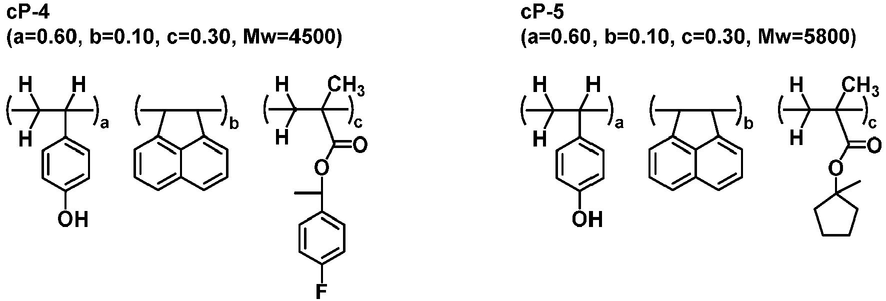

### [2] Preparation of chemically amplified positive resist compositions

### Examples 1-1 to 1-48 and Comparative Examples 1-1 to 1-6

Chemically amplified positive resist compositions were prepared by dissolving selected components in an organic solvent in accordance with the formulation shown in Tables 2 to 4, and filtering the solution through a UPE filter with a pore size of 20 nm. The organic solvent was a mixture of 650 pbw of PGMEA, 1,810 pbw of EL, and 1,810 pbw of PGME.

**Table 2**

| | | Resist composition | Polymer 1 (pbw) | Polymer 2 (pbw) | Photoacid generator (pbw) | Quencher (pbw) | Additive (pbw) |
|---|---|---|---|---|---|---|---|
| | 1-1 | R-1 | P-1 | - | PAG-A (8) | Q-1 | - |
| | | | (80) | | PAG-B (3) | (10.0) | |
| | 1-2 | R-2 | P-1 | - | PAG-A (8) | Q-1 | D-1 |
| | | | (80) | | PAG-B (3) | (10.0) | (1.5) |
| | 1-3 | R-3 | P-1 | - | PAG-A (8) | Q-1 | D-2 |
| | | | (80) | | PAG-B (3) | (10.0) | (1.5) |
| | 1-4 | R-4 | P-1 | - | PAG-A (8) | Q-1 | D-3 |
| | | | (80) | | PAG-B (3) | (10.0) | (3.0) |
| | 1-5 | R-5 | P-1 | - | PAG-A (8) | Q-1 | D-4 |
| | | | (80) | | PAG-B (3) | (10.0) | (1.5) |
| | 1-6 | R-6 | P-1 | - | PAG-C (8) | Q-1 | D-5 |
| | | | (80) | | PAG-B (3) | (10.0) | (1.5) |
| | 1-7 | R-7 | P-1 | - | PAG-C (8) | Q-2 | D-1 |
| | | | (80) | | PAG-B (3) | (10.0) | (1.5) |
| | 1-8 | R-8 | P-1 | - | PAG-C (8) | Q-3 | D-1 |
| | | | (80) | | PAG-B (3) | (10.0) | (1.5) |
| | 1-9 | R-9 | P-2 | - | PAG-C (5) | Q-1 | D-1 |
| | | | (80) | | PAG-B (3) | (8.0) | (1.5) |
| | 1-10 | R-10 | P-2 | - | PAG-C (16) | Q-1 | D-1 |
| | | | (80) | | PAG-B (3) | (13.0) | (1.5) |
| Example | 1-11 | R-11 | P-3 | - | PAG-C (5) | Q-1 | D-1 |
| | | | (80) | | PAG-B (3) | (80) | (1.5) |
| | 1-12 | R-12 | P-4 | - | PAG-C (5) | Q-1 | D-1 |
| | | | (80) | | PAG-B (3) | (8.0) | (1.5) |
| | 1-13 | R-13 | P-5 | - | PAG-C (5) | Q-1 | D-1 |
| | | | (80) | | PAG-B (3) | (8.0) | (1.5) |
| | 1-14 | R-14 | P-6 | - | PAG-C (5) | Q-1 | D-1 |
| | | | (80) | | PAG-B (3) | (8.0) | (1.5) |
| | 1-15 | R-15 | P-7 | - | PAG-C (5) | Q-1 | D-1 |
| | | | (80) | | PAG-B (3) | (8.0) | (1.5) |
| | 1-16 | R-16 | P-8 | - | PAG-C (5) | Q-1 | D-1 |
| | | | (80) | | PAG-B (3) | (8.0) | (1.5) |
| | 1-17 | R-17 | P-9 | - | PAG-C (5) | Q-1 | D-1 |
| | | | (80) | | PAG-B (3) | (8.0) | (1.5) |
| | 1-18 | R-18 | P-10 | - | PAG-C (5) | Q-1 | D-1 |
| | | | (80) | | PAG-B (3) | (8.0) | (1.5) |
| | 1-19 | R-19 | P-11 | - | PAG-C (5) | Q-1 | D-1 |
| | | | (80) | | PAG-B (3) | (8.0) | (1.5) |
| | 1-20 | R-20 | P-12 | - | PAG-C (5) | Q-1 | D-1 |
| | | | (80) | | PAG-B (3) | (8.0) | (1.5) |
| | 1-21 | R-21 | P-13 | - | PAG-C (5) | Q-1 | D-1 |
| | | | (80) | | PAG-B (3) | (8.0) | (1.5) |
| | 1-22 | R-22 | P-14 | - | PAG-C (5) | Q-1 | D-1 |
| | | | (80) | | PAG-B (3) | (8.0) | (1.5) |
| | 1-23 | R-23 | P-15 | - | PAG-C (5) | Q-1 | D-1 |
| | | | (80) | | PAG-B (3) | (8.0) | (1.5) |
| | 1-24 | R-24 | P-16 | - | PAG-C (5) | Q-1 | D-1 |
| | | | (80) | | PAG-B (3) | (8.0) | (1.5) |
| | 1-25 | R-25 | P-17 | - | PAG-C (5) | Q-1 | D-1 |
| | | | (80) | | PAG-B (3) | (8.0) | (1.5) |
| | 1-26 | R-26 | P-18 | - | PAG-C (5) | Q-1 | D-1 |
| | | | (80) | | PAG-B (3) | (8.0) | (1.5) |

**Table 3**

| | | Resist composition | Polymer 1 (pbw) | Polymer 2 (pbw) | Photoacid generator (pbw) | Quencher (pbw) | Additive (pbw) |
|---|---|---|---|---|---|---|---|
| | 1-27 | R-27 | P-19 | - | PAG-C (5) | Q-1 | D-1 |
| | | | (80) | | PAG-B (3) | (8.0) | (1.5) |
| | 1-28 | R-28 | P-20 | - | PAG-C (5) | Q-1 | D-1 |
| | | | (80) | | PAG-B (3) | (8.0) | (1.5) |
| | 1-29 | R-29 | P-21 | - | PAG-C (5) | Q-1 | D-1 |
| | | | (80) | | PAG-B (3) | (8.0) | (1.5) |
| | 1-30 | R-30 | P-22 | - | PAG-C (5) | Q-1 | D-1 |
| | | | (80) | | PAG-B (3) | (8.0) | (1.5) |
| | 1-31 | R-31 | P-23 | - | PAG-C (5) | Q-1 | D-1 |
| | | | (80) | | PAG-B (3) | (8.0) | (1.5) |
| | 1-32 | R-32 | P-24 | - | PAG-C (5) | Q-1 | D-1 |
| | | | (80) | | PAG-B (3) | (8.0) | (1.5) |
| | 1-33 | R-33 | P-25 | - | PAG-C (5) | Q-1 | D-1 |
| | | | (80) | | PAG-B (3) | (8.0) | (1.5) |
| | 1-34 | R-34 | P-26 | - | PAG-C (5) | Q-1 | D-1 |
| | | | (80) | | PAG-B (3) | (8.0) | (1.5) |
| | 1-35 | R-35 | P-4 | P-10 | PAG-C (5) | Q-1 | D-1 |
| | | | (40) | (40) | PAG-B (3) | (8.0) | (1.5) |
| | 1-36 | R-36 | P-4 | P-16 | PAG-C (5) | Q-1 | D-1 |
| | | | (40) | (40) | PAG-B (3) | (8.0) | (1.5) |
| | 1-37 | R-37 | P-16 | P-18 | PAG-C (5) | Q-1 | D-1 |
| | | | (40) | (40) | PAG-B (3) | (8.0) | (1.5) |
| Example | 1-38 | R-38 | AP-1 | - | - | Q-1 | D-1 |
| | | | (80) | | | (5.0) | (1.5) |
| | 1-39 | R-39 | AP-1 | - | PAG-C (5) | Q-1 | D-1 |
| | | | (80) | | PAG-B (3) | (12.0) | (1.5) |
| | 1-40 | R-40 | AP-1 | P-4 | PAG-C (5) | Q-1 | D-1 |
| | | | (80) | (40) | PAG-B (3) | (10.0) | (1.5) |
| | 1-41 | R-41 | AP-2 | P-4 | PAG-C (5) | Q-1 | D-1 |
| | | | (80) | (40) | PAG-B (3) | (10.0) | (1.5) |
| | 1-42 | R-42 | AP-3 | P-4 | PAG-C (8) | Q-1 | D-1 |
| | | | (40) | (40) | PAG-B (3) | (8.0) | (1.5) |
| | 1-43 | R-43 | AP-4 | P-4 | PAG-C (8) | Q-1 | D-1 |
| | | | (40) | (40) | PAG-B (3) | (8.0) | (1.5) |
| | 1-44 | R-44 | AP-5 | P-4 | PAG-C (5) | Q-1 | D-1 |
| | | | (40) | (40) | PAG-B (3) | (7.0) | (1.5) |
| | 1-45 | R-45 | AP-6 | P-4 | PAG-C (5) | Q-1 | D-1 |
| | | | (40) | (40) | PAG-B (3) | (7.0) | (1.5) |
| | 1-46 | R-46 | AP-5 | P-27 | PAG-C (8) | Q-1 | D-1 |
| | | | (40) | (40) | PAG-B (3) | (5.0) | (1.5) |
| | 1-47 | R-47 | AP-6 | P-28 | PAG-C (8) | Q-1 | D-1 |
| | | | (40) | (40) | PAG-B (3) | (5.0) | (1.5) |
| | 1-48 | R-48 | P-4 | - | PAG-C (8) | Q-1 | D-1 |
| | | | (80) | | PAG-B (3) | (1.9) | (1.5) |

**Table 4**

| | | Resist composition | Polymer 1 (pbw) | Polymer 2 (pbw) | Photoacid generator (pbw) | Quencher (pbw) | Additive (pbw) |
|---|---|---|---|---|---|---|---|
| Comparative Example | 1-1 | CR-1 | cP-1 | - | PAG-C (5) | Q-1 | D-1 |
| | | | (80) | | PAG-B (3) | (8.0) | (1.5) |
| | 1-2 | CR-2 | cP-2 | - | PAG-C (5) | Q-1 | D-1 |
| | | | (80) | | PAG-B (3) | (8.0) | (1.5) |
| | 1-3 | CR-3 | cP-3 | - | PAG-C (5) | Q-1 | D-1 |
| | | | (80) | | PAG-B (3) | (8.0) | (1.5) |
| | 1-4 | CR-4 | cP-4 | - | PAG-C (5) | Q-1 | D-1 |
| | | | (80) | | PAG-B (3) | (8.0) | (1.5) |
| | 1-5 | CR-5 | cP-5 | - | PAG-C (5) | Q-1 | D-1 |
| | | | (80) | | PAG-B (3) | (8.0) | (1.5) |
| | 1-6 | CR-6 | cP-5 | - | PAG-C (5) | Q-1 | D-1 |
| | | | (80) | | PAG-B (3) | (1.8) | (1.5) |

In Tables 2 to 4, quenchers Q-1 to Q-3, photoacid generators PAG-A to PAG-C, and fluorinated polymers D-1 to D-5 have the structures shown below.

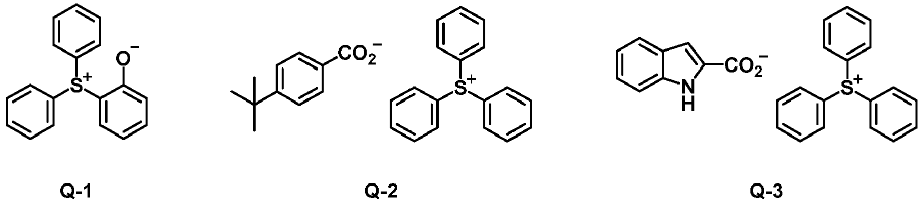

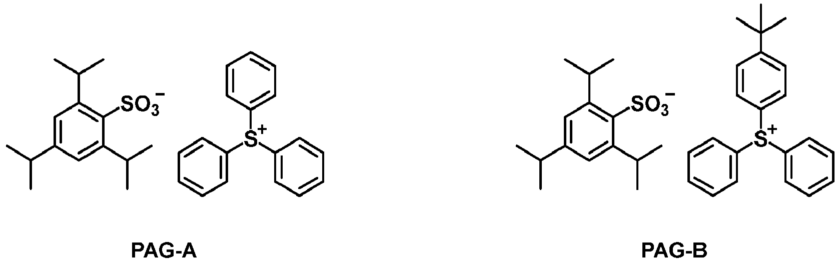

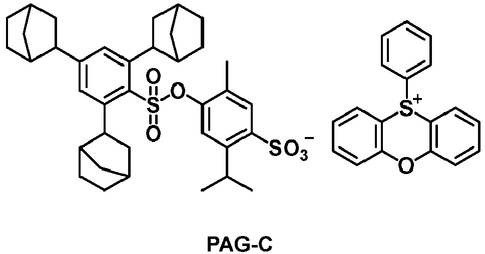

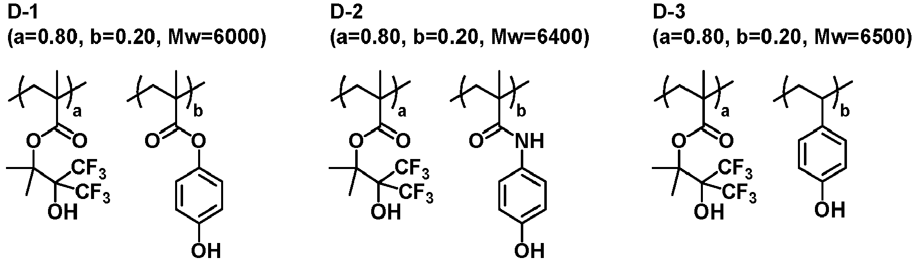

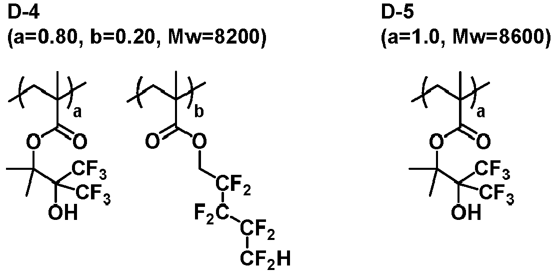

### [3] EB lithography test

### Examples 2-1 to 2-48 and Comparative Examples 2-1 to 2-6

There was furnished a reflection type mask blank for EUV lithography. Namely, a mask blank was furnished by forming a multilayer reflective film of 40 Mo/Si layers having a thickness of 284 nm on a low thermal expansion glass substrate of 6 inch squares, then successively depositing thereon a Ru film of 3.5 nm thick as a protective film, a TaN film of 70 nm thick as an absorber layer, and a CrN film of 6 nm thick as a hard mask.

Using a coater/developer system ACT-M (Tokyo Electron Ltd.), each of the positive resist compositions (R-1 to R-48, CR-1 to CR-6) was spin coated onto the mask blank and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The LS resolution (or maximum resolution) was defined as the minimum line width of a L/S pattern that could be resolved at the optimum dose. The edge roughness (LER) of a 200-nm LS pattern was measured under SEM. The develop loading was evaluated by forming a 200-nm LS pattern at the dose (µC/cm²) capable of resolving a 1:1 LS pattern of 200 nm design at a ratio 1:1 and a 200-nm LS pattern including dummy patterns having a density of 15%, 25%, 33%, 45%, 50%, 55%, 66%, 75%, 85%, and 95% arranged around the center pattern, measuring the size of spaces under SEM, and comparing the size difference among grouped and isolated patterns. Also, the pattern was visually observed to judge whether or not the profile was rectangular. For the evaluation of pattern fidelity, when a square hole pattern of size 120 nm and density 36% was placed, an area loss (%) at one corner of the square hole was computed. A smaller value indicates that the hole profile is more rectangular.

The dissolution rate of an over-exposed region was determined by spin coating the resist solution onto a 8-inch silicon wafer, baking at 110°C for 60 seconds to form a resist film of 90 nm thick, exposing the resist film to KrF excimer laser radiation in a dose (mJ/cm²) capable of resolving a 200-nm 1: 1 LS pattern at a ratio 1: 1, baking at 110°C for 60 seconds, developing the film in a 2.38 wt% TMAH aqueous solution at 23°C, and measuring a loss of film thickness by means of a resist development rate analyzer (RDA-800 by Litho Tech Japan Corp.). The results are shown in Tables 5 to 7.

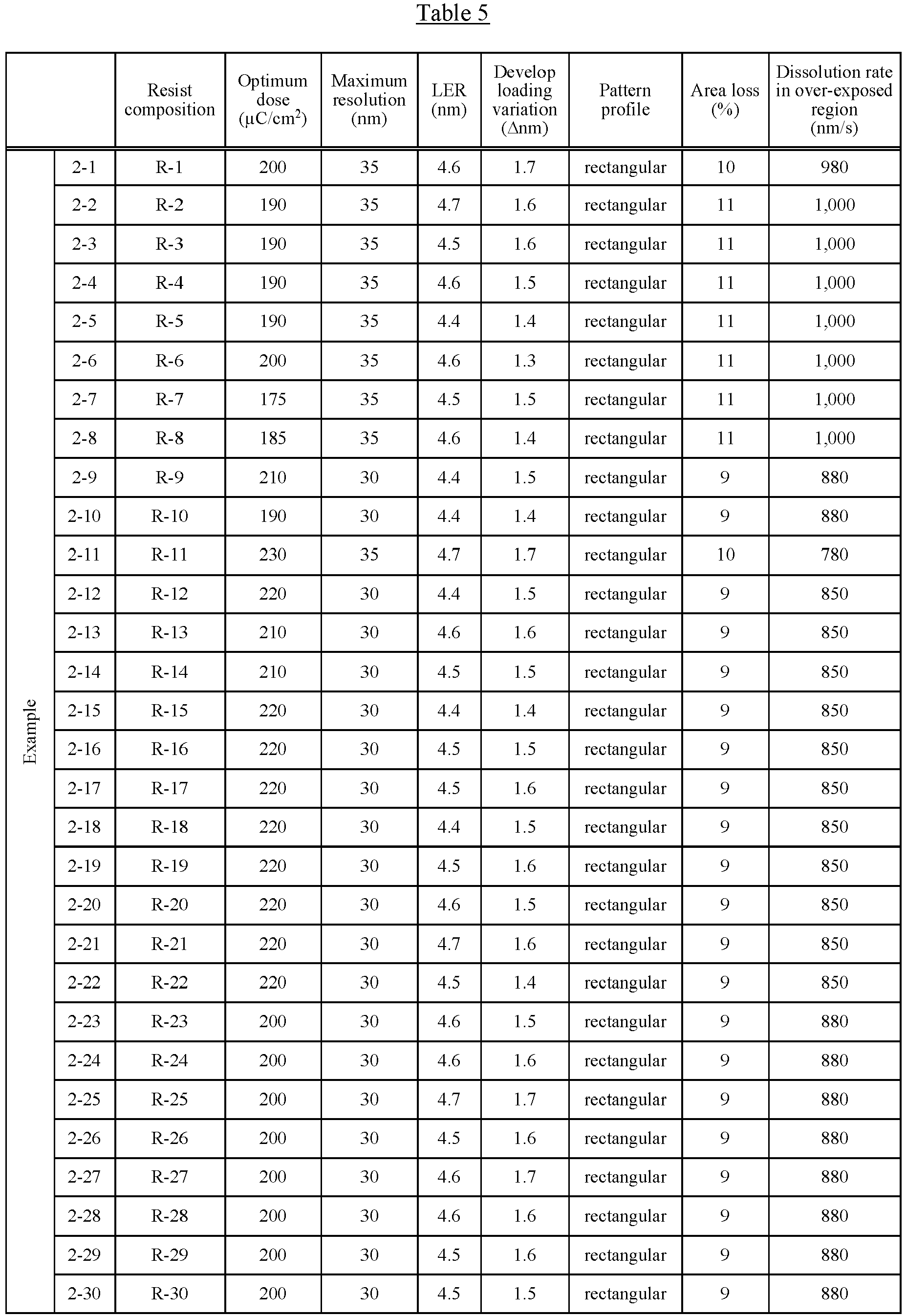

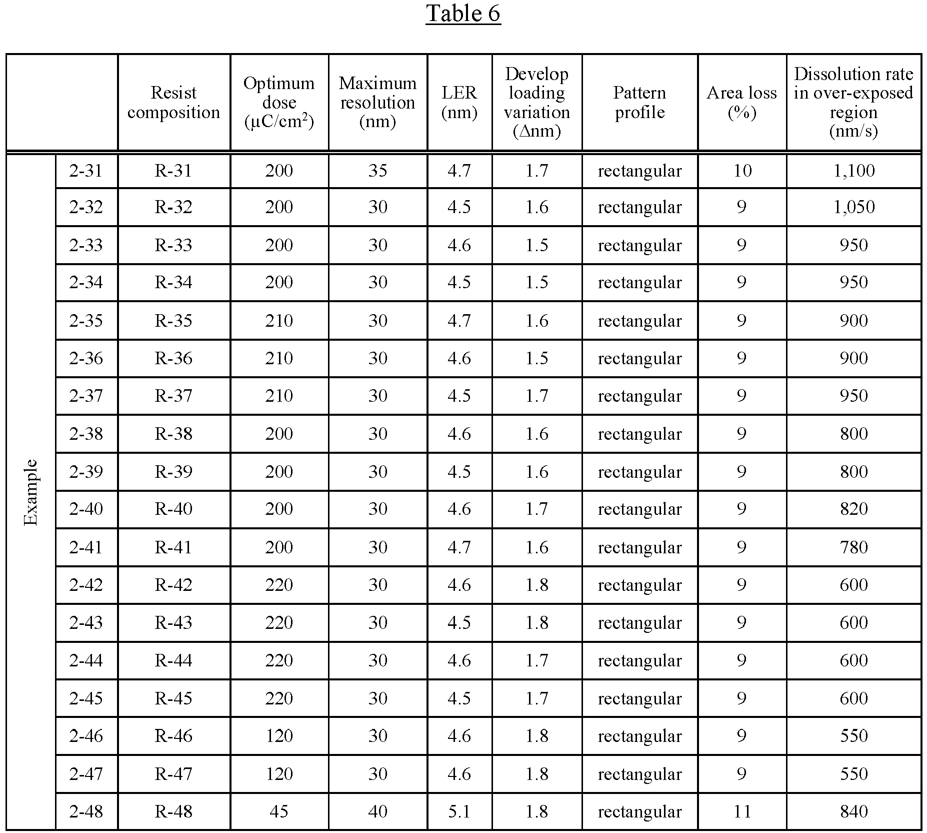

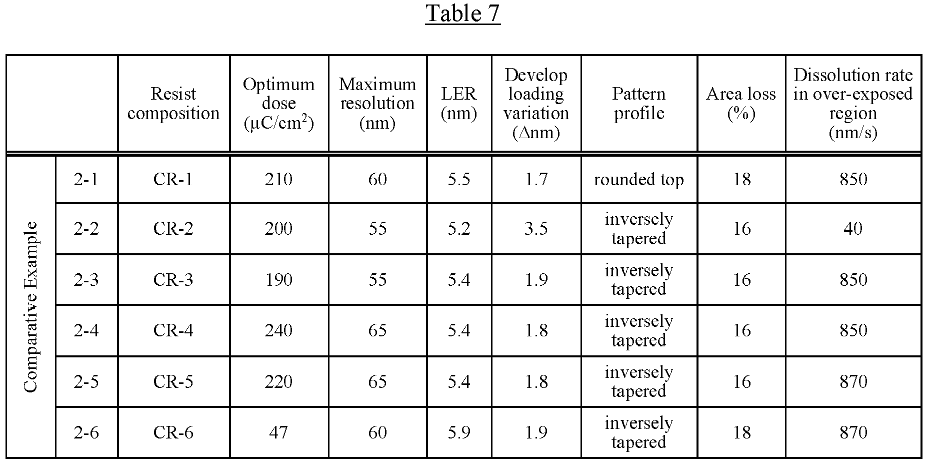

All the chemically amplified positive resist compositions (R-1 to R-48) within the scope of the invention show satisfactory resolution, reduced LER, pattern rectangularity, pattern fidelity, and controlled values of develop loading. A comparison of R-12 with R-48 reveals that the resolution in the low-sensitivity region of 50 µC or more is further improved. Of the comparative resist compositions (CR-1 to CR-6), composition CR-1 has so high a polymer dissolution rate in unexposed region that the pattern shows a rounded top profile and degraded resolution. Composition CR-2 has so low an over-exposed region dissolution rate that the control of develop loading is insufficient. In compositions CR-3 to CR-5, because the design of base polymers is insufficient, not all resolution, LER and pattern rectangularity are met although the develop loading is fully controlled. Composition CR-5 is not optimum in the reactivity of acid labile group as compared with CR-6, and the resolution is degraded under the influence of back scattering in a high-dose region with a higher level of exposure energy.

### [4] Evaluation of etching resistance

### Examples 3-1, 3-2 and Comparative Example 3-1

Using a coater/developer system ACT-M (Tokyo Electron Ltd.), each of the chemically amplified positive resist compositions (R-12, R-24, CR-5) was spin coated onto a 6-inch mask blank of reflection type for EUV lithography and prebaked on a hotplate at 110°C for 600 seconds to form a resist film of 90 nm thick. The film thickness was measured by an optical film thickness measurement system NanoSpec (Nanometrics Inc.). Measurement was carried out at 81 in-plane points on the blank substrate excluding an outer rim portion extending 10 mm inward from the periphery. From these measurements, an average film thickness and a film thickness range were computed. Using a dry etching equipment UNAXIS G4, the coated blank was dry etched under the conditions shown below. A film thickness loss rate (Å/sec) was computed from the thickness of the remaining film at the end of etching. The results are shown in Table 8.
RF1 (RIE): pulse 700 V
RF2 (ICP): CW 400 W
Pressure: 6 mTorr
Cl₂: 185 sccm
O₂: 55 sccm
He: 9.25 sccm
Etching time: 75 sec

**Table 8**

| | Resist composition | Film thickness loss rate, Å/sec |
|---|---|---|
| Example 3-1 | R-12 | 6.3 |
| Example 3-2 | R-24 | 6.5 |
| Comparative Example 3-1 | CR-5 | 8.5 |

The chemically amplified positive resist compositions used in mask blanks showed satisfactory etching resistance.

### [5] Evaluation of different substrates

### Reference Examples 1-1 to 1-4 and Comparative Reference Examples 1-1 to 1-4

There was furnished a transmission type mask blank for ArF lithography. Namely, a mask blank was furnished by forming a MoSiON film of 75 nm thick on a synthetic quartz substrate (one side 6 inches) as a phase shift layer and a CrN film of 44 nm thick thereon as a light-shielding layer. Using a coater/developer system ACT-M (Tokyo Electron Ltd.), each of the positive resist compositions (R-12, R-24, R-40, R-41, CR-2 to CR-5) was spin coated onto the mask blank and prebaked on a hotplate at 110°C for 600 seconds to form a resist film of 80 nm thick. The thickness of the resist film was measured by an optical film thickness measurement system Nanospec (Nanometrics Inc.). Measurement was carried out at 81 in-plane points on the blank substrate excluding an outer rim portion extending 10 mm inward from the periphery. From these measurements, an average film thickness and a film thickness range were computed.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated for optimum dose, maximum resolution, LER, develop loading, pattern profile, and pattern fidelity by the same methods as in [3] EB lithography test. The results are shown in Table 9.

**Table 9**

| | | Resist composition | Optimum dose (µC/cm²) | Maximum resolution (nm) | LER (nm) | Develop loading variation (Δnm) | Pattern profile | Area loss (%) |
|---|---|---|---|---|---|---|---|---|
| Reference Example | 1-1 | R-12 | 220 | 30 | 4.5 | 1.5 | rectangular | 9 |
| | 1-2 | R-24 | 200 | 30 | 4.6 | 1.6 | rectangular | 9 |
| | 1-3 | R-40 | 200 | 30 | 4.6 | 1.6 | rectangular | 9 |
| | 1-4 | R-41 | 200 | 30 | 4.7 | 1.6 | rectangular | 9 |
| Comparative Reference Example | 1-1 | CR-2 | 200 | 50 | 5.1 | 3.5 | inversely tapered | 14 |
| | 1-2 | CR-3 | 190 | 50 | 5.2 | 2.0 | inversely tapered | 14 |
| | 1-3 | CR-4 | 240 | 50 | 5.2 | 2.0 | inversely tapered | 14 |
| | 1-4 | CR-5 | 220 | 60 | 5.3 | 1.8 | inversely tapered | 14 |

When the mask blank is of transmission type, the difference in resolution from Comparative Reference Examples is small because the influence of backward scattering is mitigated as compared with the reflection type mask blank. This suggests that the mask blank and chemically amplified positive resist composition of the invention are useful particularly when applied to the reflection type.

This accounts for the design of base polymers. The polymer obtained by combining phenolic hydroxy group-containing units with acrylic units containing an acid labile group having an optimized reactivity with acid succeeds in optimization of a pattern profile owing to the phenolic hydroxy group-containing units, optimization of an exposed region dissolution rate owing to acrylic units, and suppression of backward scattering. As a result, satisfactory resolution, LER, pattern rectangularity, pattern fidelity, etching resistance, and develop loading control are achieved.

The mask blank and the resist pattern forming process using the positive resist composition are useful in photolithography for the fabrication of semiconductor devices and the processing of photomask blanks of reflection type.

## Claims

1. A mask blank comprising a resist film which is obtained by coating a chemically amplified positive resist composition, the resist composition comprising a base polymer containing a polymer comprising phenolic hydroxy group-containing repeat units having the formula (A1) and repeat units containing a carboxy group protected with an acid labile group, having the formula (A2), and an organic solvent, 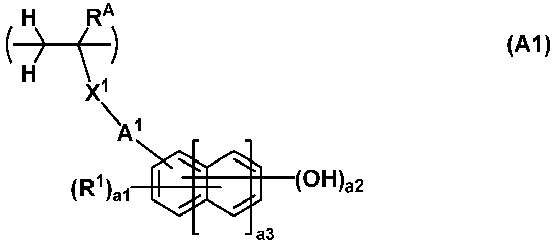 wherein R^{A} is hydrogen, fluorine, methyl or trifluoromethyl,
X¹ is a single bond, ^{∗}-C(=O)-O- or ^{∗}-C(=O)-NH-, ^{∗} designates a point of attachment to the carbon atom in the backbone,
A¹ is a single bond or a C₁-C₁₀ saturated hydrocarbylene group in which some constituent -CH₂- may be replaced by -O-,
R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
a1 is an integer satisfying 0 ≤ a1 ≤ 5+2a3-a2, a2 is an integer of 1 to 3, and a3 is an integer of 0 to 2, 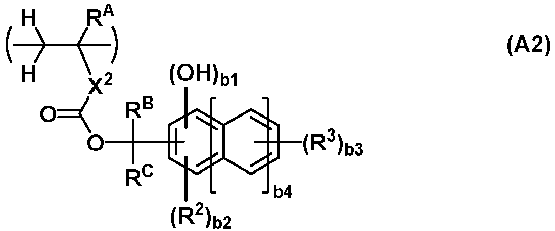 wherein R^{A} is hydrogen, fluorine, methyl or trifluoromethyl,
X² is a single bond, ^{∗}-C(=O)-O-X²¹-, phenylene group, or naphthylene group, the phenylene group and naphthylene group may be substituted with an optionally fluorinated C₁-C₁₀ alkoxy moiety or halogen, X²¹ is a C₁-C₂₀ aliphatic hydrocarbylene group, phenylene group or naphthylene group, the aliphatic hydrocarbylene group may contain at least one moiety selected from an optionally fluorinated C₁-C₁₀ alkoxy moiety, hydroxy, ether bond, ester bond and lactone ring, ^{∗} designates a point of attachment to the carbon atom in the backbone,
R^{B} and R^{C} are each independently a C₁-C₁₀ hydrocarbyl group which may contain a heteroatom, R^{B} and R^{C} may bond together to form a ring with the carbon atom to which they are attached,
R² is each independently halogen, cyano group, C₁-C₅ acyl group, C₁-C₅ alkoxy group, C₁-C₅ fluorinated alkyl group, or C₁-C₅ fluorinated alkoxy group,
R³ is each independently a C₁-C₁₀ hydrocarbyl group which may contain a heteroatom,
b1 is an integer of 0 to 2, b2 is an integer of 0 to 2, b3 is an integer of 0 to 5, and b4 is an integer of 0 to 2, with the proviso that b1 and b2 are not equal to 0 at the same time.

2. The mask blank of claim 1 wherein the phenolic hydroxy group-containing unit is a repeat unit having the following formula (A1-1), and the unit containing a carboxy group protected with an acid labile group is a repeat unit having the following formula (A2-1): 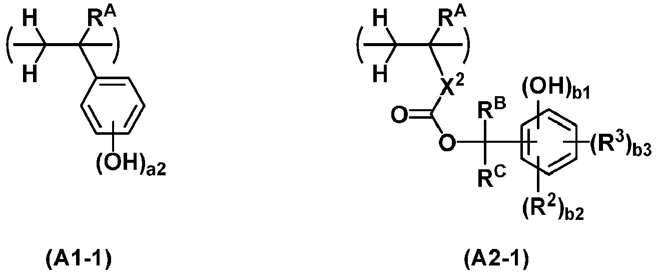 wherein R^{A}, R^{B}, R^{C}, X², R², R³, a2, b1, b2 and b3 are as defined above, with the proviso that b1 and b2 are not equal to 0 at the same time.

3. The mask blank of claim 1 or 2 wherein b2 is 1 or 2, and R² is fluorine, trifluoromethyl or trifluoromethoxy.

4. The mask blank of any one of claims 1 to 3 wherein the polymer further comprises repeat units having any one of the formulae (B 1) to (B3): 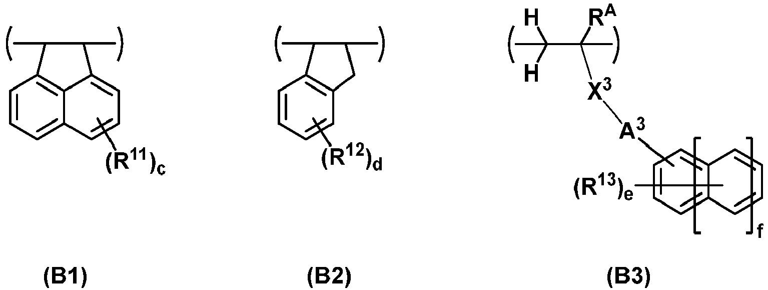 wherein R^{A} is as defined above,
c and d are each independently an integer of 0 to 4, e is an integer of 0 to 5, f is an integer of 0 to 2,
X³ is a single bond, ^{∗}-C(=O)-O- or ^{∗}-C(=O)-NH-, ^{∗} designates a point of attachment to the carbon atom in the backbone,
A³ is a single bond or a C₁-C₁₀ saturated hydrocarbylene group in which some constituent -CH₂- may be replaced by -O-,
R¹¹ and R¹² are each independently hydroxy, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group,
R¹³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group or cyano group, R¹³ may also be hydroxy when f is 1 or 2.

5. The mask blank of any one of claims 1 to 4 wherein the polymer further comprises repeat units having any one of the formulae (C 1) to (C8): 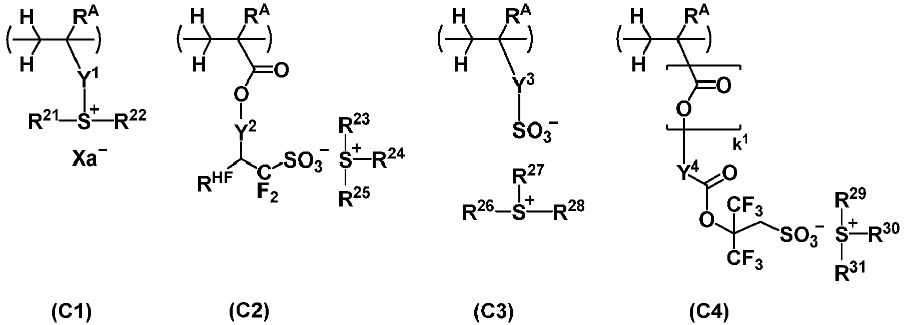 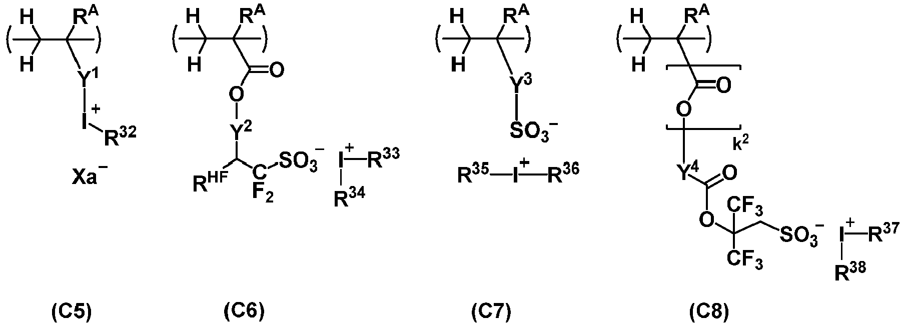 wherein R^{A} is as defined above,
Y¹ is a single bond, a C₁-C₆ aliphatic hydrocarbylene group, phenylene group, naphthylene group or C₇-C₁₈ group obtained by combining the foregoing, ^{∗}-O-Y¹¹-, ^{∗}-C(=O)-O-Y¹¹-, or ^{∗}-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
Y² is a single bond or ^{∗∗}-Y²¹-C(=O)-O-, Y²¹ is a C₁-C₂₀ hydrocarbylene group which may contain a heteroatom,
Y³ is a single bond, methylene, ethylene, phenylene, fluorinated phenylene, trifluoromethyl-substituted phenylene, ^{∗}-O-Y³¹-, ^{∗}-C(=O)-O-Y³¹-, or ^{∗}-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
^{∗} designates a point of attachment to the carbon atom in the backbone, ** designates a point of attachment to the oxygen atom in the formula,
Y⁴ is a single bond or C₁-C₃₀ hydrocarbylene group which may contain a heteroatom, k¹ and k² are each independently 0 or 1, k¹ and k² are 0 when Y⁴ is a single bond,
R²¹ to R³⁸ are each independently halogen or a C₁-C₂₀ hydrocarbyl group which may contain a heteroatom, R²¹ and R²² may bond together to form a ring with the sulfur atom to which they are attached, R²³ and R²⁴, R²⁶ and R²⁷, or R²⁹ and R³⁰ may bond together to form a ring with the sulfur atom to which they are attached,
R^{HF} is hydrogen or trifluoromethyl, and
Xa⁻ is a non-nucleophilic counter ion.

6. The mask blank of any one of claims 1 to 5 wherein the resist composition further comprises a fluorinated polymer comprising repeat units of at least one type selected from repeat units having the following formula (D1), repeat units having the following formula (D2), repeat units having the following formula (D3), and repeat units having the following formula (D4) and optionally repeat units of at least one type selected from repeat units having the following formula (D5) and repeat units having the following formula (D6): 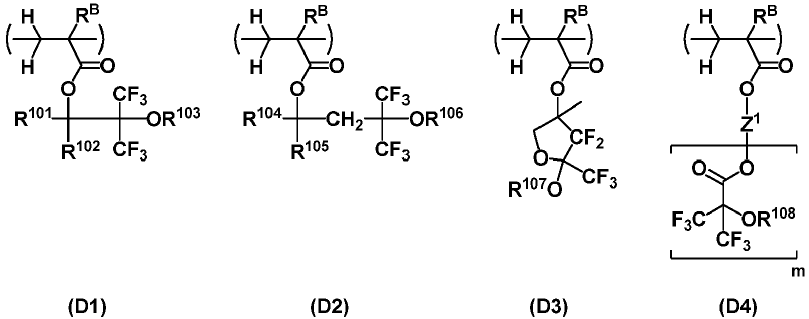 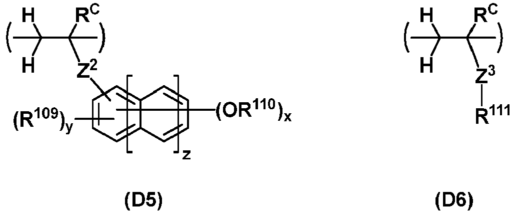 wherein R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is hydrogen or a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen atom is substituted by fluorine and in which some constituent -CH₂- may be replaced by an ester bond or ether bond,
x is an integer of 1 to 3, y is an integer satisfying 0 ≤ y ≤ 5+2z-x, z is 0 or 1, m is an integer of 1 to 3,
Z¹ is a C₁-C₂₀ (m+1)-valent hydrocarbon group or C₁-C₂₀ (m+1)-valent fluorinated hydrocarbon group,
Z² is a single bond, ^{∗}-C(=O)-O- or ^{∗}-C(=O)-NH-, ^{∗} designates a point of attachment to the carbon atom in the backbone, and
Z³ is a single bond, -O-, ^{∗}-C(=O)-O-Z³¹-Z³²- or ^{∗}-C(=O)-NH-Z³¹-Z³²-, Z³¹ is a single bond or a C₁-C₁₀ saturated hydrocarbylene group, Z³² is a single bond, ester bond, ether bond or sulfonamide bond, ^{∗} designates a point of attachment to the carbon atom in the backbone.

7. The mask blank of any one of claims 1 to 6 wherein the resist composition further comprises a photoacid generator.

8. The mask blank of claim 7 wherein the photoacid generator has an anion having an acid strength (pKa) of -2.0 or larger.

9. The mask blank of any one of claims 1 to 8 wherein the resist composition further comprises a quencher.

10. The mask blank of any one of claims 1 to 9 wherein the resist film has a dissolution rate in overexposed region of at least 100 nm/sec.

11. The mask blank of any one of claims 1 to 10 wherein the mask blank has an outermost surface prior to coating of the resist composition, the outermost surface being composed of a material containing at least one element selected from chromium, silicon, tantalum, molybdenum, cobalt, nickel, tungsten and tin.

12. The mask blank of claim 11 which is of reflection type.

13. A resist pattern forming process comprising the steps of:
exposing the resist film of the mask blank of any one of claims 1 to 12 patternwise to high-energy radiation, and
developing the exposed resist film in an alkaline developer.

14. The process of claim 13 wherein the high-energy radiation is EB.

15. A chemically amplified positive resist composition comprising a base polymer containing a polymer comprising phenolic hydroxy group-containing repeat units having the formula (A1) and repeat units containing a carboxy group protected with an acid labile group, having the formula (A2), an organic solvent, a photoacid generator, and a quencher, wherein a weight ratio of the photoacid generator to the quencher is less than 6/1, 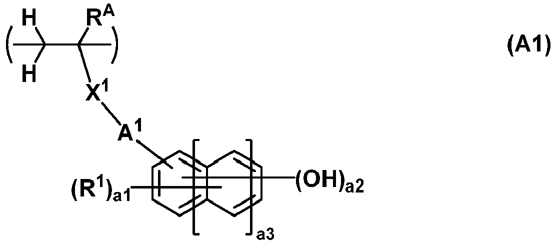 wherein R^{A} is hydrogen, fluorine, methyl or trifluoromethyl,
X¹ is a single bond, ^{∗}-C(=O)-O- or ^{∗}-C(=O)-NH-, ^{∗} designates a point of attachment to the carbon atom in the backbone,
A¹ is a single bond or a C₁-C₁₀ saturated hydrocarbylene group in which some constituent -CH₂- may be replaced by -O-,
R¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
a1 is an integer satisfying 0 ≤ a1 ≤ 5+2a3-a2, a2 is an integer of 1 to 3, and a3 is an integer of 0 to 2, 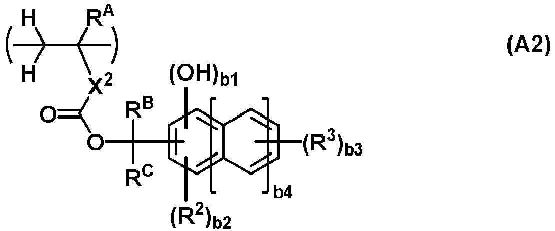 wherein R^{A} is hydrogen, fluorine, methyl or trifluoromethyl,
X² is a single bond, ^{∗}-C(=O)-O-X²¹-, phenylene group, or naphthylene group, the phenylene group and naphthylene group may be substituted with an optionally fluorinated C₁-C₁₀ alkoxy moiety or halogen, X²¹ is a C₁-C₂₀ aliphatic hydrocarbylene group, phenylene group or naphthylene group, the aliphatic hydrocarbylene group may contain at least one moiety selected from an optionally fluorinated C₁-C₁₀ alkoxy moiety, hydroxy, ether bond, ester bond and lactone ring, ^{∗} designates a point of attachment to the carbon atom in the backbone,
R^{B} and R^{C} are each independently a C₁-C₁₀ hydrocarbyl group which may contain a heteroatom, R^{B} and R^{C} may bond together to form a ring with the carbon atom to which they are attached,
R² is each independently halogen, cyano group, C₁-C₅ acyl group, C₁-C₅ alkoxy group, C₁-C₅ fluorinated alkyl group, or C₁-C₅ fluorinated alkoxy group,
R³ is each independently a C₁-C₁₀ hydrocarbyl group which may contain a heteroatom,
b1 is an integer of 0 to 2, b2 is an integer of 0 to 2, b3 is an integer of 0 to 5, b4 is an integer of 0 to 2, b1 and b2 are not equal to 0 at the same time.
